# EUROPEAN PATENT SPECIFICATION

(11) **EP 3 601 478 B1**
(45) Date of publication and mention of the grant of the patent: **24.02.2021**
(21) Application number: 18711584.5
(22) Date of filing: 23.03.2018
(51) Int. Cl.: C09K 11/02, C09K 11/06, H01L 27/32, C08G 63/16, C08G 63/181, C08K 5/00, C08K 5/3417, C09B 67/22, C09B 5/62, C09B 57/08

(54) **POLY(ETHYLENE FURAN-2,5-DICARBOXYLATE) AS MATRIX MATERIAL FOR COLOR CONVERTERS**
POLY(ETHYLEN-FURAN-2,5-DICARBOXYLAT) ALS MATRIXMATERIAL FÜR FARBKONVERTER
POLY (ÉTHYLÈNE FURAN-2,5-DICARBOXYLATE) EN TANT QUE MATIÈRE DE MATRICE POUR CONVERTISSEURS DE COULEURS

(30) Priority: 24.03.2017 EP 17162815
(43) Date of publication of application: 05.02.2020
(73) Proprietor: BASF SE, 67056 Ludwigshafen am Rhein (DE)
(72) Inventor: KOENEMANN, Martin, 67056 Ludwigshafen (DE); MANGOLD, Hannah Stephanie, 67056 Ludwigshafen (DE); IVANOVICI, Sorin, 67056 Ludwigshafen (DE); INDERBITZIN, Bruno, 4057 Basel (CH)
(74) Representative: BASF IP Association
(86) International application number: PCT/EP2018/057445
(87) International publication number: WO 2018/172523

(56) References cited:
- WO-A1-2016/130748
- WO-A1-2017/038092
- US-A1- 2011 120 902
- US-A1- 2013 342 101

## Description

The present invention relates to a color converter comprising a polymeric matrix material comprising at least one 2,5-furandicarboxylate polyester and at least one luminescent material and to the use of said color converter. The present invention also relates to a polymer mixture comprising at least one 2,5-furandicarboxylate polyester and at least one luminescent material, to a lighting device comprising at least one LED and said color converter and to a device producing electric power upon illumination comprising a photovoltaic cell and said color converter.

### BACKGROUND OF THE INVENTION

Light emitting diodes (LEDs) are replacing conventional light sources such as incandescent lamps and fluorescent lamps for general lighting applications due to their much higher energy efficiency and longer lifetime. Currently, a blue LED is used in combination with a fluorescent material to create an LED device to give white light.

According to a known method for this purpose, a polymeric material comprising a fluorescent colorant is applied directly to the LED light source (LED chip). Frequently, the polymeric material is supplied to the LED chip in approximately droplet or hemispherical form, as a result of which particular optical effects contribute to the emission of light. Such structures in which fluorescent colorants in a polymeric matrix are applied directly and without intervening space to an LED chip are also referred to as "phosphor on a chip". In phosphor on a chip LEDs, the fluorescent colorants used to date have generally been inorganic materials. The fluorescent materials, which may consist, for example, of cerium-doped yttrium aluminum garnet, absorb a certain proportion of blue light and emit longer-wave light with a broad emission band, such that the mixing of the blue light transmitted and of the light emitted gives rise to white light.

In order to improve the color reproduction of such lighting elements, it is additionally possible to incorporate a red-emitting diode as well as the white light diode described. This can produce light which many people perceive to be more pleasant. However, this is more technically complicated and more costly.

In phosphor on a chip LEDs, the polymeric material and the fluorescent material are subject to relatively high thermal and radiative stress. For this reason, organic fluorescent colorants have to date not been suitable for use in phosphor on a chip LEDs. Organic fluorescent colorants can in principle generate good color reproduction through their broad emission bands. However, they have to date not been stable enough to cope with the stresses in the case of direct arrangement on the LED chip.

In order to produce white light by color conversion from blue light, there is a further concept in which the color converter (also referred to simply as "converter"), which generally comprises a carrier and a polymer layer, is at a certain distance from the LED chip. Such a structure is referred to as "remote phosphor".

The spatial distance between the primary light source, the LED, and the color converter reduces the stress resulting from heat and radiation to such an extent that the requirements on the stability can be achieved by suitable organic fluorescent dyes. Furthermore, LEDs according to the "remote phosphor" concept are even more energy-efficient than those according to the "phosphor on a chip" concept.

One problem with color converters is still the degradation of organic fluorescent colorants under the influence of blue light source irradiation, especially degradation caused by exposure to air and/or water vapor. The same problem applies for color converters comprising quantum dots (QDs) as inorganic luminescent material. Typically, the polymers used in color converters are organic polymers which are transmissive for light having a wavelength in the range of 380-750 nm such as polystyrene, polycarbonate, polyethylene terephthalate, polyethylene naphthalate, polymethyl acrylate and polymethyl methacrylate, since they give the best optical properties compared to other polymers. However, the relative susceptibility of these polymers to gas permeation reduces the lifetime of the fluorescent colorant(s) and thus limits the lifetime of the color converter. Protection of the polymeric layer comprising the organic fluorescent colorant(s) and/or QDs by at least one barrier layer having low gas permeability is one option to increase the resistance to gas permeation and thus to increase the lifetime of the color converter. This option is described in WO 2012/152812. Another option may be using a polymer having higher barrier properties against gas permeation relative to the present polymers.

WO 2014/100265 describes polyethylene furanoate as a promising alternative to polyethylene terephthalate in terms of six times improved oxygen barrier and also improved moisture barrier. US 2011/120902 A1 and WO 2016/130748 A1 disclose polymeric materials comprising polyethylene 2,5-furandicarboxylate (PEF) with colorants. There is no indication that polyethylene furanoate based polyesters can be used as polymeric matrix material in color converters.

Nowadays, there is a growing interest in the use of polymers including components produced from renewable resources as an alternative to fossil based materials. Thus, there is a need in the art for alternative polymers for use in color converters, especially for polymers with improved gas barrier properties.

Surprisingly, it has been found that these and other objects are achieved by polymeric materials selected from at least one 2,5-furandicarboxylate polyester as described below.

### SUMMARY OF THE INVENTION

A first subject of the invention, therefore, is a a color converter comprising
- a polymeric matrix material comprising at least one 2,5-furandicarboxylate polyester (A) obtainable by reacting (i) at least one diol selected from an aliphatic C₂-C₂₀-diol and a cycloaliphatic C₃-C₂₀-diol, with (ii) 2,5-furandicarboxylic acid and/or an ester forming derivative thereof and (iii) optionally at least one further dicarboxylic acid selected from 1,2-cyclohexanedicarboxylic acid, 1,4-cyclohexanedicarboxylic acid, 3,4-furandicarboxylic acid, terephthalic acid and 2,6-naphthalic acid and/or an ester forming derivative thereof; and
- at least one luminescent material.

A further subject of the invention relates to the use of the color converter as defined above.

A further subject of the invention relates to a polymer mixture comprising at least one 2,5-furandicarboxylate polyester (A) and at least one luminescent material, preferably a fluorescent organic colorant.

A further subject of the invention relates to a lighting device comprising (i) at least one LED selected from a blue LED with a center wavelength of emission from 400 nm to 480 nm, especially from 420 nm to 480 nm and a cool white LED having a correlated color temperature between 3 000 K and 20 000 K, especially between 6 000 K and 20 000 K; and (ii) at least one color converter as defined above,wherein the at least one color converter is in a remote arrangement from the at least one LED.

A further subject of the invention relates to a device producing electric power upon illumination comprising a photovoltaic cell and the color converter as defined above, where at least a part of the light not absorbed by the photovoltaic cell is absorbed by the color converter.

### DESCRIPTION OF THE INVENTION

By use of at least one 2,5-furandicarboxylate polyester (A) in a polymeric matrix, it is possible to obtain color converters with high fluorescence quantum efficiency. In addition, the color converters have improved liftetime when compared to present color converters. The polyester (A) used according to the invention has at least one of the following advantages:
- transmissive for light in the range of 380-750 nm;
- high barrier property towards oxygen;
- high barrier property towards water vapor;
- high processability;
- high heat deflection temperature;
- readily obtainable from renewable starting materials;
- enables high fluorescence quantum yields for the luminescent material(s);
when compared to present polymers.

For the purpose of the present invention, the term "luminescent material" includes all materials which have luminescent properties, i.e. they are capable of absorbing light of a particular wavelength and converting it to light of another wavelength. The term "luminescent material" includes inorganic luminescent materials and organic luminescent materials. Organic luminescent materials are also referred to as fluorescent colorants. Fluorescent colorants include organic fluorescent pigments and organic fluorescent dyes. For the purpose of the present invention, the term "luminescent material" is also referred to as "radiation conversion luminophore" or "phosphor". All these terms are used interchangeable.

For the purpose of the present invention, the term "conversion material" refers to a material that is excited by a photon of a first wavelength and emits photons of a second, different wavelength.

For the purpose of the present invention, "a phosphor-converted LED" refers to an LED element having a phosphor material layer coated thereon for converting or changing the color of the light emitted by the LED element to a different color.

For the purpose of the present invention, a quantum dot is a nanocrystal made of semiconductor materials that is small enough to exhibit quantum mechanical properties. Quantum dots are showing remarkably narrow emission spectra, i.e. with extraordinary small FWHM (full width of half maximum). The color output of the dots can be tuned by controlling the size of the crystals. With a smaller size in quantum dots, the quantum dots emit light of a shorter wavelength.

For the purpose of the present invention, "color converter" is understood to mean all physical devices capable of absorbing light of particular wavelengths and converting it to light of a second wavelength. Color converters are, for example, part of lighting devices, especially those lighting devices which utilize LEDs or OLEDs as a light source, or of fluorescence conversion solar cells. Thus, the blue light may be (at least) partly converted into visible light of longer wavelengths than the excitation wavelengths.

For the purpose of the present invention, the term "center wavelength" of a given spectral distribution F(λ) is defined as the following average: λ_{c} = ∫λ•F(λ) dλ / ∫F(λ) dλ.

In the context of the present invention, a "blue LED" is understood to mean an LED which emits light in the blue range of the electromagnetic spectrum with a center wavelength of emission in the range of 400 to 480 nm, preferably 420 to 480 nm, more preferably 440 to 470 nm, especially at 440 to 460 nm. Suitable semiconductor materials are silicon carbide, zinc selenide and nitrides such as aluminum nitride (AIN), gallium nitride (GaN), indium nitride (InN) and indium gallium nitride (InGaN). LEDs typically have a narrow wavelength distribution that is tightly centered about their peak wavelength. Standard InGaN-based blue LEDs are fabricated on a sapphire substrate and peak emission wavelength is usually centered at 445 to 455 nm.

Light sources that are not incandescent radiators have correlated color temperatures. The correlated color temperature (CCT) is the temperature of a black body radiator that is perceived by the human eye to emit the same white light as the LEDs. The correlated color temperature (CCT) describes the color appearance of white light emitted from electric light sources and is measured in Kelvin. It is determined according to the CIE international standard. CCT from a white light source usually is in the range from 1 500 K to 20 000 K, especially 2 000 K to 20 000 K. White light having higher CCT contains relatively higher intensity in the short wavelength region (blue) and relatively lower intensity in the longer wavelength region (red) compared to white light with lower CCT. Accordingly, higher CCTs generally indicate white light having a more significant blue component or a cool tone while lower CCTs generally indicate light having a more significant red tint or a warm tone.

For the purpose of the present invention, the word "essentially" encompasses the words "completely", "wholly" and "all". The word encompasses a proportion of 90% or more, such as 95% or more, especially 99% or 100%.

For the purpose of the present invention, the term "and/or" especially relates to one or more of the items mentioned before and after "and/or".

For the purpose of the present invention, the term "renewable resource" means that the material described comprises components that can be derived from animal material, or especially plant material, commonly called bio-mass. The components may be naturally occurring in the bio-mass or may be the transformation product of natural or genetically engineered organisms or other chemical transformation processes.

For the purpose of the present invention, the term "bio-mass" refers to material derived from living or recently living biological material.

For the purpose of the invention, the article "a" and "an" preceding an element does not exclude the presence of a plurality of such elements.

The definitions of the variables specified in the above formulae use collective terms which are generally representative of the respective substituents. The definition Cₙ-Cₘ gives the number of carbon atoms possible in each case in the respective substituent or substituent moiety.

The expression "halogen" denotes in each case fluorine, bromine, chlorine or iodine, particularly chlorine, bromide or iodine.

In the context of the invention, the expression "in each case unsubstituted or substituted alkyl, cycloalkyl and aryl" represents unsubstituted or substituted alkyl, unsubstituted or substituted cycloalkyl and unsubstituted or substituted aryl.

Likewise, in the context of the invention, the expression "in each case unsubstituted or substituted C₁-C₃₀-alkyl, polyalkyleneoxy, C₁-C₃₀-alkoxy, C₁-C₃₀-alkylthio, C₃-C₂₀-cycloalkyl, C₃-C₂₀-cycloalkyloxy, C₆-C₂₄-aryl and C₆-C₂₄-aryloxy " represents unsubstituted or substituted C₁-C₃₀-alkyl, unsubstituted or substituted polyalkyleneoxy, unsubstituted or substituted C₁-C₃₀-alkoxy, unsubstituted or substituted C₁-C₃₀-alkylthio, unsubstituted or substituted C₃-C₂₀-cycloalkyl, unsubstituted or substituted C₃-C₂₀-cycloalkyloxy, unsubstituted or substituted C₆-C₂₄-aryl and unsubstituted or substituted C₆-C₂₄-aryloxy.

For the purpose of the present invention, the term "aliphatic radical" refers to an acyclic saturated or unsaturated, straight-chain or branched hydrocarbon radical. Usually the aliphatic radical has 1 to 100 carbon atoms. Examples for an aliphatic radical are alkyl, alkenyl and alkynyl.

For the purpose of the present invention, the term "cycloaliphatic radical" refers to a cyclic, non-aromatic saturated or unsaturated hydrocarbon radical having usually 3 to 20 ring carbon atoms. Examples are cycloalkanes, cycloalkenes, and cycloalkynes. The cycloaliphatic radical may also comprise heteroatoms or heteroatom groups selected from N, O, S and SO₂.

The term "alkyl" as used herein and in the alkyl moieties of alkoxy, alkylthio, alkylsulfinyl, alkylsulfonyl, alkylamino, dialkylamino, alkylcarbonyl, alkoxycarbonyl and the like refers to saturated straight-chain or branched hydrocarbon radicals having usually 1 to 100 ("C₁-C₁₀₀-alkyl"), 1 to 30 ("C₁-C₃₀-alkyl"),1 to 18 ("C₁-C₁₈-alkyl"), 1 to 12 ("C₁-C₁₂-alkyl"), 1 to 8 ("C₁-C₈-alkyl") or 1 to 6 ("C₁-C₆-alkyl") carbon atoms. Alkyl is preferably C₁-C₃₀-alkyl, more preferably C₁-C₂₀-alkyl. Examples of alkyl groups are especially methyl, ethyl, n-propyl, isopropyl, n-butyl, isobutyl, sec-butyl, tert-butyl, n-pentyl, 1-methylbutyl, 1-ethylpropyl, neo-pentyl, n-hexyl, 1-methylpentyl, 2-methylpentyl, 1-ethylbutyl, 2-ethylbutyl, n-heptyl, 1-methylhexyl, 2-methylhexyl, 1-ethylpentyl, 1-propylbutyl, 2-ethylpentyl, n-octyl, 1-methylheptyl, 2-methylheptyl, 1-ethylhexyl, 2-ethylhexyl, 1-propylpentyl, 2-propylpentyl, n-nonyl, etc.

Substituted alkyl groups, depending on the length of the alkyl chain, have one or more (e.g. 1, 2, 3, 4, 5 or more than 5) substituents. These are preferably each independently of each other selected from unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted alkyl groups have one or more, for example 1, 2 or 3 substituent(s) selected from unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

Special embodiments of substituted alkyl groups are alkyl groups, wherein one hydrogen atom has been replaced by an aryl radical ("aralkyl", also referred to hereinafter as arylalkyl or arylalkylene), in particular a phenyl radical. The aryl radical in turn may be unsubstituted or substituted, suitable substituents are the substituents mentioned below for aryl. Particular examples of aryl-C₁-C₄-alkyl include benzyl, 1-phenethyl, 2-phenetyl, 1-phenylpropyl, 2-phenylpropyl, 3-phenyl-1-propyl, 2-phenyl-2-propyl, naphthylmethyl, naphthylethyl etc.

Further special embodiments of substituted alkyl groups are alkyl groups where some or all of the hydrogen atoms in these groups may be replaced by halogen atoms as mentioned above, for example C₁-C₄-haloalkyl.

The term "alkenyl" as used herein refers to straight-chain or branched hydrocarbon groups having usually 2 to 100 ("C₂-C₁₀₀-alkenyl"), 2 to 18 ("C₂-C₁₈-alkenyl"), 2 to 10 ("C₂-C₁₀-alkenyl"), 2 to 8 ("C₂-C₈-alkenyl"), or 2 to 6 ("C₂-C₆-alkenyl") carbon atoms and one or more, e.g. 2 or 3, double bonds in any position. Substituted alkenyl groups, depending on the length of the alkenyl chain, have one or more (e.g. 1, 2, 3, 4, 5 or more than 5) substituents. These are preferably each independently of each other selected from unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, NE¹E², -NR^{Ar1}COR^{Ar2}, - CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted alkenyl groups have one or more, for example 1, 2 or 3 substituent(s) selected from unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

The term "alkynyl" as used herein (also referred to as alkyl whose carbon chain may comprise one or more triple bonds) refers to straight-chain or branched hydrocarbon groups having usually 2 to 100 ("C₂-C₁₀₀-alkynyl"), 2 to 18 ("C₂-C₁₈-alknyl"), 2 to 10 ("C₂-C₁₀-alkynyl"), 2 to 8 ("C₂-C₈-alkynyl"), or 2 to 6 ("C₂-C₆-alkynyl") carbon atoms and one or more, e.g. 2 or 3, triple bonds in any position. Substituted alkynyl groups, depending on the length of the alkynyl chain, have one or more (e.g. 1, 2, 3, 4, 5 or more than 5) substituents. These are preferably each independently of each other selected from unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, alkylcarbonyloxy, formyl, acyl, COOH, carboxylate, -COOR^{Ar1}, NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted alkynyl groups have one or more, for example 1, 2 or 3 substituent(s) selected from unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, - CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

The term "alkoxy" as used herein refers to an alkyl group bound through an oxygen atom, that is, an "alkoxy" group may be represented as -O-alkyl where alkyl is as defined above. C₁-C₂-Alkoxy is methoxy or ethoxy. C₁-C₄-Alkoxy is, for example, methoxy, ethoxy, n-propoxy, 1-methylethoxy (isopropoxy), butoxy, 1-methylpropoxy (sec-butoxy), 2-methylpropoxy (isobutoxy) or 1,1-dimethylethoxy (tert-butoxy).

Accordingly, the term "unsubstituted or substituted alkoxy" as used herein refers to -O-alkyl where alkyl is unsubstituted or substituted as defined above.

The term "polyoxyalkylene" as used herein refers to an alkyl group bound through an oxygen atom to the remainder of the molecule, where alkyl is interrupted by one or more non-adjacent oxygen atoms and alkyl is as defined above.

Accordingly, the term "unsubstituted or substituted polyalkyleneoxy" as used herein refers to -O-alkyl where alkyl is interrupted by one or more non-adjacent oxygen atoms and alkyl is unsubstituted or substituted as defined above.

The term "alkylthio" as used herein refers to an alkyl group bound through a sulfur atom, that is, an "alkylthio" group may be represented as -S-alkyl where alkyl is as defined above. C₁-C₂-Alkylthio is methylthio or ethylthio. C₁-C₄-Alkylthio is, for example, methylthio, ethylthio, n-propylthio, 1-methylethylthio (isopropylthio), butylthio, 1-methylpropylthio (sec-butylthio), 2-methylpropylthio (isobutylthio) or 1,1-dimethylethylthio (tert-butylthio).

Accordingly, the term "unsubstituted or substituted alkylthio" as used herein refers to -S-alkyl where alkyl is unsubstituted or substituted as defined above.

The term "cycloalkyl" as used herein refers to mono- or bi- or polycyclic saturated hydrocarbon radicals having usually 3 to 24 (C₃-C₂₄-cycloalkyl), 3 to 20 ("C₃-C₂₀-cycloalkyl") atoms, preferably 3 to 8 ("C₃-C₈-cycloalkyl") or 3 to 6 carbon atoms ("C₃-C₆-cycloalkyl"). Examples of monocyclic radicals having 3 to 6 carbon atoms comprise cyclopropyl, cyclobutyl, cyclopentyl and cyclohexyl. Examples of monocyclic radicals having 3 to 8 carbon atoms comprise cyclopropyl, cyclobutyl, cyclopentyl, cyclohexyl, cycloheptyl and cyclooctyl. Examples of bicyclic radicals having 7 to 12 carbon atoms comprise bicyclo[2.2.1]heptyl, bicyclo[3.1.1]heptyl, bicyclo[2.2.2]octyl, bicyclo[3.3.0]octyl, bicyclo[3.2.1]octyl, bicyclo[3.3.1]nonyl, bicyclo[4.2.1]nonyl, bicyclo[4.3.1]decyl, bicyclo[3.3.2]decyl, bicyclo[4.4.0]decyl, bicyclo[4.2.2]decyl, bicyclo[4.3.2] undecyl, bicyclo[3.3.3]undecyl, bicyclo[4.3.3]dodecyl,and perhydronaphthyl. Examples of polycyclic rings are perhydroanthracyl, perhydrofluorenyl, perhydrochrysenyl, perhydropicenyl, and adamantyl.

Substituted cycloalkyl groups may, depending on the ring size, have one or more (e.g. 1, 2, 3, 4, 5 or more than 5) substituents. These are preferably each independently of each other selected from unsubstituted or substituted alkyl, unsubstituted or substituted alkenyl, unsubstituted or substituted alkynyl, unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, -NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted cycloalkyl groups have one or more, for example 1, 2 or 3 substituent(s) selected from unsubstituted or substituted alkyl, unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

The term "cycloalkyloxy" as used herein refers to a cycloalkyl group bound through an oxygen atom, that is, a "cycloalkyloxy" group may be represented as -O-cycloalkyl where cycloalkyl is as defined above.

Accordingly, the term "unsubstituted or substituted cycloalkyloxy" as used herein refers to -O-cycloalkyl where cycloalkyl is unsubstituted or substituted as defined above.

The term "cycloalkylthio" as used herein refers to a cycloalkyl group bound through a sulfur atom, that is, a "cycloalkylthio" group may be represented as -S-cycloalkyl where cycloalkyl is as defined above.

Accordingly, the term "unsubstituted or substituted cycloalkylthio" as used herein refers to -S-cycloalkyl where cycloalkyl is unsubstituted or substituted as defined above.

The term "heterocycloalkyl" refers to nonaromatic, partially unsaturated or fully saturated, heterocyclic rings having generally 5 to 8 ring members, preferably 5 or 6 ring members, comprising besides carbon atoms as ring members, one, two, three or four heteroatoms or heteroatom-containing groups selected from O, N, NR^{cc}, S, SO and S(O)₂ as ring members, wherein R^{cc} is hydrogen, C₁-C₂₀-alkyl, C₃-C₂₄-cycloalkyl, heterocycloalkyl, C₆-C₂₄-aryl or heteroaryl. Examples of heterocycloalkyl groups are especially pyrrolidinyl, piperidinyl, imidazolidinyl, pyrazolidinyl, oxazolidinyl, morpholinyl, thiazolidinyl, isothiazolidinyl, isoxazolidinyl, piperazinyl, tetrahydrothiophenyl, dihydrothien-2-yl, tetrahydrofuranyl, dihydrofuran-2-yl, tetrahydropyranyl, 2-oxazolinyl, 3-oxazolinyl, 4-oxazolinyl and dioxanyl.
Substituted heterocycloalkyl groups may, depending on the ring size, have one or more (e.g. 1, 2, 3, 4, 5 or more than 5) substituents. These are preferably each independently of each other selected from unsubstituted or substituted alkyl, unsubstituted or substituted alkenyl, unsubstituted or substituted alkynyl, unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, -NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted heterocycloalkyl groups have one or more, for example 1, 2 or 3 substituent(s) selected from unsubstituted or substituted alkyl, unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

For the purpose of the present invention, the term "aryl" refers to phenyl and bi- or polycyclic carbocycles having at least one fused phenylene ring, which is bound to the remainder of the molecule. Examples of bi- or polycyclic carbocycles having at least one phenylene ring include naphthyl, tetrahydronaphthyl, indanyl, indenyl, anthracenyl, fluorenyl etc. Preferably, the term "aryl" denotes phenyl and naphthyl.
Substituted aryls may, depending on the number and size of their ring systems, have one or more (e.g. 1, 2, 3, 4, 5 or more than 5) substituents. These are preferably each independently of each other selected from unsubstituted or substituted alkyl, unsubstituted or substituted alkenyl, unsubstituted or substituted alkynyl, unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, -NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted arylgroups have one or more, for example 1, 2 or 3 substituent(s) selected from unsubstituted or substituted alkyl, unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, each independently of each, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl.

Substituted aryl is preferably aryl substituted by at least one alkyl group ("alkaryl", also referred to hereinafter as alkylaryl). Alkaryl groups may, depending on the size of the aromatic ring system, have one or more (e.g. 1, 2, 3, 4, 5, 6, 7, 8, 9 or more than 9) alkyl substituents. The alkyl substituents may be unsubstituted or substituted. In this regard, reference is made to the above statements regarding unsubstituted and substituted alkyl. A special embodiment relates to alkaryl groups, wherein alkyl is unsubstituted. Alkaryl is preferably phenyl which bears 1, 2, 3, 4 or 5, preferably 1, 2 or 3, more preferably 1 or 2 alkyl substituents. Aryl which bears one or more alkyl radicals, is, for example, 2-, 3- and 4-methylphenyl, 2,4-, 2,5-, 3,5- and 2,6-dimethylphenyl, 2,4,6-trimethylphenyl, 2-, 3- and 4-ethylphenyl, 2,4-, 2,5-, 3,5- and 2,6-diethylphenyl, 2,4,6-triethylphenyl, 2-, 3- and 4-n-propylphenyl, 2-, 3- and 4-isopropylphenyl, 2,4-, 2,5-, 3,5- and 2,6-di-n-propylphenyl, 2,4,6-tripropylphenyl, 2-, 3- and 4-isopropylphenyl, 2,4-, 2,5-, 3,5- and 2,6-diisopropylphenyl, 2,4,6-triisopropylphenyl, 2-, 3- and 4-butylphenyl, 2,4-, 2,5-, 3,5- and 2,6-dibutylphenyl, 2,4,6-tributylphenyl, 2-, 3- and 4-isobutylphenyl, 2,4-, 2,5-, 3,5- and 2,6-diisobutylphenyl, 2,4,6-triisobutylphenyl, 2-, 3- and 4-sec-butylphenyl, 2,4-, 2,5-, 3,5- and 2,6-di-sec-butylphenyl, 2,4,6-tri-sec-butylphenyl, 2-, 3- and 4-tert-butylphenyl, 2,4-, 2,5-, 3,5- and 2,6-di-tert-butylphenyl and 2,4,6-tri-tert-butylphenyl.

C₆-C₂₄-aryloxy: C₆-C₂₄-aryl as defined above, which is bonded to the skeleton via an oxygen atom (-O-). Preference is given to phenoxy and naphthyloxy.

Accordingly, the term "unsubstituted or substituted aryloxy" as used herein refers to -O-aryl where aryl is unsubstituted or substituted as defined above.

C₆-C₂₄-arylthio: C₆-C₂₄-aryl as defined above, which is bonded to the skeleton via a sulfur atom (-S-). Preference is given to phenylthio and naphthylthio.

Accordingly, the term "unsubstituted or substituted arylthio" as used herein refers to -S-aryl where aryl is unsubstituted or substituted as defined above.

In the context of the present invention, the expression "hetaryl" (also referred to as heteroaryl) comprises heteroaromatic, mono- or polycyclic groups. In addition to the ring carbon atoms, these have 1, 2, 3, 4 or more than 4 heteroatoms as ring members. The heteroatoms are preferably selected from oxygen, nitrogen, selenium and sulfur. The hetaryl groups have preferably 5 to 18, e.g. 5, 6, 8, 9, 10, 11, 12, 13 or 14, ring atoms.

Monocyclic hetaryl groups are preferably 5- or 6-membered hetaryl groups, such as 2-furyl (furan-2-yl), 3-furyl (furan-3-yl), 2-thienyl (thiophen-2-yl), 3-thienyl (thiophen-3-yl), 1H-pyrrol-2-yl, 1H-pyrrol-3-yl, pyrrol-1-yl, imidazol-2-yl, imidazol-1-yl, imidazol-4-yl, pyrazol-1-yl, pyrazol-3-yl, pyrazol-4-yl, pyrazol-5-yl, 3-isoxazolyl, 4-isoxazolyl, 5-isoxazolyl, 3-isothiazolyl, 4-isothiazolyl, 5-isothiazolyl, 2-oxazolyl, 4-oxazolyl, 5-oxazolyl, 2-thiazolyl, 4-thiazolyl, 5-thiazolyl, 1,2,4-oxadiazol-3-yl, 1,2,4-oxadiazol-5-yl, 1,3,4-oxadiazol-2-yl, 1,2,4-thiadiazol-3-yl, 1,2,4-thiadiazol-5-yl, 1,3,4-thiadiazol-2-yl, 4H-[1,2,4]-triazol-3-yl, 1,3,4-triazol-2-yl, 1,2,3-triazol-1-yl, 1,2,4-triazol-1-yl, pyridin-2-yl, pyridin-3-yl, pyridin-4-yl, 3-pyridazinyl, 4-pyridazinyl, 2-pyrimidinyl, 4-pyrimidinyl, 5-pyrimidinyl, 2-pyrazinyl, 1,3,5-triazin-2-yl and 1,2,4-triazin-3-yl.

Polycyclic hetaryl groups have 2, 3, 4 or more than 4 fused rings. The fused-on rings may be aromatic, saturated or partly unsaturated. Examples of polycyclic hetaryl groups are quinolinyl, isoquinolinyl, indolyl, isoindolyl, indolizinyl, benzofuranyl, isobenzofuranyl, benzothiophenyl, benzoxazolyl, benzisoxazolyl, benzthiazolyl, benzoxadiazolyl, benzothiadiazolyl, benzoxazinyl, benzopyrazolyl, benzimidazolyl, benzotriazolyl, benzotriazinyl, benzoselenophenyl, thienothiophenyl, thienopyrimidyl, thiazolothiazolyl, dibenzopyrrolyl (carbazolyl), dibenzofuranyl, dibenzothiophenyl, naphtho[2,3-b]thiophenyl, naphtha[2,3-b]furyl, dihydroindolyl, dihydroindolizinyl, dihydroisoindolyl, dihydroquinolinyl and dihydroisoquinolinyl.

Substituted hetaryl groups may, depending on the number and size of their ring systems, have one or more (e.g. 1, 2, 3, 4, 5 or more than 5) substituents. These are preferably each independently of each other selected from unsubstituted or substituted alkyl, unsubstituted or substituted alkenyl, unsubstituted or substituted alkynyl, unsubstituted or substituted cycloalkyl, unsubstituted or substituted cycloalkyloxy, unsubstituted or substituted cycloalkylthio, unsubstituted or substituted heterocycloalkyl, unsubstituted or substituted aryl, unsubstituted or substituted aryloxy, unsubstituted or substituted arylthio, unsubstituted or substituted hetaryl, fluorine, chlorine, bromine, iodine, hydroxyl, mercapto, unsubstituted or substituted alkoxy, unsubstituted or substituted polyalkyleneoxy, unsubstituted or substituted alkylthio, unsubstituted or substituted cyclolalkyloxy, unsubstituted or substituted aryloxy, unsubstituted or substituted arylthio, cyano, nitro, unsubstituted or substituted alkylcarbonyloxy, formyl, acyl, COOH, carboxylate, -COOR^{Ar1}, -NE¹E², -NR^{Ar1}COR^{Ar2}, -CONR^{Ar1}R^{Ar2}, -SO₂NR^{Ar1}R^{Ar2} and -SO₃R^{Ar2}, where E¹ and E² are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl, and R^{Ar1} and R^{Ar2}, independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl. In particular, substituted hetarylgroups have one or more, for example 1, 2 or 3 substituent(s) selected from unsubstituted or substituted alkyl, unsubstituted or substituted cycloalkyl, unsubstituted or substituted aryl, fluorine, chlorine, bromine, hydroxyl, alkoxy, polyalkyleneoxy, mercapto, alkylthio, cyano, nitro, NE¹E², -NR^{Ar1}COR^{Ar2}, -CONR^{Ar1}R^{Ar2}, -SO₂NR^{Ar1}R^{Ar2}, and -SO₃R^{Ar2}, where E¹, E², R^{Ar1} and R^{Ar2} are as defined above.

Fused ring systems can comprise alicyclic, aliphatic heterocyclic, aromatic and heteroaromatic rings and combinations thereof, hydroaromatic joined by fusion. Fused ring systems comprise two, three or more (e.g. 4, 5, 6, 7 or 8) rings. Depending on the way in which the rings in fused ring systems are joined, a distinction is made between ortho-fusion, i.e. each ring shares at least one edge or two atoms with each adjacent ring, and peri-fusion in which a carbon atom belongs to more than two rings. Preferred fused ring systems are ortho-fused ring systems.

When # or * appear in a formula showing a substructure of a compound of the present invention, it denotes the attachment bond in the remainder molecule.

The color converter according to the invention comprises a polymeric matrix which mandatorily comprises at least one 2,5-furandicarboxylate polyester (A) as defined above and at least one luminecent material.

### 2,5-Furandicarboxylate polyester (A)

Suitable aliphatic C₂-C₂₀-diols are preferably linear or branched C₂-C₁₅-alkanediols, especially linear or branched C₂-C₁₀-alkanediols such as ethane-1,2-diol (ethylene glycol), propane-1,2-diol, propane-1,3-diol (propylene glycol), butane-1,3-diol, butane-1,4-diol (butylene glycol), 2-methyl-1,3-propanediol, pentane-1,5-diol, 2,2-dimethyl-1,3-propanediol (neopentyl glycol), hexane-1,6-diol, heptane-1,7-diol, octane-1,8-diol, nonane-1,9-diol, decane-1,10-diol, etc. Suitable cycloaliphatic C₃-C₂₀-diols are preferably C₃-C₁₀-cycloalkylenediols, such as 1,2-cyclopentanediol, 1,3-cyclopentanediol, 1,2-cyclohexanediol, 1,4-cyclohexanediol, 1,2-cycloheptanediol or 1,4-cycloheptanediol. Other suitable cycloaliphatic C₃-C₂₀-diols include 1,3-cyclohexane dimethanol and 1,4-cyclohexane dimethanol, or 2,2,4,4-tetramethyl-1,3-cyclobutanediol, or combinations thereof. Particularly preferred diols are C₂-C₆-alkanediols, in particular ethane-1,2-diol, propane-1,2-diol, propane-1,3-diol, butane-1,3-diol, butane-1,4-diol, pentane-1,5-diol, 2,2-dimethyl-1,3-propanediol and mixtures thereof. More particularly preferred are ethane-1,2-diol and propane-1,3-diol. Especially preferred is ethane-1,2-diol.

More particularly preferred are also biologically derived ("bio-derived") C₂-C₁₀-alkanediols, especially C₂-C₆-alkanediols such as ethane-1,2-diol and propane-1,3-diol. Bio-based ethane-1,2-diol may be obtained from a ligno-cellulosic biomass source by the conversion of the carbohydrates therein contained. Methods for preparing C₂-C₁₀-alkanediols from biomass are known in the art, for example from US 2011/0306804.

Preferably, the diol component (i) is made up exclusively of one diol mentioned as preferred, especially ethane-1,2-diol. The diol component (i) may also comprise two, three or more than three different diols. If two, three or more than three different diols are used, preference is given to those mentioned above as being preferred. In this case, based on the total weight of component (i), ethane-1,2-diol is preferably the major component.

Ester forming derivatives of 2,5-furandicarboxylic acids are especially C₁-C₁₀-dialkyl esters of 2,5-furandicarboxylic acid. Particularly preferred diesters are C₁-C₆-dialkyl esters of 2,5-furandicarboxylic acid, especially the dimethyl ester and diethyl ester. Component (ii) may also comprise two, three or more than three different diesters of 2,5-furandicarboxylic acid. 2,5-Furandicarboxylic acid can be produced from bio-based sugars. Routes for the preparation of 2,5-furandicarboxylic acid using air oxidation of 2,5-disubstituted furans such as 5-hydroxymethylfurfural with catalysts comprising Co, Mn and/or Ce were reported recently in WO 2010/132740, WO 2011/043660, WO 2011/043661, US 2011/0282020, US 2014/0336349 and WO 2015/137804. Routes for the preparation of dialkyl ester of 2,5-furandicarboxylic acid are also described for example in WO 2011/043661.

Preferably, component (ii) is made up exclusively of 2,5-furandicarboxylic acid or of diester(s) of 2,5-furandicarboxylic acid.

Preferably, the 2,5-furandicarboxylate polyester (A) is selected from poly(ethylene-2,5-furandicarboxylate), poly(propylene-2,5-furandicarboxylate), poly(ethylene-co-propylene-2,5-furandicarboxylate), poly(butylene-2,5-furandicarboxylate), poly(pentylene-2,5-furandicarboxylate), poly(neopentylene-2,5-furandicarboxylate) and mixtures thereof. In particular, the polymeric matrix material for use in the color converter according to the invention can consist of, can consist essentially of or can be selected from poly(ethylene-2,5-furandicarboxylate), poly(trimethylene-2,5-furandicarboxylate) and poly(butylene-2,5- furandicarboxylate). Especially, the polymeric matrix material for use in the color converter according to the invention consists of poly(ethylene-2,5-furandicarboxylate). In a further specific embodiment, the polymeric matrix material of the color converter comprises a mixture (blend) of different 2,5-furandicarboxylate polyesters (A) as defined above, for example, a blend of poly(ethylene-2,5-furandicarboxylate) and poly(propylene-2,5-furandicarboxylate). Poly(propylene-2,5-furandicarboxylate) is also referred to as poly(trimethylene 2,5-furandicarboxylate); poly(butylene-2,5-furandicarboxylate) is also referred to as poly(tetramethylene 2,5-furan-dicarboxylate), poly(pentylene-2,5-furandicarboxylate) is also referred to as poly(pentamethylene 2,5-furan-dicarboxylate).

Likewise suitable are 2,5-furandicarboxylate polyesters (A) obtainable by reacting at least one diol component (i) as defined above, component (ii) as defined above and at least one further diacid or diester component (iii) selected from 1,2-cyclohexanedicarboxylic acid, 1,4-cyclohexanedicarboxylic acid, 3,4-furandicarboxylic acid, terephthalic acid and 2,6-naphthalic acid and/or an ester forming derivative thereof. Ester forming derivative of 1,2-cyclohexanedicarboxylic acid, 1,4-cyclohexanedicarboxylic acid, 3,4-furandicarboxylic acid, terephthalic acid and 2,6-naphthalic acid are especially the C₁-C₁₀-dialkyl ester. Particularly preferred esters are C₁-C₆-dialkyl ester, especially the dimethyl ester and diethyl ester. When using a combination of component (ii) and component (iii), component (ii) is the major component based on the total weight of component (ii) and (iii). Examples are poly(ethylene-2,5-furandicarboxylate-co-1,2-cyclohexanedicarboxylate), poly(ethylene-2,5-furandicarboxylate-co-1,4-cyclohexanedicarboxylate), poly(ethylene-2,5-furandicarboxylate-co-terephthalate), poly(ethylene-2,5-furandicarboxylate-co-2,6-naphthalate) or poly(ethylene-2,5-furandicarboxylate-co-3,4-furandicarboxylate), preferably poly(ethylene-2,5-furandicarboxylate-co-terephthalate), poly(ethylene-2,5-furandicarboxylate-co-2,6-naphthalate) or poly(ethylene-2,5-furandicarboxylate-co-3,4-furandicarboxylate.

The 2,5-furandicarboxylate polyester (A) can be prepared as described in US 2,551,731.

Alternatively, the polymeric matrix material comprises a blend comprising a 2,5-furandicarboxylate polyester (A) as described above and one or more conventional light-transmissive polymers. Suitable light-transmissive polymers are, for example, polystyrene, polycarbonate, polyester, polymethyl methacrylate, polyvinylpyrrolidone, polymethacrylate, polyvinyl acetate, polyvinyl chloride, polybutene, silicone, polyacrylate, epoxy resin, polyvinyl alcohol, poly(ethylene vinylalcohol)-copolymer, polyacrylonitrile, polyvinylidene chloride, polystyrene-acrylonitrile, polyvinyl butyrate, polyvinyl chloride, polyamides, polyoxymethylenes, polyimides, polyetherimides and mixtures.

In this case, preference is given to a blend of at least two polyesters, a first polyester that is poly(ethylene-2,5-furandicarboxylate) obtainable as described above and at least one second polyester which is selected from a polyester obtainable from 1,2-cyclohexanedicarboxylic acid, 1,4-cyclohexanedicarboxylic acid, terephthalic acid, 2,6-naphthalenedicarboxylic acid and/or an ester forming derivative thereof with at least one diol selected from an aliphatic C₂-C₂₀-diol and a cycloaliphatic C₃-C₂₀-diol. Suitable ester forming derivatives of 1,2-cyclohexanedicarboxylic acid, 1,4-cyclohexanedicarboxylic acid, terephthalic acid and 2,6-naphthalenedicarboxylic acid, respectively, are especially the C₁-C₁₀-dialkyl ester of said acid. Particularly preferred esters are the C₁-C₆-dialkyl esters, in particular the dimethyl esters and the diethyl esters. With regard to suitable aliphatic C₂-C₂₀-diols and cycloaliphatic C₃-C₂₀-diols, the statements made above for component (i) apply correspondingly. Preferably, the at least one second polyester is poly(ethylene terephthalate), poly(ethylene 2,6-naphthalate), poly(butylene terephthalate), or poly(butylene 2,6-naphthalate).

The at least one second polyester can be prepared according to standard methods, for example in analogy to the methods described in US 2,551,731 and WO 2010/0177133.

The 2,5-furandicarboxylate polyester (A) and, if present, further light-transmissive polymers serve as matrix material for the at least one luminescent material.

Useful 2,5-furandicarboxylate polyesters(A) have a low oxygen permeability at 25°C. Useful 2,5-furandicarboxylate polyesters(A) have a low water vapor permeability at 25°C.

The polymeric matrix material used according to the invention may have a light transmission in the range of 50 - 100%, especially in the range of 70-100% for light generated by the light source of the illumination device (see also below).

### Luminescent material

The color converter comprises at least one luminescent material, of which preferably at least one is an organic fluorescent colorant. Suitable organic fluorescent colorants are in principle all organic dyes or pigments, which have a sufficient stability to thermal and radiative stress and which can be incorporated into a polymer. For example the organic fluorescent colorant(s) may molecularly be distributed through the polymer matrix or are dissolved in the polymer matrix.

In a specific embodiment, the at least one fluorescent colorant (B) is an organic fluorescent colorant selected from the groups of colorants (B1), (B2), (B3), (B4), (B5), (B6), (B7), (B8), (B9), (B10), (B11), (B12), (B13), (B14) and (B15), which are defined as follows:
(B1) a naphthoylbenzimidazole compound of formula (I) 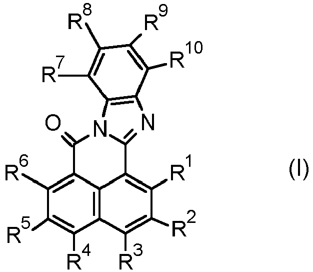 wherein
   at least one of the radicals R¹, R², R³, R⁴, R⁵, R⁶, R⁷, R⁸, R⁹ and R¹⁰ independently of each other is aryl which carries one, two or three cyano groups and 0, 1, 2, 3 or 4 substituents R^{Ar} and the remaining radicals R¹, R², R³, R⁴, R⁵, R⁶, R⁷, R⁸, R⁹ and R¹⁰ independently of each other are selected from hydrogen and aryl which is unsubstituted or carries 1, 2, 3, 4 or 5 substituents R^{Ar},
   where
   - R^{Ar}: independently of each other and independently of each occurrence is selected from halogen, C₁-C₃₀-alkyl, C₂-C₃₀-alkenyl, C₂-C₃₀-alkynyl, where the three latter radicals are unsubstituted or carry one or more R^{a} groups, C₃-C₈-cycloalkyl, 3- to 8-membered heterocyclyl, where the two latter radicals are unsubstituted or carry one or more R^{b} groups, aryl and heteroaryl, where the two latter radicals are unsubstituted or carry one or more R^{c} groups, where
   R^{a} independently of each other and independently of each occurrence is selected from cyano, halogen, C₃-C₈-cycloalkyl, 3- to 8-membered heterocyclyl, aryl and heteroaryl, where C₃-C₈-cycloalkyl, 3- to 8-membered heterocyclyl are unsubstituted or bear one or more R^{b1} groups, and where aryl and heteroaryl are unsubstituted or bear one or more R^{c1} groups;
   R^{b} independently of each other and independently of each occurrence is selected from cyano, halogen, C₁-C₁₈-alkyl, C₃-C₈-cycloalkyl, 3- to 8-membered heterocyclyl, aryl and heteroaryl, where C₃-C₈-cycloalkyl, 3- to 8-membered heterocyclyl are unsubstituted or bear one or more R^{b1} groups, and where aryl and heteroaryl are unsubstituted or bear one or more R^{c1} groups;
   R^{c} independently of each other and independently of each occurrence is selected from cyano, halogen, C₁-C₁₈-alkyl, C₃-C₈-cycloalkyl, 3- to 8-membered heterocyclyl, aryl and heteroaryl, where C₃-C₈-cycloalkyl, 3- to 8-membered heterocyclyl are unsubstituted or bear one or more R^{b1} groups, and where aryl and heteroaryl are unsubstituted or bear one or more R^{c1} groups;
   R^{b1} independently of each other and independently of each occurrence is selected from halogen, C₁-C₁₈-alkyl and C₁-C₁₈-haloalkyl,
   R^{c1} independently of each other and independently of each occurrence is selected from halogen, C₁-C₁₈-alkyl and C₁-C₁₈-haloalkyl;
   or mixtures thereof;
(B2) a cyanated naphthoylbenzimidazole compound of formula (II) 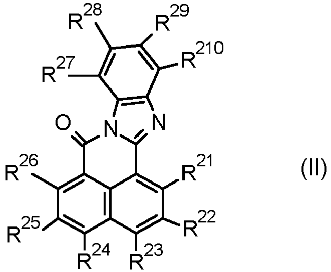 wherein
   R²¹, R²², R²³, R²⁴, R²⁵, R²⁶, R²⁷, R²⁸, R²⁹ and R²¹⁰ are each independently hydrogen, cyano or aryl which is unsubstituted or has one or more identical or different substituents R^{2Ar}, where
   each R^{2Ar} is independently selected from cyano, hydroxyl, mercapto, halogen, C₁-C₂₀-alkoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₃₀-alkyl, C₂-C₃₀-alkenyl, C₂-C₃₀-alkynyl, where the three latter radicals are unsubstituted or bear one or more R^{2a} groups, C₃-C₈-cycloalkyl, 3- to 8-membered heterocyclyl, where the two latter radicals are unsubstituted or bear one or more R^{2b} groups, aryl, U-aryl, heteroaryl and U-heteroaryl, where the four latter radicals are unsubstituted or bear one or more R^{2b} groups;
      where
   each R^{2a} is independently selected from cyano, hydroxyl, oxo, mercapto, halogen, C₁-C₂₀-alkoxy, C₁-C₂₀-alkylthio, nitro, -NR^{2Ar2}R^{Ar3}, -NR^{2Ar2}COR^{2Ar3}, -CONR^{2Ar2}R^{Ar3}, -SO₂NR^{2Ar2}R^{Ar3}, -COOR^{2Ar2}, -SO₃R^{2Ar2}, C₃-C₈-cycloalkyl, 3- to 8-membered heterocyclyl, aryl and heteroaryl, where the cycloalkyl, heterocyclyl, aryl and heteroaryl radicals are unsubstituted or bear one or more R^{2b} groups;
   each R^{2b} is independently selected from cyano, hydroxyl, oxo, mercapto, halogen, C₁-C₂₀-alkoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₁₈-alkyl, C₂-C₁₈-alkenyl, C₂-C₁₈-alkynyl, C₃-C₈-cycloalkyl, 3- to 8-membered heterocyclyl, aryl and heteroaryl, where the four latter radicals are unsubstituted or bear one or more R^{2b1} groups;
   each R^{2b1} is independently selected from cyano, hydroxyl, mercapto, oxo, nitro, halogen, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, -SO₃R^{2Ar2}, C₁-C₁₈-alkyl, C₂-C₁₈-alkenyl, C₂-C₁₈-alkynyl, C₁-C₁₂-alkoxy, and C₁-C₁₂-alkylthio,
   U is an -O-, -S-, -NR^{2Ar1}-, -CO-, -SO- or -SO₂- moiety; R^{2Ar1}, R^{2Ar2}, R^{2Ar3} are each independently hydrogen, C₁-C₁₈-alkyl, 3- to 8-membered cycloalkyl, 3- to 8-membered heterocyclyl, aryl or heteroaryl, where alkyl is unsubstituted or bears one or more R^{2a} groups, where 3- to 8-membered cycloalkyl, 3- to 8-membered heterocyclyl, aryl and heteroaryl are unsubstituted or bear one or more R^{2b} groups;
   with the proviso that the compound of formula (II) comprises at least one cyano group,
   or mixtures thereof;
(B3) a cyanated perylene compound of formula (III) 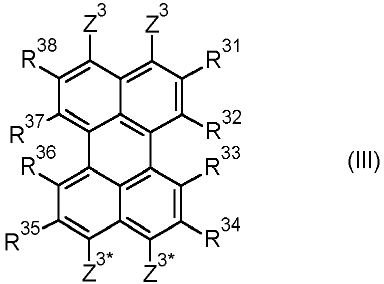 in which
   one of the Z³ substituents is cyano and the other Z³ substituent is CO₂R³⁹, CONR³¹⁰R³¹¹, C₁-C₁₈-alkyl, C₂-C₁₈-alkenyl, C₂-C₁₈-alkynyl, C₃-C₁₂-cycloalkyl or C₆-C₁₄-aryl, where
      C₁-C₁₈-alkyl, C₂-C₁₈-alkenyl, C₂-C₁₈-alkynyl are unsubstituted or bear one or more identical or different Z^{3a} substituents,
      C₃-C₁₂-cycloalkyl is unsubstituted or bears one or more identical or different Z^{3b} substituents, and
      C₆-C₁₄-aryl is unsubstituted or bears one or more identical or different Z^{3Ar} substituents;
      one of the Z^{3*} substituents is cyano and the other Z^{3*} substituent is CO₂R³⁹, CONR³¹⁰R³¹¹, C₁-C₁₈-alkyl, C₂-C₁₈-alkenyl, C₂-C₁₈-alkynyl, C₃-C₁₂-cycloalkyl or C₆-C₁₄-aryl, where
      C₁-C₁₈-alkyl, C₂-C₁₈-alkenyl, C₂-C₁₈-alkynyl are unsubstituted or bear one or more identical or different Z^{3a} substituents,
      C₃-C₁₂-cycloalkyl is unsubstituted or bears one or more identical or different Z^{3b} substituents, and
      C₆-C₁₄-aryl is unsubstituted or bears one or more identical or different Z^{3Ar} substituents;
   R³¹, R³², R³³, R³⁴, R³⁵, R³⁶, R³⁷ and R³⁸ are each independently selected from hydrogen, cyano, bromine and chlorine,
      with the proviso that 1, 2, 3, 4, 5, 6, 7 or 8 of the R³¹, R³², R³³, R³⁴, R³⁵, R³⁶, R³⁷ or R³⁸ substituents are cyano;
         where
      R³⁹ is hydrogen, C₁-C₁₀-alkyl, C₂-C₁₀-alkenyl, C₂-C₁₀-alkynyl, C₃-C₁₂-cycloalkyl or C₆-C₁₄-aryl, where
         C₁-C₁₀-alkyl, C₂-C₁₀-alkenyl, C₂-C₁₀-alkynyl are unsubstituted or bear one or more identical or different R^{3a} substituents,
         C₃-C₁₂-cycloalkyl is unsubstituted or bears one or more identical or different R^{3b} substituents and
         C₆-C₁₄-aryl is unsubstituted or bears one or more identical or different R^{3Ar} substituents;
      R³¹⁰ and R³¹¹ are each independently hydrogen, C₁-C₁₀-alkyl, C₂-C₁₀-alkenyl, C₂-C₁₀-alkynyl, C₃-C₁₂-cycloalkyl or C₆-C₁₄-aryl, where
         C₁-C₁₀-alkyl, C₂-C₁₀-alkenyl, C₂-C₁₀-alkynyl are unsubstituted or bear one or more identical or different R^{3a} substituents,
         C₃-C₁₂-cycloalkyl is unsubstituted or bears one or more identical or different R^{3b} substituents and
         C₆-C₁₄-aryl is unsubstituted or bears one or more identical or different R^{3Ar} substituents;
   each Z^{3a} is independently halogen, hydroxyl, NR^{310a}R^{311a}, C₁-C₁₀-alkoxy, C₁-C₁₀-haloalkoxy, C₁-C₁₀-alkylthio, C₃-C₁₂-cycloalkyl, C₆-C₁₄-aryl, C(=O)R^{39a}; C(=O)OR^{39a} or C(O)NR^{310a}R^{311a}, where
      C₃-C₁₂-cycloalkyl is unsubstituted or bears one or more identical or different R^{3b} substituents and
      C₆-C₁₄-aryl is unsubstituted or bears one or more identical or different R^{3Ar} substituents;
   each Z^{3b} and each Z^{3Ar} is independently halogen, hydroxyl, NR^{310a}R^{311a}, C₁-C₁₀-alkyl, C₁-C₁₀-alkoxy, C₁-C₁₀-haloalkoxy, C₁-C₁₀-alkylthio, C(=O)R^{39a}; C(=O)OR^{39a} or C(O)NR^{310a}R^{311a};
      each R^{3a} is independently halogen, hydroxyl, C₁-C₁₀-alkoxy, C₃-C₁₂-cycloalkyl or C₆-C₁₄-aryl;
      each R^{3b} is independently halogen, hydroxyl, C₁-C₁₀-alkyl, C₁-C₁₀-alkoxy, C₁-C₁₀-haloalkoxy, C₁-C₁₀-alkylthio, C₂-C₁₀-alkenyl, C₂-C₁₀-alkynyl, C₃-C₁₂-cycloalkyl or C₆-C₁₄-aryl;
      each R^{3Ar} is independently halogen, hydroxyl, C₁-C₁₀-alkyl, C₁-C₁₀-alkoxy, C₁-C₁₀-haloalkoxy, C₁-C₁₀-alkylthio, C₂-C₁₀-alkenyl, C₂-C₁₀-alkynyl, C₃-C₁₂-cycloalkyl or C₆-C₁₄-aryl;
      R^{39a} is hydrogen, C₁-C₁₀-alkyl, C₂-C₁₀-alkenyl, C₂-C₁₀-alkynyl, C₃-C₁₂-cycloalkyl or C₆-C₁₄-aryl; and
      R^{310a}, R^{311a} are each independently hydrogen, C₁-C₁₀-alkyl, C₂-C₁₀-alkenyl, C₂-C₁₀-alkynyl, C₃-C₁₂-cycloalkyl or C₆-C₁₄-aryl;
      or mixtures thereof;
(B4) a cyanated compound of formula (IV) 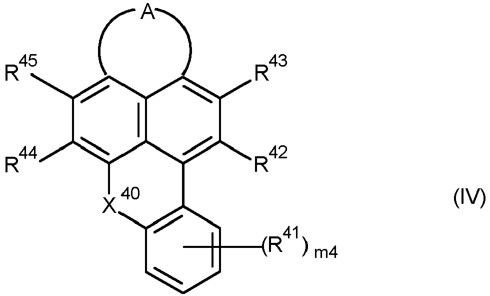 wherein
   - m4: is 0, 1, 2, 3 or 4;
   - each R⁴¹: independently from each other is selected from bromine, chlorine, cyano, -NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl, aryloxy in the six last-mentioned radicals are unsubstituted or substituted with 1, 2, 3, 4 or 5 identical or different radicals R^{41a} and where C₁-C₂₄-alkyl, C₁-C₂₄-haloalkyl, C₁-C₂₄-alkoxy, and the alkylene moiety of C₆-C₂₄-aryl-C₁-C₁₀-alkylene may be interrupted by one or more groups selected from O, S and NR^{4c}; at least one of the radicals R⁴², R⁴³, R⁴⁴ and R⁴⁵ is CN, and the remaining radicals, independently from each other, are selected from hydrogen, chlorine and bromine;
   - X⁴⁰: is O, S, SO or SO₂;
   - A: is a diradical selected from diradicals of the general formulae (A.1), (A.2), (A.3), and (A.4) 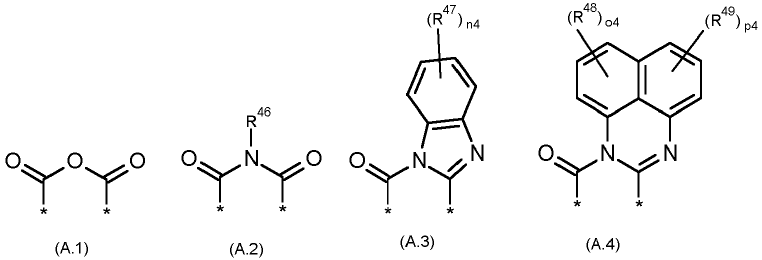 wherein
   * in each case denotes the point of attachments to the remainder of the molecule;
   n4 is 0, 1, 2, 3 or 4;
   o4 is 0, 1, 2 or 3;
   p4 is 0, 1, 2 or 3;
   R⁴⁶ is hydrogen, C₁-C₂₄-alkyl, C₁-C₂₄-haloalkyl, C₃-C₂₄-cycloalkyl, C₆-C₂₄-aryl or C₆-C₂₄-aryl-C₁-C₁₀-alkylene, where the rings of cycloalkyl, aryl, and aryl-alkylene in the three last-mentioned radicals are unsubstituted or substituted with 1, 2, 3, 4 or 5 identical or different radicals R^{46a}, and where C₁-C₂₄-alkyl, C₁-C₂₄-haloalkyl and the alkylene moiety of C₆-C₂₄-aryl-C₁-C₁₀-alkylene may be interrupted by one or more heteroatoms or heteroatomic groups selected from O, S and NR^{4c};
   each R⁴⁷ independently from each other is selected from bromine, chlorine, cyano, -NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl-alkylene in the six last-mentioned radicals are unsubstituted or substituted with 1, 2, 3, 4 or 5 identical or different radicals R^{47a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
   each R⁴⁸ independently from each other is selected from bromine, chlorine, cyano, NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl-alkylene in the six last-mentioned radicals are unsubstituted or substituted with 1, 2, 3, 4 or 5 identical or different radicals R^{48a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
   each R⁴⁹ independently from each other is selected from bromine, chlorine, cyano, NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl- alkylene in the six last-mentioned radicals are unsubstituted or substituted with 1, 2, 3, 4 or 5 identical or different radicals R^{49a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
   R^{41a}, R^{46a}, R^{47a}, R^{48a}, R^{49a} are independently of one another selected from C₁-C₂₄-alkyl, C₁-C₂₄-fluoroalkyl, C₁-C₂₄-alkoxy, fluorine, chlorine and bromine;
   R^{4a}, R^{4b}, R^{4c} are independently of one another are selected from hydrogen, C₁-C₂₀-alkyl, C₃-C₂₄-cycloalkyl, heterocycloalkyl, heteroaryl and C₆-C₂₄-aryl;
   or mixtures thereof;
(B5) a benz(othi)oxanthene compound of formula (V) 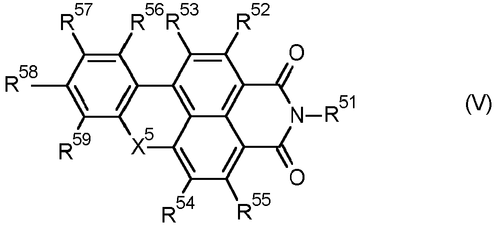 wherein
   - X⁵: is oxygen or sulfur;
   - R⁵¹: is phenyl which is unsubstituted or carries 1, 2, 3, 4, or 5 substituents selected from halogen, R⁵¹¹, OR⁵⁵², NHR⁵⁵² and NR⁵⁵²R⁵⁵⁷;
   - R⁵², R⁵³, R⁵⁴, R⁵⁵, R⁵⁶, R⁵⁷, R⁵⁸ and R⁵⁹: are independently of each other selected from hydrogen, halogen, R⁵⁵³, OR⁵⁵³, NHR⁵⁵³ and NR⁵⁵³R⁵⁵⁴,
   wherein
   R⁵¹¹ is selected from C₁-C₂₀-alkyl, C₆-C₂₄-aryl and heteroaryl;
   R⁵⁵² and R⁵⁵⁷ are independently of each other selected from C₁-C₁₈-alkyl, C₆-C₂₄-aryl and heteroaryl; and
   R⁵⁵³ and R⁵⁵⁴ are independently of each other selected from C₁-C₁₈-alkyl, C₆-C₂₄-aryl and heteroaryl;
   or mixtures thereof;
(B6) a benzimidazoxanthenisoquinoline compound of formula (VIA) or (VIB) 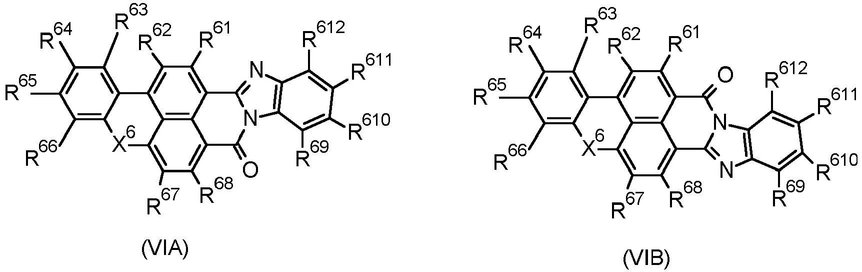 wherein
   X⁶ is oxygen or sulfur;
   R⁶¹, R⁶², R⁶³, R⁶⁴, R⁶⁵, R⁶⁶, R⁶⁷, R⁶⁸, R⁶⁹, R⁶¹⁰, R⁶¹¹ and R⁶¹² are independently of each other selected from hydrogen, halogen, R⁶⁶¹, OR⁶⁶¹, NHR⁶⁶¹ and NR⁶⁶¹R⁶⁶²;
      wherein
   each R⁶¹¹ is selected from C₁-C₁₈-alkyl, C₆-C₂₄-aryl and heteroaryl; and
   each R⁶⁶² is selected from C₁-C₁₈-alkyl, C₆-C₂₄-aryl and heteroaryl;
   or mixtures thereof;
(B7) fluorescent compound comprising at least one structural unit of formula (VII) 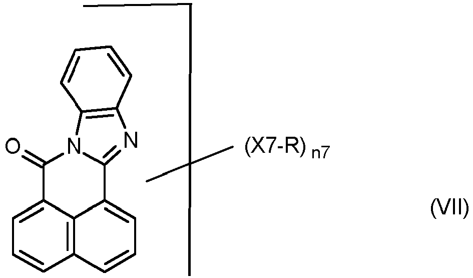 where one or more CH groups of the six-membered ring of the benzimidazole structure shown may be replaced by nitrogen and where the symbols are each defined as follows:
   - n7: is a number from 0 to (10-p7) for each structural unit of formula (VII); where p7 is the number of CH units which have been replaced by nitrogen in the six-membered ring of the benzimidazole structure shown
   - X7: is a chemical bond, O, S, SO, SO₂, NR⁷¹; and
   - R: is an aliphatic radical, cycloaliphatic radical, aryl, heteroaryl, each of which may bear substituents,
   an aromatic or heteroaromatic ring or ring system, each of which is fused to other aromatic rings of the structural unit of formula (VII), is F, Cl, Br, CN, H when X7 is not a chemical bond;
   where two R radicals may be joined to give one cyclic radical and where X7 and R, when n7 > one, may be the same or different;
   R⁷¹ is each independently hydrogen, C₁-C₁₈-alkyl or cycloalkyl, the carbon chain of which may comprise one or more -O-, -S-, -CO-, -SO- and/or -SO₂- moieties and which may be mono- or polysubstituted; aryl or heteroaryl which may be mono- or polysubstituted;
   or mixtures thereof;
(B8) a perylene compound of formulae (VIII) or (IX) 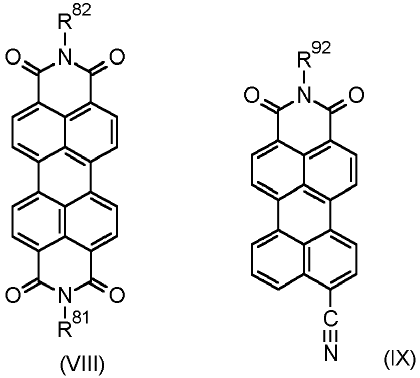 where
   - R⁸¹, R⁸²: are each independently C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀-aryl-C₁-C₁₀-alkylene, where the aromatic ring in the three latter radicals is unsubstituted or mono- or polysubstituted by C₁-C₁₀-alkyl;
   - R⁹²: is C₁-C₃₀-alkyl, C₃-C₈-cycloalkyl, aryl, heteroaryl, aryl-Ci-Cio-alkylene, where the aromatic ring in the three latter radicals is unsubstituted or mono- or polysubstituted by C₁-C₁₀-alkyl;
(B9) a naphthalene monoimide compound of formula (X) 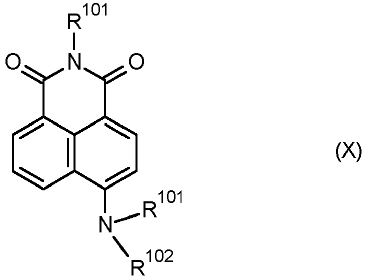 wherein
   - each R¹⁰¹: independently of each other is hydrogen, C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀-aryl-C₁-C₁₀-alkylene, where the aromatic ring in the three latter radicals is unsubstituted or mono- or polysubstituted by C₁-C₁₀-alkyl;
   - R¹⁰²: is hydrogen, C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀-aryl-C₁-C₁₀-alkylene, where the aromatic ring in the three latter radicals is unsubstituted or mono- or polysubstituted by C₁-C₁₀-alkyl;
(B10) 7-(diethylamino)-3-(5-methylbenzo[d]oxazol-2-yl)-2H-chromen-2-one;
(B11) a perylene compound of formulae (XIA) or (XIB), 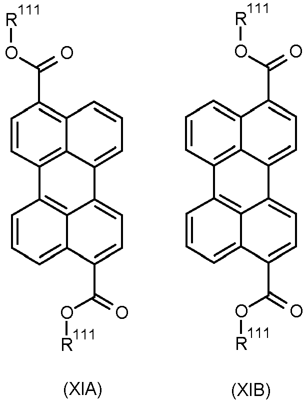 wherein
   each R¹¹¹ independently of each other is C₁-C₁₈ alkyl, C₄-C₈ cycloalkyl, which may be mono- or polysubstituted by halogen or by linear or branched C₁-C₁₈ alkyl, or phenyl or naphthyl which may be mono- or polysubstituted by halogen or by linear or branched C₁-C₁₈ alkyl;
   or mixtures thereof;
(B12) a cyanated perylene compound of formulae (XIIA) or (XIIB) 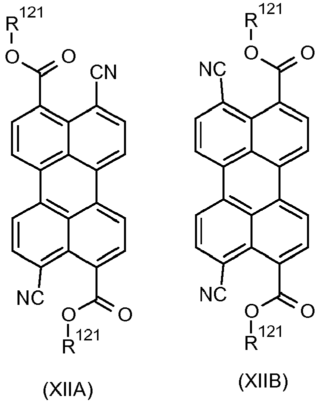 wherein
   each R¹²¹ independently of each other is C₁-C₁₈ alkyl, C₄-C₈ cycloalkyl, which may be mono- or polysubstituted by halogen or by linear or branched C₁-C₁₈ alkyl, or phenyl or naphthyl which may be mono- or polysubstituted by halogen or by linear or branched C₁-C₁₈ alkyl;
   or mixtures thereof;
(B13) a perylene bisimide compound of formula (XIII) 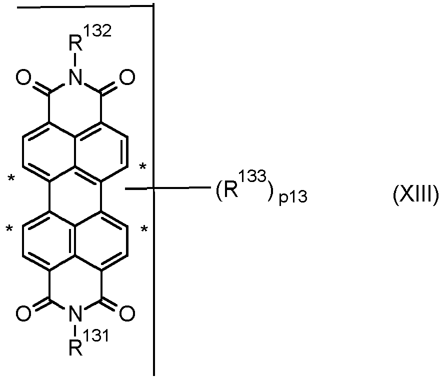 wherein
   p13 is 1, 2, 3 or 4;
   R¹³¹ and R¹³² independently of each other are C₁-C₁₀-alkyl, which is unsubstituted or substituted by C₆-C₁₀-aryl which in turn is unsubstituted or substituted by 1, 2 or 3 C₁-C₁₀-alkyl,
      C₂-C₂₀-alkyl, which is interrupted by one or more oxygen, C₃-C₈-cycloalkyl, which is unsubstituted or substituted by 1, 2 or 3 C₁-C₁₀-alkyl, or
      C₆-C₁₀-aryl which is unsubstituted or substituted by 1, 2 or 3 C₁-C₁₀-alkyl;
   each R¹³³ independently of each other is fluorine, chlorine, C₁-C₁₆-alkyl, C₂-C₁₆-alkyl interrupted by one or more oxygen, C₁-C₁₆-alkoxy, C₆-C₁₀-aryloxy which is unsubstituted or mono- or polysubstituted by fluorine, chlorine, C₁-C₁₆-alkyl, C₂-C₁₆-alkyl interrupted by one or more oxygen, C₁-C₁₆-alkoxy or C₆-C₁₀-aryl, which is unsubstituted or substituted by 1, 2 or 3 radicals selected from C₁-C₆-alkyl, C₁-C₆-alkoxy-C₁-C₆-alkyl and C₁-C₆-alkoxy, where the R¹³³ radicals are at the positions indicated by *;
   or mixtures thereof;
(B14)a perylene compound of formula (XIV) 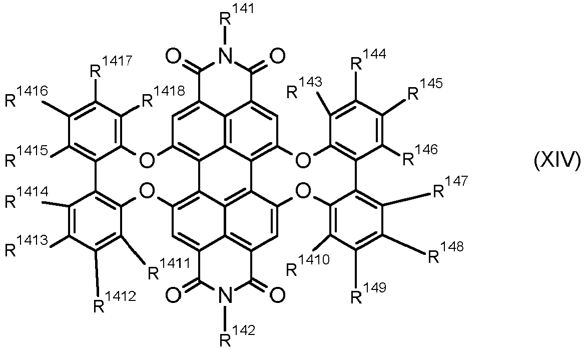 wherein
   R¹⁴¹ and R¹⁴², independently of each other, are selected from hydrogen, in each case unsubstituted or substituted C₁-C₃₀-alkyl, polyalkyleneoxy, C₁-C₃₀-alkoxy, C₁-C₃₀-alkylthio, C₃-C₂₀-cycloalkyl, C₃-C₂₀-cycloalkyloxy, C₆-C₂₄-aryl and C₆-C₂₄-aryloxy;
   R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ and R¹⁴¹⁸ independently of each other, are selected from hydrogen, halogen, cyano, hydroxyl, mercapto, nitro, -NE¹⁴¹E¹⁴², -NR^{Ar141}COR^{A142}, -CONR^{Ar141}R^{Ar142}, -SO₂NR^{A141}R^{A142}, -COOR^{Ar141}, -SO₃R^{Ar142}, in each case unsubstituted or substituted C₁-C₃₀-alkyl, polyalkyleneoxy, C₁-C₃₀-alkoxy, C₁-C₃₀-alkylthio, C₃-C₂₀-cycloalkyl, C₃-C₂₀-cycloalkoxy, C₆-C₂₄-aryl, C₆-C₂₄-aryloxy and C₆-C₂₄-arylthio,
      where R¹⁴³ and R¹⁴⁴, R¹⁴⁴ and R¹⁴⁵, R¹⁴⁵ and R¹⁴⁶, R¹⁴⁶ and R¹⁴⁷, R¹⁴⁷ and R¹⁴⁸, R¹⁴⁸ and R¹⁴⁹, R¹⁴⁹ and R¹⁴¹⁰, R¹⁴¹¹ and R¹⁴¹², R¹⁴¹² and R¹⁴¹³, R¹⁴¹³ and R¹⁴¹⁴, R¹⁴¹⁴ and R¹⁴¹⁵, R¹⁴¹⁵ and R¹⁴¹⁶, R¹⁴¹⁶ and R¹⁴¹⁷ and/or R¹⁴¹⁷ and R¹⁴¹⁸ together with the carbon atoms of the biphenylyl moiety to which they are bonded, may also form a further fused aromatic or non-aromatic ring system wherein the fused ring system is unsubstituted or substituted;
         where
      E¹⁴¹ and E142, independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl;
         R^{Ar141} and R^{Ar142}, each independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl;
      or mixtures thereof;
(B15) a 3,4;9,10-perylenetetracarboxylic diimide compound comprising a first group (XVa) and a second group (XVb),
   wherein the first group group (XVa) comprises one or more groups based on one or more of compound (V), compound (X), compound (XIA), compound (XIB), 7-(diethylamino)-3-(6-methylbenzo[d]oxazol-2-yl)-2H-chromen-2-one or compounds of formula (XVa1) 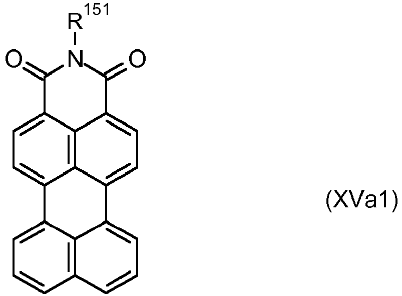 wherein
   - R¹⁵¹: is C₁-C₁₀-alkyl, which is unsubstituted or substituted by C₆-C₁₀-aryl which in turn is unsubstituted or substituted by 1, 2 or 3 C₁-C₁₀-alkyl, C₂-C₂₀-alkyl, which is interrupted by one or more oxygen, C₃-C₈-cycloalkyl, which is unsubstituted or substituted by 1, 2 or 3 C₁-C₁₀-alkyl, or C₆-C₁₀-aryl which is unsubstituted or substituted by 1, 2 or 3 C₁-C₁₀-alkyl;
   and wherein the second group (XVb) is 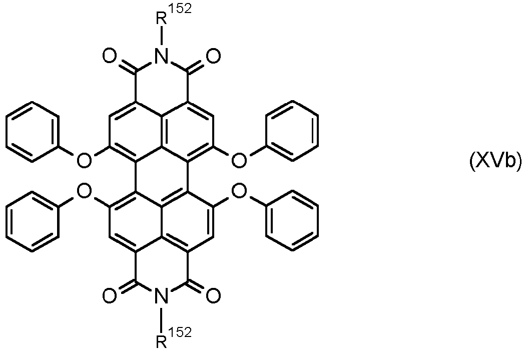 wherein
   - R¹⁵²: independently of each other, are selected from hydrogen, C₁-C₁₀-alkyl, which is unsubstituted or substituted by C₆-C₁₀-aryl which in turn is unsubstituted or substituted by 1, 2 or 3 C₁-C₁₀-alkyl, C₂-C₂₀-alkyl, which is interrupted by one or more oxygen, C₃-C₈-cycloalkyl, which is unsubstituted or substituted by 1, 2 or 3 C₁-C₁₀-alkyl, or C₆-C₁₀-aryl which is unsubstituted or substituted by 1, 2 or 3 C₁-C₁₀-alkyl or a group (XVb1) 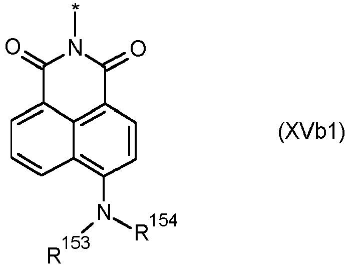 wherein
   * denotes the bonding site to the remainder of the molecule;
   R¹⁵³ and R¹⁵⁴, independently of each other, are selected from hydrogen, C₁-C₃₀-alkyl, C₂-C₃₀-alkenyl, C₂-C₃₀-alkynyl, C₃-C₁₂-cycloalkyl and C₆-C₂₄-aryl wherein the two last-mentioned radicals are unsubstituted or carry one, two or three radicals selected from C₁-C₁₀-alkyl.

### Organic fluorescent colorant (B1)

Naphthoylbenzimidazole compounds of formula (I) are known from EP 17151931.7. Compounds of formula (I) are usually yellow fluorescent compounds.

With regard to the use in color converters, compounds of formula (I) are preferred which correspond to a compound of formula (I-A) 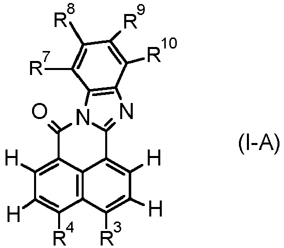 wherein
R³ and R⁴ are each independently hydrogen; phenyl; phenyl which carries 1 or 2 cyano groups; or phenyl which carries 1, 2 or 3 substituents selected from C₁-C₁₀-alkyl; and
R⁷, R⁸, R⁹ and R¹⁰ are each independently hydrogen; phenyl; phenyl which carries 1 or 2 cyano groups; or phenyl which carries 1, 2 or 3 substituents selected from C₁-C₁₀-alkyl.

Among the compounds of formula (I-A), preference is given to compounds, in which R⁸ and R¹⁰ have the same meaning. Likewise, preference is given to compounds, in which R⁷ and R⁹ have the same meaning and are in particular hydrogen. In particular, R⁸ and R¹⁰ have the same meaning and R⁷ and R⁹ have the same meaning.

A particular preferred embodiment of the invention relates to compounds of formula (I-A), wherein
- R³ and R⁴: are each independently selected from hydrogen; phenyl; phenyl which carries 1 or 2 cyano groups; and phenyl which carries 1, 2 or 3 C₁-C₁₀-alkyl substituents; in particular hydrogen, phenyl or phenyl which carries 1 cyano group;
- R⁷: is hydrogen;
- R⁸: is phenyl which carries 1 or 2 cyano groups; phenyl; or phenyl which carries 1, 2 or 3 substituents C₁-C₁₀-alkyl; in particular 4-cyanophenyl
- R⁹: is hydrogen; and
- R¹⁰: is phenyl which carries 1 or 2 cyano groups; phenyl; or phenyl which carries 1, 2 or 3 substituents C₁-C₁₀-alkyl in particular 4-cyanophenyl.

A more particular preferred embodiment of the invention relates to compounds of formula (I-A), wherein
- R³: is phenyl; phenyl which carries 1 cyano group; or phenyl which carries 1 substituent selected from C₁-C₁₀-alkyl; in particular phenyl which carries 1 cyano group;
- R⁴: is hydrogen;
- R⁸ and R¹⁰: are each phenyl which carries 1 cyano group;
- R⁷ and R⁹: are each hydrogen.

A further especially preferred embodiment of the invention relates to compounds of formula (I-A), wherein
- R³: hydrogen;
- R⁴: is phenyl; phenyl which carries 1 cyano group; or phenyl which carries 1 substituent selected from C₁-C₁₀-alkyl; in particular phenyl which carries 1 cyano group;
- R⁸ and R¹⁰: are each phenyl which carries 1 cyano group;
- R⁷ and R⁹: are each hydrogen.

Examples of preferred compounds of formula (I-A) are the compounds of formulae (I-A.1), (I-A.2) (I-A.3) and (I-A.4)

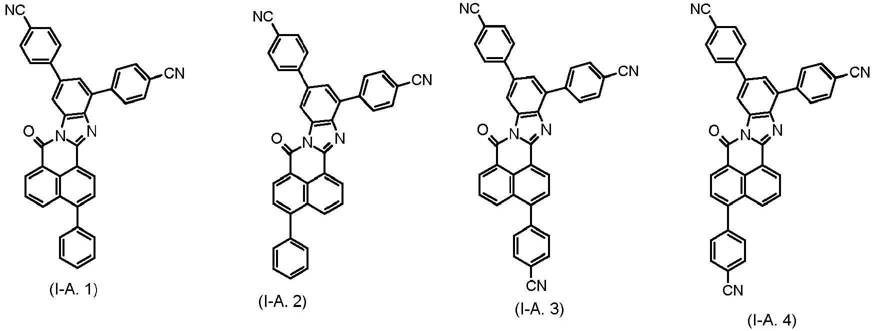

Compounds of formula I and mixtures thereof can be prepared in analogy to standard methods, for example as described in WO 2012/168395, especially on pages 64 - 81 or WO 2015/019270, on pages 21 - 30.

### Organic fluorescent colorant (B2)

Cyanated naphthoylbenzimidazole compound of formula (II) are known from WO 2015/019270. Compounds of formula (II) are usually green, yellow-green or yellow fluorescent dyes. With regard to the use in the color converter of the present invention, the compound (II) is preferably selected from a compound of formula (II-A) 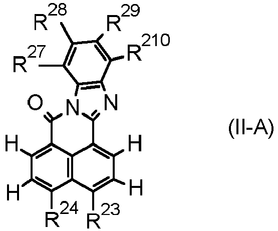 and mixtures thereof,
in which
R²³ and R²⁴ are each independently cyano, phenyl, 4-cyanophenyl or phenyl which carries 1, 2 or 3 substituents selected from C₁-C₁₀-alkyl, especially cyano, phenyl or 4-cyanophenyl; and
R²⁷, R²⁸, R²⁹ and R²¹⁰ are each independently hydrogen, cyano, phenyl, 4-cyanophenyl or phenyl which carries 1, 2 or 3 substituents selected from C₁-C₁₀-alkyl, especially hydrogen, cyano, phenyl or 4-cyanophenyl.

More preferred are the compounds specified in WO 2015/019270 on page 16, 2^{nd} paragraph to page 20, 3^{rd} paragraph. With regard to the use in the color converter of the present invention, especially preferred are compounds of formula (II) selected from compounds of formulae (II-1), (II-2), (II-3), (II-4), (II-5), (II-6), (II-7), (II-8), (II-9), (II-10), (II-11), (II-12), (II-13), (II-14), (II-15), (II-16), (II-17), (II-18), (II-19), (II-20), (II-21), (II-22), (II-23), (II-24), (II-25), (II-26), (II-27), (II-28), (II-29), (II-30), (II-31), (II-32), (II-33), (II-34), (II-35), (II-36), (II-37), (II-38), (II-39), (II-40), (II-41), (II-42), (II-43), (II-44), (II-45), (II-46), (II-47), (II-48), (II-49), and (II-50) and mixtures thereof

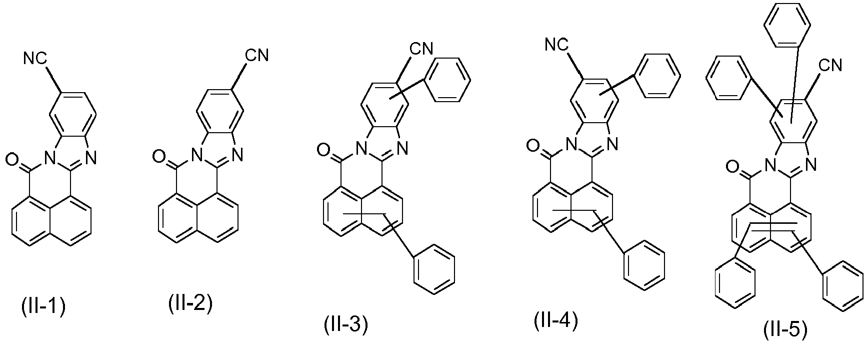

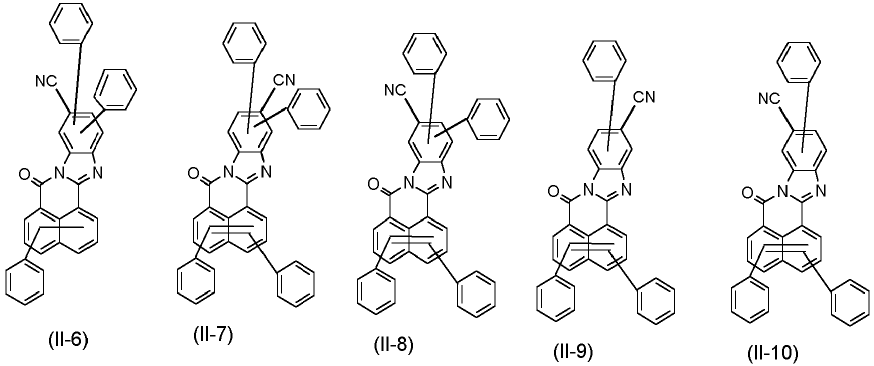

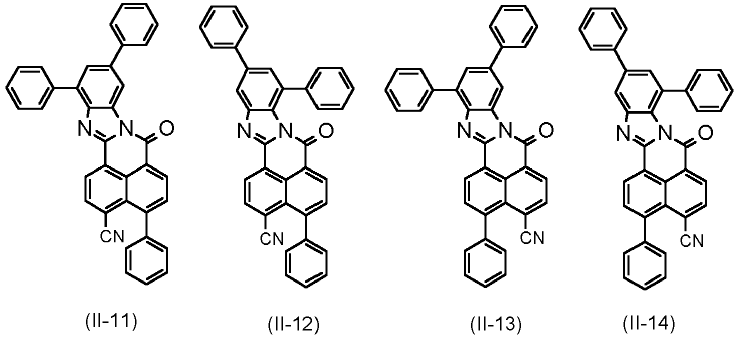

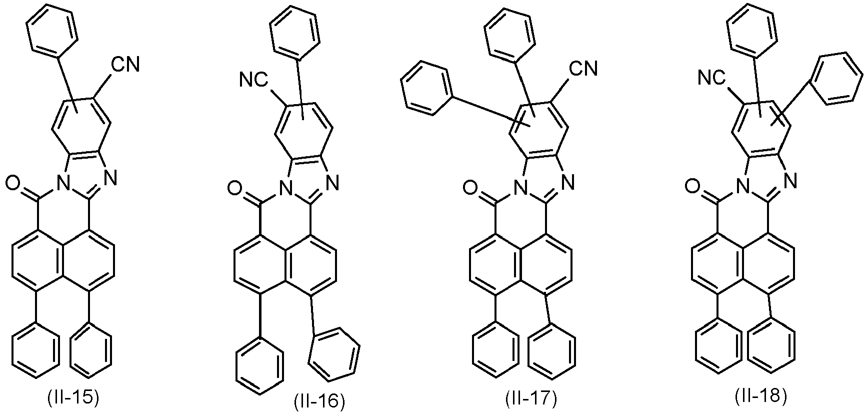

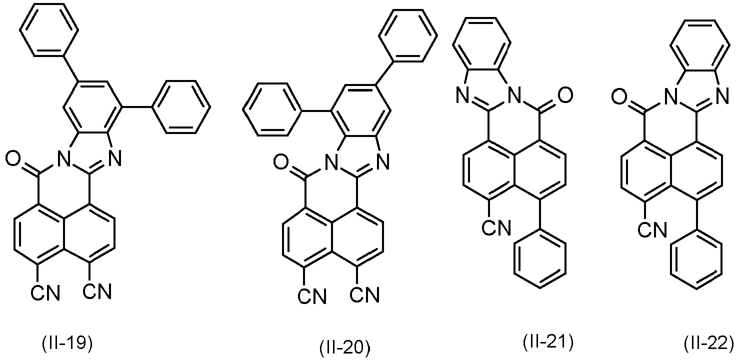

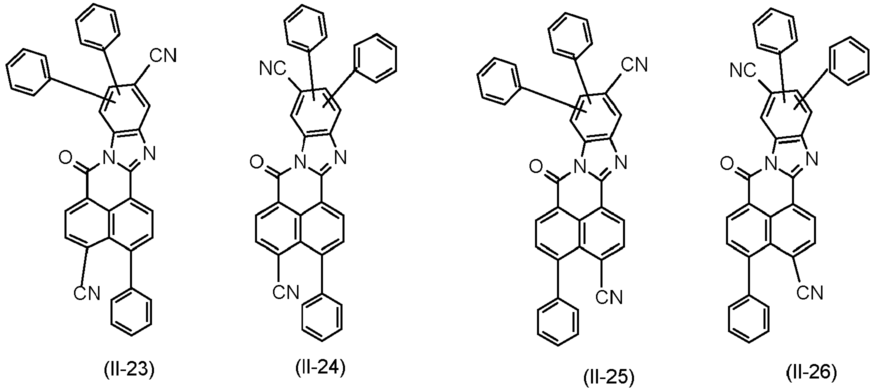

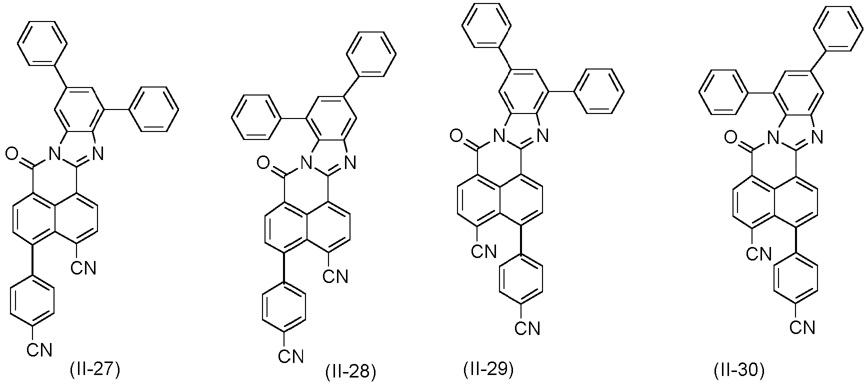

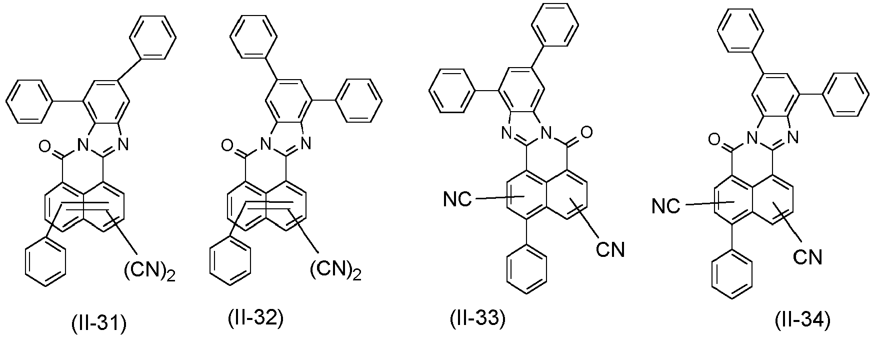

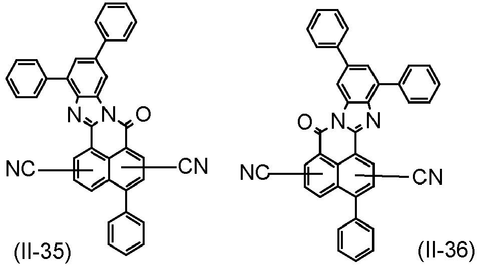

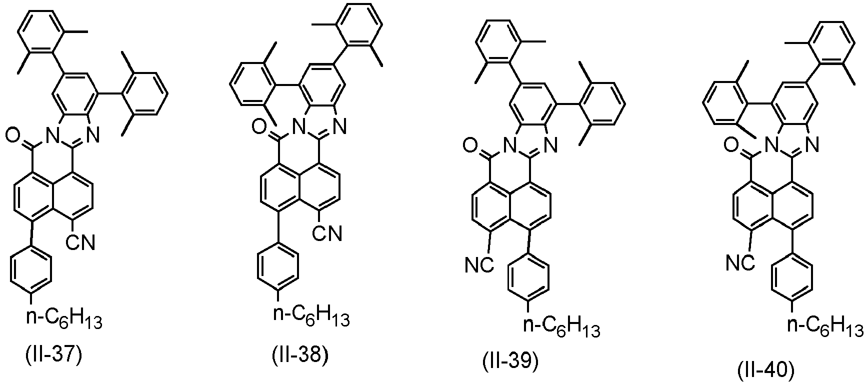

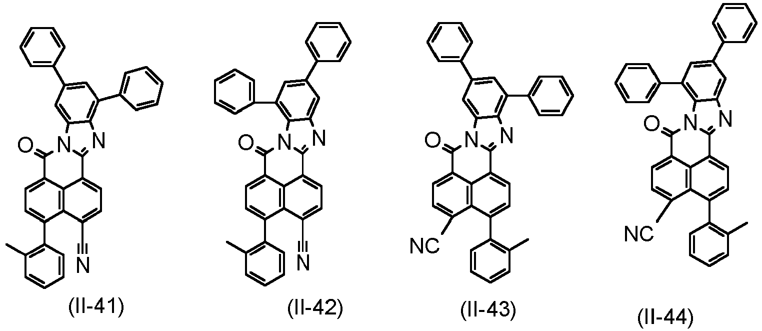

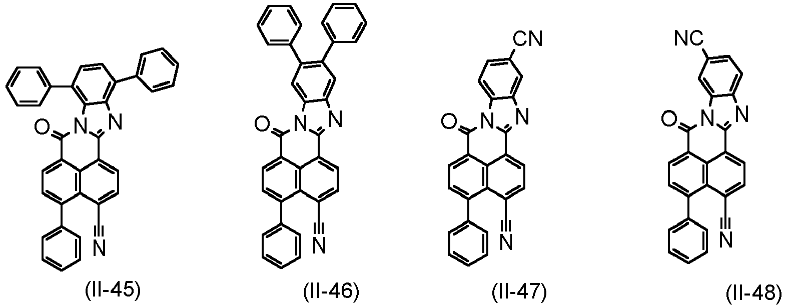

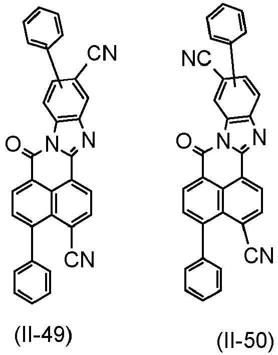

More especially preferred are compounds (II-3), (II-4), (II-6), (II-7), (II-8), (II-9), (II-10), (II-11), (II-12), (II-13), (II-14), (II-15), (II-16), (II-17), (II-18), (II-19), (II-20), (II-21), (II-22), (II-27), (II-28), (II-29), (II-30) and mixtures thereof.

### Organic fluorescent colorant (B3)

Compounds of formula (III) are known from WO 2015/169935. Compounds of formula (III) are usually yellow or yellow-green fluorescent dyes. With regard to the use in the color converter of the present invention, the compound of formula (III)-encompass the following compounds of formulae (III-a) and (III-b) as well as compounds of formulae (III-c) and (IIII-d): 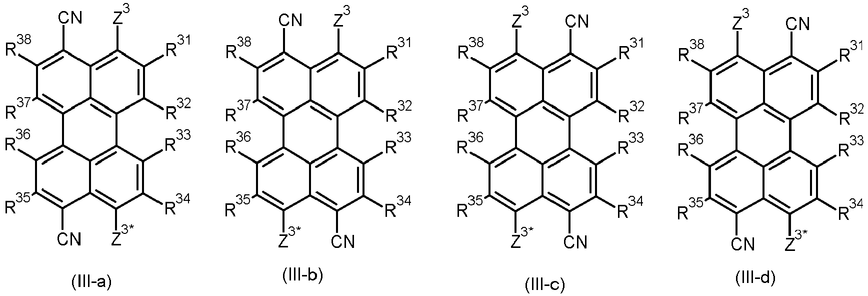 individually and mixtures thereof,
in which R³¹, R³², R³³, R³⁴, R³⁵, R³⁶, R³⁷, R³⁸, Z³ and Z^{3*} are each as defined above.

In particular, preferrence is given to the compounds specified in WO 2015/169935 on page 12, line 9 to page 13, line 31. With regard to the use in the color converter of the present invention, preferred are compounds of formula (III) selected from compounds of formulae (III-1), (III-2), (III-3), (III-4), (III-5), (III-6), (III-7), (III-8), (III-9), (III-10), (III-11), (III-12), (III-13), (III-14), (III-15), (III-16), (III-17), (III-18), (III-19), (III-20) 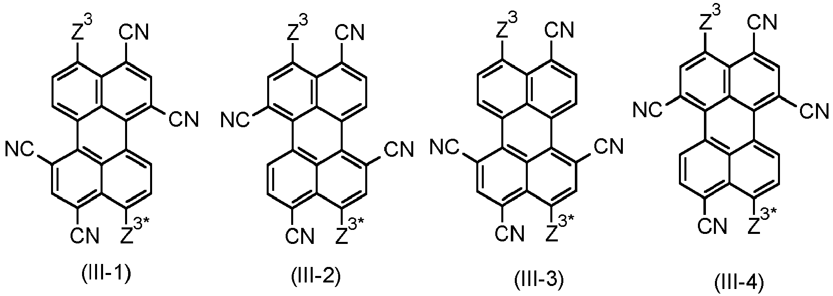 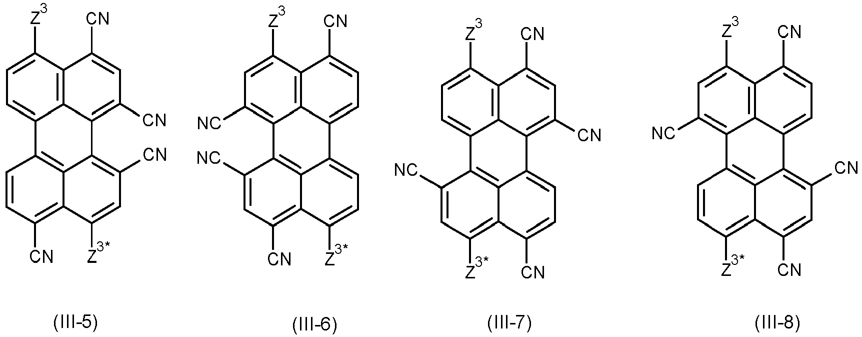 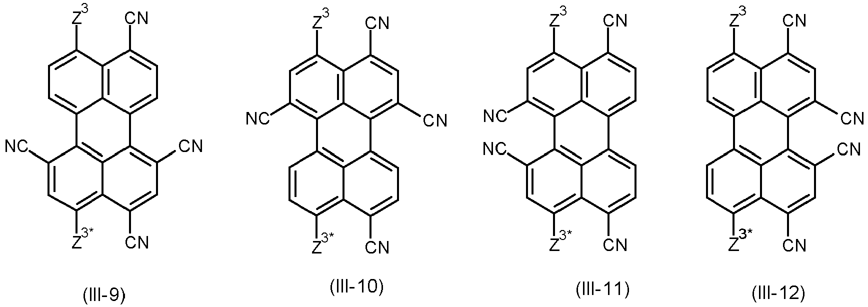 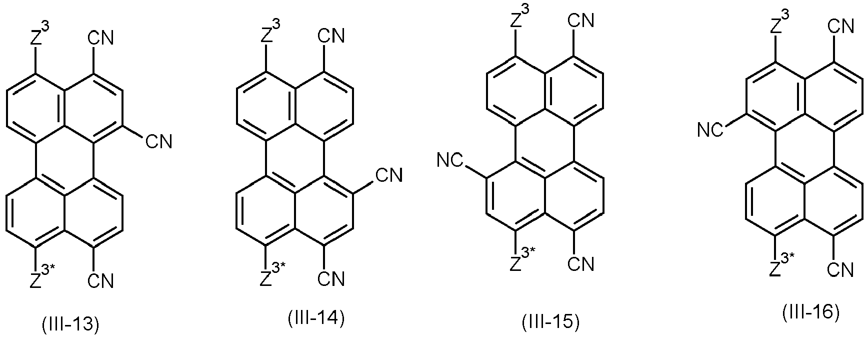 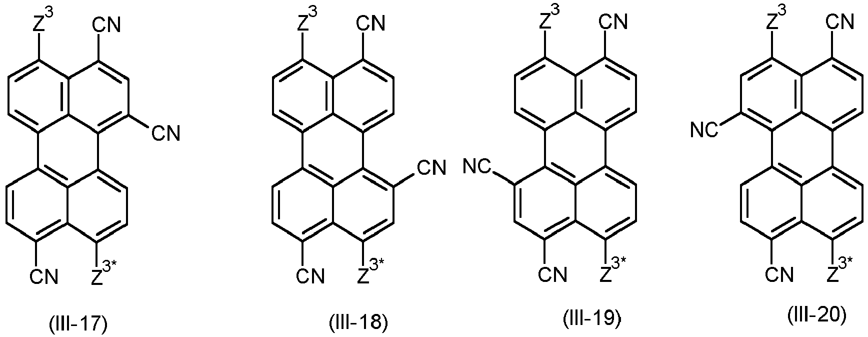 and mixtures thereof,
in which
- Z³: is selected from C₁-C₆-alkyl, C₁-C₆-alkoxycarbonyl, phenyl, and phenyl bearing 1, 2 or 3 C₁-C₄-alkyl groups; and
- Z^{3*}: is selected from C₁-C₆-alkyl, C₁-C₆-alkoxycarbonyl, phenyl, and phenyl bearing 1, 2 or 3 C₁-C₄-alkyl groups.

Among these, specific preference is given to perylene compounds of formulae (111-1), (III-2), (III-3), (III-4), (III-5), (III-6), (III-7), (III-8), (III-9), (III-10), (III-11), (III-12), (III-13), (III-14), (III-15), (III-16), (III-17), (III-18), (III-19), (III-20) in which Z and Z* have the same definition. More especially preferred are compounds of formulae (III-2) and (III-20), wherein Z³ is C₁-C₆-alkoxycarbonyl, phenyl or phenyl bearing 1, 2 or 3 C₁-C₄-alkyl groups and Z^{3*} has the same meaning as Z³.

### Organic fluorescent colorant (B4)

Cyanated compounds of formula (IV) are subject-matter of WO 2016/151068. Compounds of formula (III) are usually yellow or yellow-green fluorescent dyes. With regard to the use in the color converter of the present invention, the compound of formula (IV) is preferably a compound, wherein X⁴⁰ is O. Also preferred are compounds of formula (IV), wherein X⁴⁰ is S. Preferrence is given to the compounds specified in WO 2016/151068 on page 24, line 10 to page 34, line 4.

Among these, compounds of formula (IV) are especially preferred, wherein A is a radical of formula (A.2). Compounds of formula (IV), where A is a radical of formula (A.2) are also referred to as compounds of formula (IV-A.2), 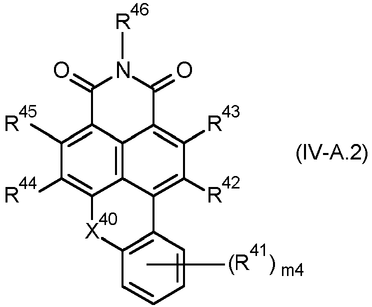 wherein
m4, X⁴⁰, R⁴¹, R⁴², R⁴³, R⁴⁴, R⁴⁵ and R⁴⁶ are as defined above.

In the compounds of formula (IV-A.2), R⁴⁶ is preferably selected from hydrogen, linear C₁-C₂₄-alkyl, branched C₃-C₂₄-alkyl, C₆-C₁₀-aryl and C₆-C₁₀-aryl-C₁-C₁₀-alkylene, where the aryl ring in the two last mentioned moieties is unsubstituted or substituted with 1, 2, 3, 4 or 5 identical or different radicals R^{46a}. Especially, R⁴⁶ is selected from linear C₁-C₂₄-alkyl, a radical of formula (B.1) and a radical of formula (B.2) 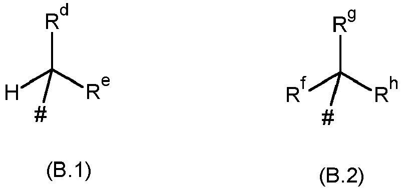 in which
# is the bonding site to the nitrogen atom;
R^{d} and R^{e}, in the formula (B.1), independently from each other are selected from C₁-C₂₃-alkyl, where the sum of the carbon atoms of the R^{d} and R^{e} radicals is an integer from 2 to 23;
R^{f}, R^{g} and R^{h}, in the formula (B.2) are independently selected from C₁- to C₂₀-alkyl, where the sum of the carbon atoms of the R^{f}, R^{g} and R^{h} radicals is an integer from 3 to 23.

Preferred radicals of formula (B.1) are: 1-methylethyl, 1-methylpropyl, 1-methylbutyl, 1-methylpentyl, 1-methylhexyl, 1-methylheptyl, 1-methyloctyl, 1-ethylpropyl, 1-ethylbutyl, 1-ethylpentyl, 1-ethylhexyl, 1-ethylheptyl, 1-ethyloctyl, 1-propylbutyl, 1-propylpentyl, 1-propylhexyl, 1-propylheptyl, 1-propyloctyl, 1-butylpentyl, 1-butylhexyl, 1-butylheptyl, 1-butyloctyl, 1-pentylhexyl, 1-pentylheptyl, 1-pentyloctyl, 1-hexylheptyl, 1-hexyloctyl, 1-heptyloctyl.

A particularly preferred radical of formula (B.2) is tert.-butyl.

Likewise especially, R⁴⁶ is a radical of formula (C.1), a radical of formula (C.2) or a radical of formula (C.3) 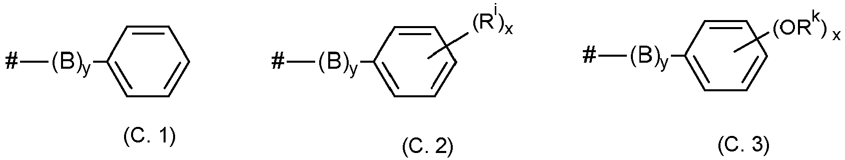 where
- #: represents the bonding side to the nitrogen atom,
- B: where present, is a C₁-C₁₀-alkylene group which may be interrupted by one or more nonadjacent groups selected from -O- and -S-,
- y: is 0 or 1,
- Rⁱ: is independently of one another selected from C₁-C₂₄-alkyl, C₁-C₂₄-fluoroalkyl, fluorine, chlorine or bromine,
- R^{k}: is independently of one another selected from C₁-C₂₄-alkyl,
- x: in formulae C.2 and C.3 is 1, 2, 3, 4 or 5.

Preferably, y is 0, i.e. the variable B is absent.

Irrespectively of its occurrence, Rⁱ is preferably selected from C₁-C₂₄-alkyl, more preferably linear C₁-C₁₀-alkylor branched C₃-C₁₀-alkyl, especially isopropyl. Irrespectively of its occurrence, R^{k} is preferably selected from C₁-C₃₀-alkyl, more preferably linear C₁-C₁₀-alkylor branched C₃-C₁₀-alkyl. The variable x in formulae C.2 and C.3 is preferably 1, 2 or 3.

A special group of embodiments relates to compounds of formula (IV-A.2), wherein the variables m4, X⁴⁰, R⁴¹, R⁴², R⁴³, R⁴⁴, and R⁴⁵ independently of each other or in particular in combination, have the following meanings:
- X⁴⁰: is O or S;
- R⁴² and R⁴⁴: are each cyano;
- R⁴³ and R⁴⁵: are each hydrogen or one of R⁴³ and R⁴⁵ is bromine and the other of R⁴³ and R⁴⁵ is hydrogen;
- R⁴¹: is selected from cyano, bromine, and phenyl which is unsubstituted or carries 1 or 2 radicals selected from C₁-C₄-alkyl;
- R⁴⁶: is selected from hydrogen, C₁-C₂₄-linear alkyl, branched C₃-C₂₄-alkyl, a radical of formula (C.1), a radical of formula (C.2) and a radical of formula (C.3);
- m4: is 0 or 1.

Even more preferably,
- X⁴⁰: is O or S;
- R⁴² and R⁴⁴: are each cyano;
- R⁴³ and R⁴⁵: are each hydrogen;
- R⁴¹: is selected from cyano, bromine, and phenyl which is unsubstituted or carries 1 or 2 radicals selected from C₁-C₄-alkyl; especially cyano;
- R⁴⁶: is selected from linear C₁-C₂₄-alkyl, branched C₃-C₂₄-alkyl, a radical of formula (C.1), a radical of formula (C.2) and a radical of formula (C.3); especially linear C₁-C₂₄-alkyl, branched C₃-C₂₄-alkyl, or phenyl which carries 1 or 2 radicals selected from C₁-C₄-alkyl such as 2,6-diisopropylphenyl;
- m4: is 0 or 1.

Examples for preferred compounds of formula (IV-A.2) are shown below:

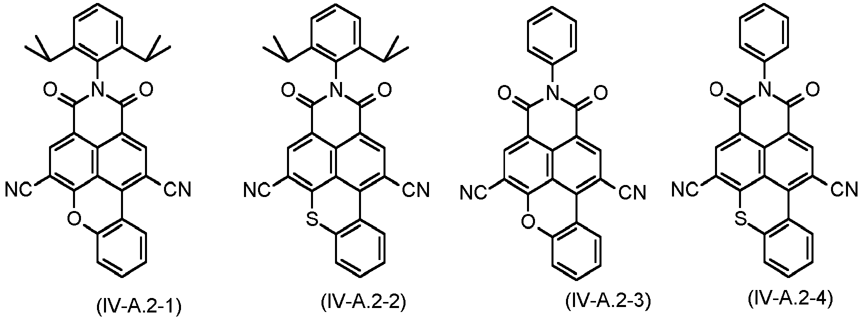

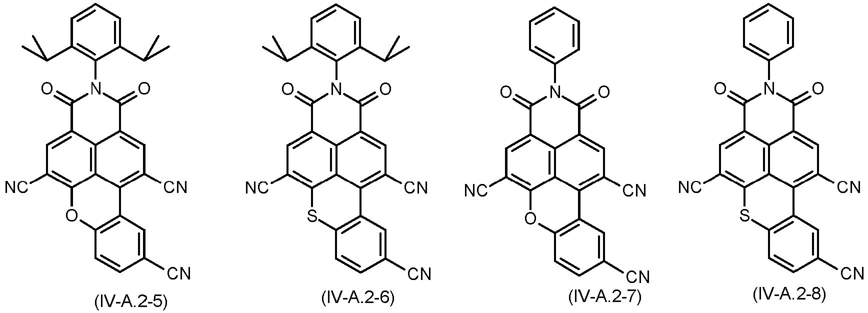

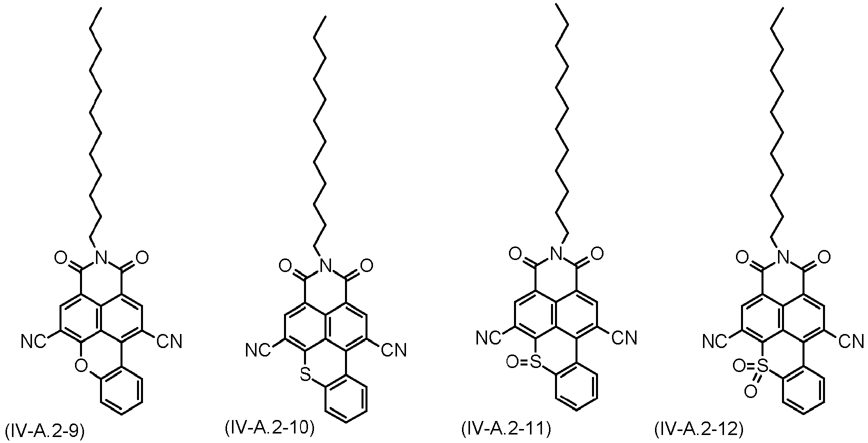

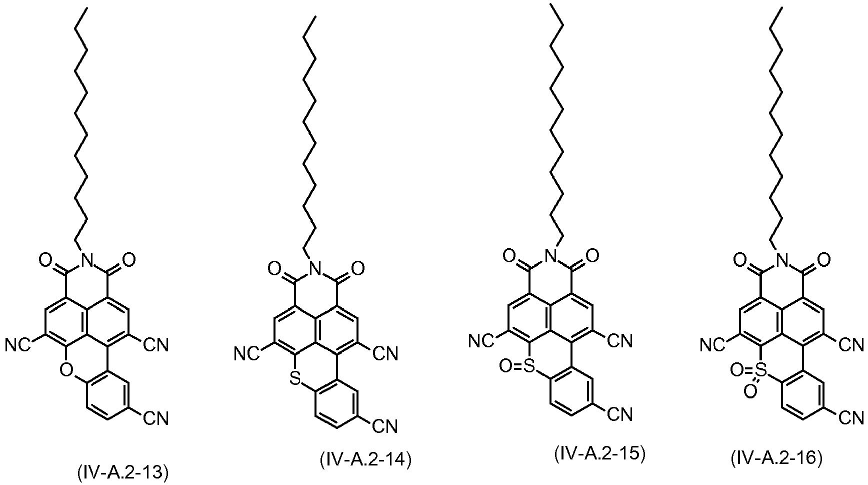

### Fluorescent compound (B5)

Benzoxanthene compounds of formula (V) are known from WO 2014/131628. They are usually yellow fluorescent. Suitable compounds are depicted in in Fig. 2A, FIG.2B and FIG. 2C of WO 2014/131628. They are usually yellow or yellow-green fluorescent dyes. Benzothioxanthene compounds of formula (V) are known for example from US 3,357,985. Preferred are benzothioxanthene compounds of formula (V), wherein X⁵ is S, R⁵¹ is C₁₀-C₂₀-alkyl and R⁵² - R⁵⁹ are hydrogen. A suitable example is benzothioxanthene-3,4-dicarboxylic acid-N-stearylimide, also referred to as Solvent Yellow 98 (CAS Registry Number: 12671-74-8).

### Fluorescent compound (B6)

Benzimidazoxanthenisoquinoline compounds of formula (VIA) and (VIB) are known from WO 2015/062916. Suitable compounds are depicted at page 3, line 24 to page 8, line 24, especially FIG.3A, FIG.3B, FIG.3C of WO 2015/062916.

### Organic fluorescent colorant (B7)

Compounds having a structural unit of formula (VII) are known from WO 2012/168395. In general, they are yellow fluorescent dyes. With regard to the use in the color converter of the present invention, the compound having a structural unit of formula (VII) is preferably a compound as specified in WO 2012/168395, at page 28, line14 to page 32, line 5.

With regard to the use in the color converter of the present invention, the compound having a structural unit of formula (VII) is more preferably selected from compounds of formulae (VII-1), (VII-2), (VII-3), (VII-4), (VII-5), (VII-6), (VII-7), (VII-8), (VII-9), (VII-10), (VII-11), (VII-12), (VII-13), (VII-14), (VII-15), (VII-16), (VII-17), (VII-18), (VII-19), (VII-20), (VII-21), (VII-22), (VII-23), (VII-24), (VII-25), (VII-26), (VII-27), (VII-28), (VII-29), (VII-30), (VII-31), (VII-32), (VII-33), (VII-34), (VII-35), (VII-36), (VII-37), (VII-38), (VII-39), (VII-40), (VII-41), (VII-42), (VII-43), (VII-44), (VII-45), (VII-46), (VII-47), (VII-48), (VII-49), (VII-50), (VII-51), (VII-52), (VII-53), (VII-54), (VII-55), and mixtures thereof 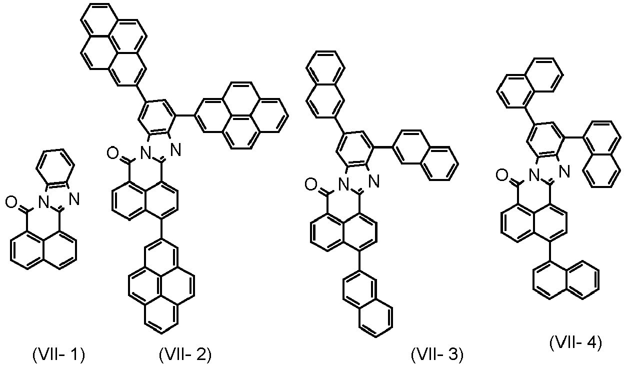 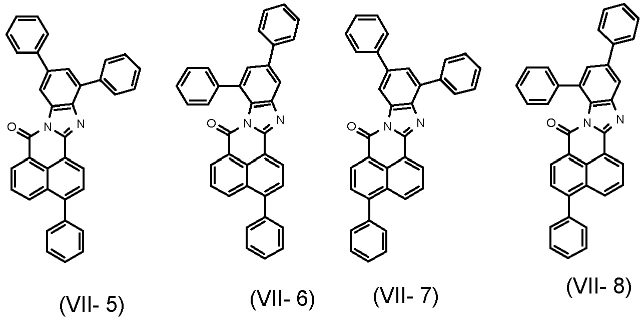 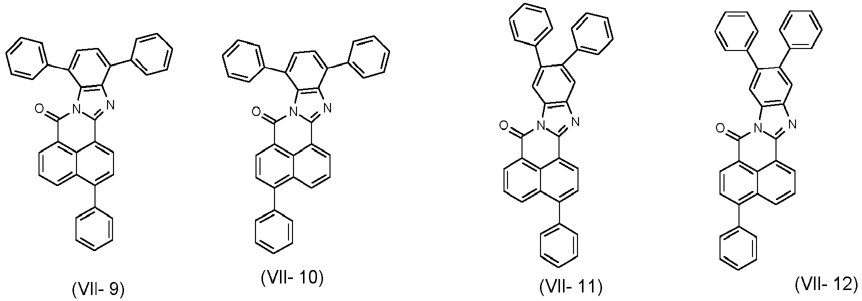 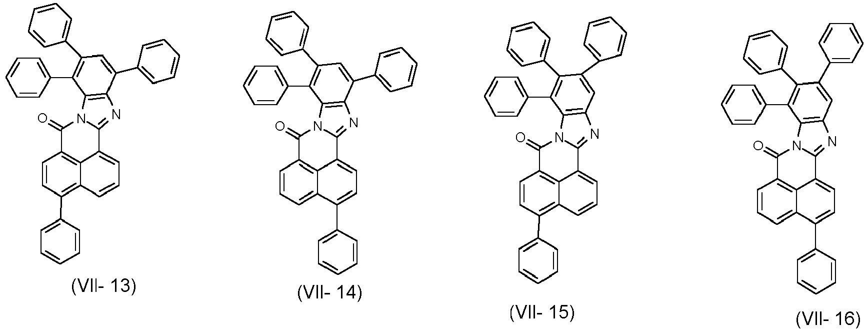 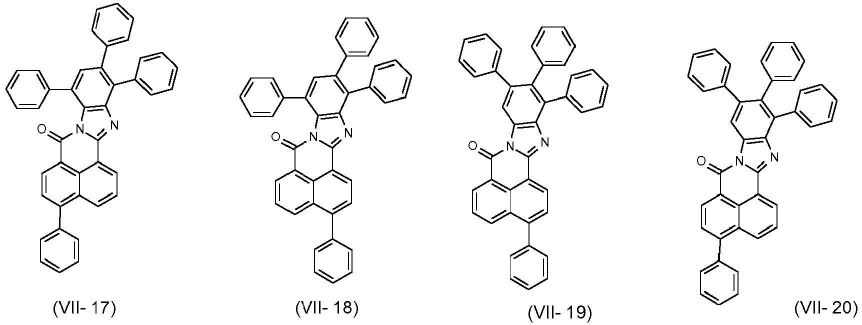 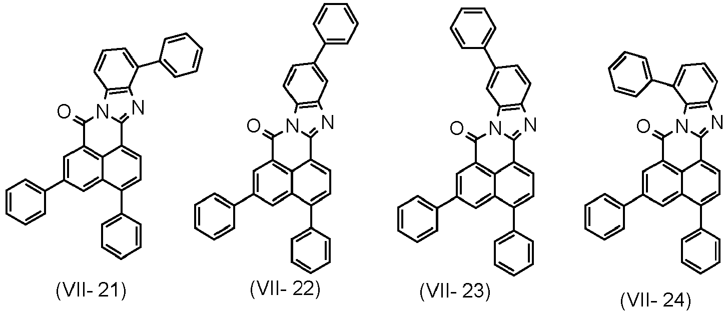 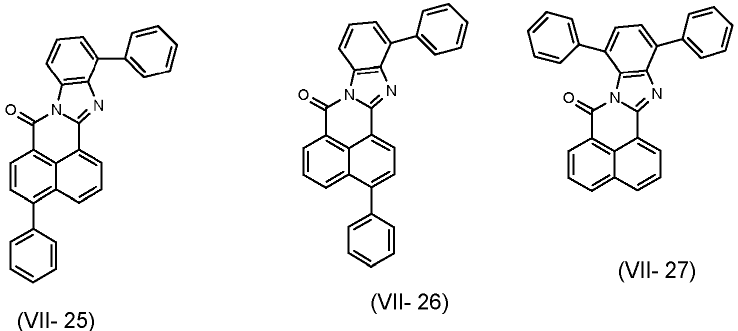 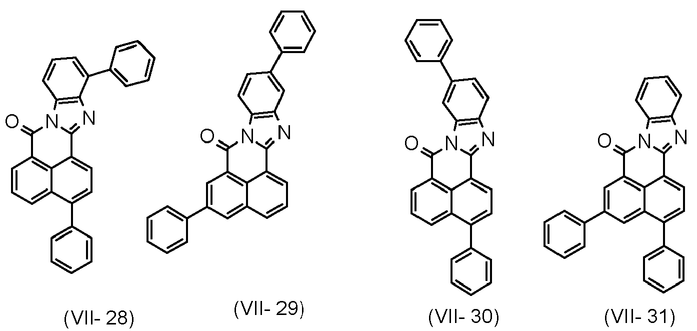 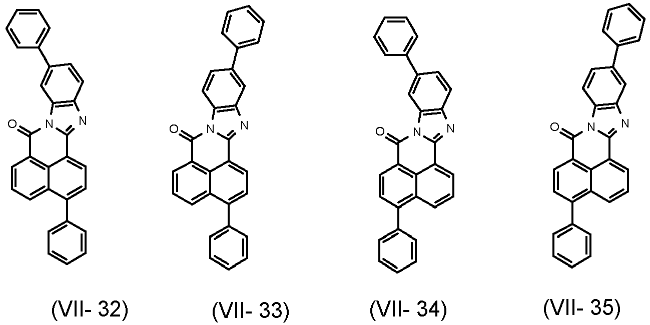 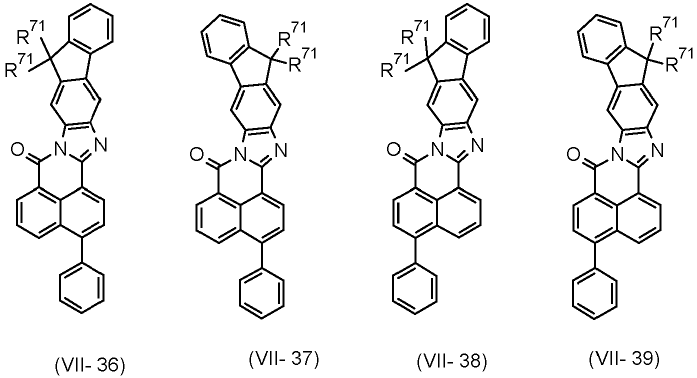 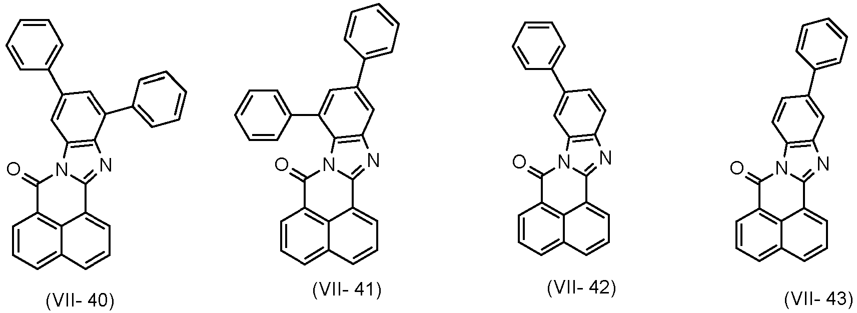 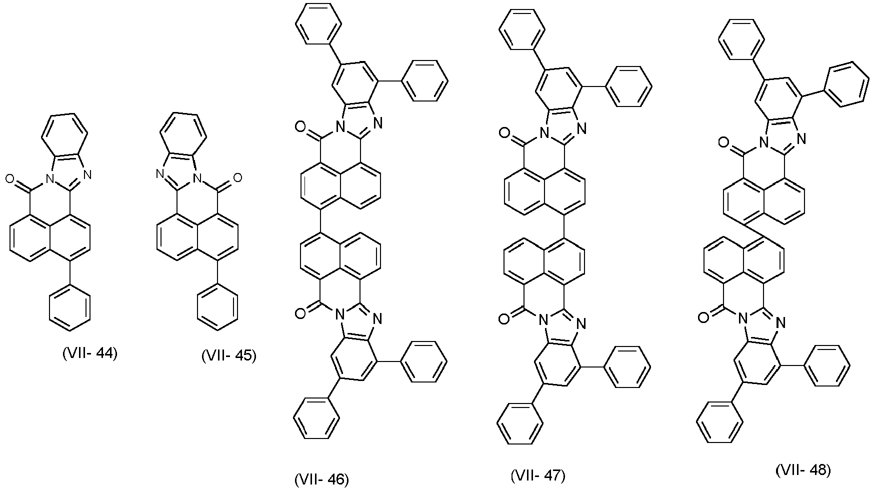 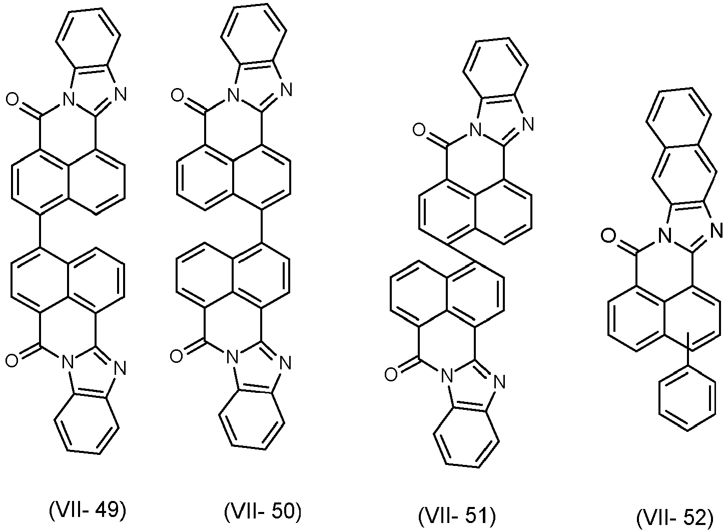 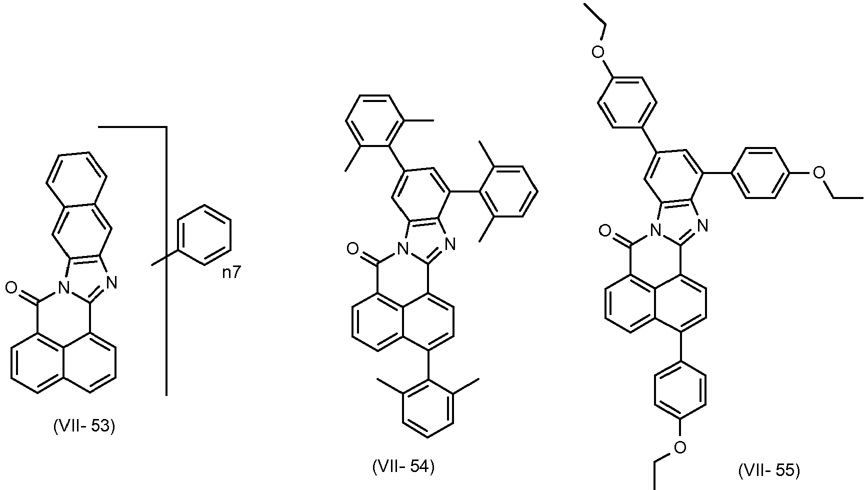 and mixtures thereof,
where n7 is a number from 0, 1, 2, 3, 4, 5, 6, 7, 8, 9 or 10;
R⁷¹ is independently hydrogen, C₁-C₁₈-alkyl or cycloalkyl, the carbon chain of which may comprise one or more -O-, -S-, -CO-, -SO- and/or -SO₂- moieties and which may be mono- or polysubstituted;
   aryl or heteroaryl which may be mono- or polysubstituted.

Especially preferred are the compounds of formulae (VII-5), (VII-6), (VII-7) and (VII-8) and mixtures thereof. Especially preferred are also the compounds of (VII-17), (VII-18), (VII-19), (VII-20) and mixtures thereof.

### Organic fluorescent colorant (B8)

Perylene imide compounds of formula (VIII) and (IX) are well known in the art, e.g. from WO 2007/006717 or US 6,472,050. 9-Cyano substituted perylene-3,4-dicarboxylic acid monoimides of formula (IX) are also known from WO2004029028. They are usually orange fluorescent dyes. Preferably, in compound of formula (VIII), R⁸¹ and R⁸² are a linear or branched C₁-C₁₈ alkyl radical, a C₄-C₈ cycloalkyl radical which may be mono- or polysubstituted by halogen or by linear or branched C₁-C₁₈ alkyl, or phenyl or naphthyl which may be mono- or polysubstituted by halogen or by linear or branched C₁ - C₁₈ alkyl.

In one embodiment, R⁸¹ and R⁸² in formula VIII represents compounds with what is called swallowtail substitution, as specified in WO 2009/037283 A1 at page 16 line 19 to page 25 line 8. In a preferred embodiment, R⁸¹ and R⁸², independently of each other, are a 1-alkylalkyl, for example 1-ethylpropyl, 1-propylbutyl, 1-butylpentyl, 1-pentylhexyl or 1-hexylheptyl. More preferably, R⁸¹ and R⁸², independently of each other, are 2,4-di(tert-butyl)phenyl or 2,6-disubstituted phenyl, especially preferably 2,6-diphenylphenyl, 2,6-diisopropylphenyl. More preferably, R⁸¹ and R⁸² have the same meaning. A preferred compound of formula (VIII) is N,N'-bis(2,6-diisopropylphenyl)-3,4,9,10-perylenetetracarboxylic diimide (CAS-number: 82953-57-9).

Suitable 9-cyano substituted perylene-3,4-dicarboxylic acid monoimides of formula (IX) are preferably those, wherein R⁹² is a linear or branched C₁-C₁₈ alkyl radical, a C₄-C₈ cycloalkyl radical which may be mono- or polysubstituted by halogen or by linear or branched C₁-C₁₈ alkyl, or phenyl or naphthyl which may be mono- or polysubstituted by halogen or by linear or branched C₁ - C₁₈ alkyl. In one embodiment, R⁹² in formula IX represents compounds with what is called swallowtail substitution, as specified in WO 2009/037283 A1 at page 16 line 19 to page 25 line 8. In a preferred embodiment, R⁹², is a 1-alkylalkyl, for example 1-ethylpropyl, 1-propylbutyl, 1-butylpentyl, 1-pentylhexyl or 1-hexylheptyl. More preferably, R⁹², is 2,4-di(tert-butyl)phenyl or 2,6-disubstituted phenyl, especially preferably 2,6-diphenylphenyl, 2,6-diisopropylphenyl, in particular 2,6-d iisopropylphenyl.

### Organic fluorescent colorant (B9)

4-Amino-substituted naphthalimide compounds of formula (X) are known in the art. Suitable 4-amino substituted naphthalimide compounds of formula (X) are preferably those, wherein R¹⁰¹ is linear or branched C₁-C₁₀-alkyl, C₂-C₁₀-alkyl which is interrupted by one or more oxygen, or C₃-C₈-cycloalkyl. R¹⁰² is preferably hydrogen. A suitable compound of formula (X) is 4-(butylamino)-N-butyl-1,8-naphthalimide (CAS Number: 19125-99-6). Likewise preferably, R¹⁰² is linear or branched C₁-C₁₀-alkyl. The compounds of formula (X) can be synthesized in two steps. The first step may be the condensation of 4-chloro-1,8-naphthalic anhydride with amines in a solvent such as 1,4-dioxane or 2-methoxyethanol under reflux yielding the corresponding 4-chloro-1,8-naphthalimides. The second step involves the substitution of the chlorine atom with aliphatic primary or secondary amines.

### Organic fluorescent colorant (B10)

7-(Diethylamino)-3-(5-methylbenzo[d]oxazol-2-yl)-2H-chromen-2-one is also known as Disperse Yellow (CAS Registry no. 34564-13-1).

### Organic fluorescent colorant (B11)

Compounds of formulae (XIA) and (XIB) are known from US 5,470,502. They are usually yellow fluorescent dyes. Preferred are compounds of formulae (XIA) and (XIB), wherein R¹¹¹ is linear C₁-C₁₀-alkylor branched C₃-C₁₀-alkyl. Preferred examples are diisobutyl-3,9-perylenedicarboxylate and diisobutyl-3,10-perylenedicarboxylate, especially diisobutyl-3,9-perylenedicarboxylate.

### Organic fluorescent colorant (B12)

Compounds of formulae (XIIA) and (XIIB) are known from US 5,470,502. They are usually yellow fluorescent dyes. Preferred are compounds of formulae (XIIA) and (XIIB), wherein R¹²¹ is linear C₁-C₁₀-alkylor branched C₃-C₁₀-alkyl. Preferred examples are diisobutyl 4,10-dicyanoperylene-3,9-dicarboxylate and diisobutyl 4,9-dicyano-perylene-3,10-dicarboxylate, especially especially diisobutyl 4,10-dicyanoperylene-3,9-dicarboxylate.

### Organic fluorescent colorant (B13)

Suitable examples of compounds of formula (XIII) are for example the perylene derivatives specified in WO 2007/006717, especially at page 1, line 5 to page 22, line 6; in US 4,845,223, especially col. 2, line 54 to col. 6, line 54; in WO 2014, especially at page 3, line 20 to page 9, line 11; in EP3072887; and in EP16192617.5, especially at page 35, line 34 to page 37, line 29. The compounds of formula (XIII) are usually orange or red fluorescent colorants. Preferred are compounds of formula (XIII), wherein R¹³¹ and R¹³² are each independently selected from C₁-C₁₀-alkyl, 2,6-di(C₁-C₁₀-alkyl)aryl and 2,4-di(C₁-C₁₀-alkyl)aryl. More preferably, R¹³¹¹ and R¹³² are identical. Very particularly, R¹³¹ and R¹³² are each 2,6-diisopropylphenyl or 2,4-di-*tert-*butylphenyl. R¹³³ is preferably phenoxy, which is unsubstituted or substituted by 1 or 2 identical or different substituents selected from fluorine, chlorine, C₁-C₁₀-alkyl and phenyl. Preferably, p₁₃ is 2, 3 or 4, in particular 2 or 4.

The compounds of formula (XIII) can be prepared in analogy to the methods described for example in WO 2007/006717, US 4,845,223, EP3072887 and WO 2014/122549. Suitable organic fluorescent colorants B13 are, for example, N,N'-bis(2,6-diisopropylphenyl)-1,6,7,12-tetraphenoxyperylene-3,4:9,10-tetracarboximide, N,N'-bis(2,6-diisopropylphenyl)-1,7-di(2,6-diisopropylphenoxy)perylene-3,4:9,10-tetracarboximide, N,N'-bis(2,6-diisopropylphenyl)-1,6-di(2,6-diisopropylphenoxy)perylene-3,4:9,10-tetracarboximide, N,N'-bis(2,6-diisopropylphenyl)-1,7-di(p-tert-octylphenoxy)perylene-3,4;9,10-tetracarboximide, N,N'-bis(2,6-diisopropylphenyl)-1,7-diphenoxyperylene-3,4;9,10-tetracarboximide, N,N'-bis(2,6-diisopropylphenyl)-1,7-di(2,6-diphenylphenoxy)perylene-3,4;9,10-tetracarboximide, N,N'-bis(2,6-diisopropylphenyl)-1,6-di(2,6-diphenylphenoxy)perylene-3,4;9,10-tetracarboximide, N,N'-bis(2,6-diisopropylphenyl)-1,6,7,12-tetra(2-phenylphenoxy)perylene-3,4:9,10-tetracarboximide, N,N'-bis(2,6-diisopropylphenyl)-1,7-di(2,3-difluorophenoxy)perylene-3,4:9,10-tetracarboximide, N,N'-bis(2,6-diisopropylphenyl)-1,6,7,12-tetra(2,3-difluorophenoxy)perylene-3,4:9,10-tetracarboximide, N,N'-bis(2,6-diisopropylphenyl)-1,6,7,12-tetra(3-fluorophenoxy)perylene-3,4:9,10-tetracarboximide, N,N'-bis(2,6-diisopropylphenyl)-1,6,7,12-tetra(2,6-difluorophenoxy)perylene-3,4:9,10-tetracarboximide, N,N'-bis(2,6-diisopropylphenyl)-1,6,7,12-tetra(2,5-difluorophenoxy)perylene-3,4:9,10-tetracarboximide, N,N'-bis(2,6-diisopropylphenyl)-1,6,7,12-tetra(2,3-dichlorophenoxy)perylene-3,4:9,10-tetracarboximide, N,N'-bis(2,6-diisopropylphenyl)-1,6,7,12-tetra(3-chlorophenoxy)perylene-3,4:9,10-tetracarboximide, N,N'-bis(2,6-diisopropylphenyl)-1,6,7,12-tetra(2,6-dichlorophenoxy)perylene-3,4:9, 10-tetracarboximide, N,N'-bis(2,6-diisopropylphenyl)-1,6,7,12-tetra(2,5-dichlorophenoxy)perylene-3,4:9,10-tetracarboximide.

### Organic fluorescent colorant (B14)

Compounds of formula (XIV) are subject matter of WO 2017/121833 (PCT/EP2017/050621). Compounds of formula (IV) are usually orange or red fluorescent colorants. Preference is given to compounds of formula (XIV), where R¹⁴¹ and R¹⁴² are, independently of each other, selected from phenyl which is unsubstituted or substituted by 1, 2 or 3 C₁-C₆-alkyl; and R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ and R¹⁴¹⁸ are each hydrogen. The compound of formula (XIV) as defined above is preferably

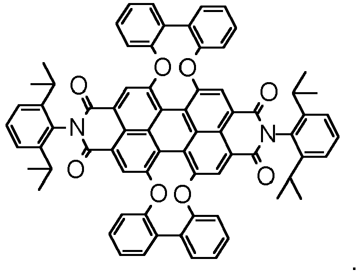

The compound of formula (XIV) can be prepared by reacting the appropriate chlorinated or brominated perylene bisimide of formula (XIVa) 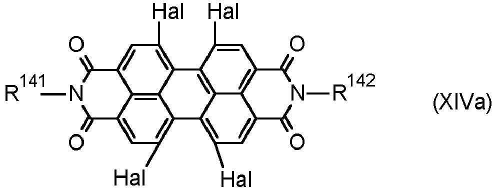 where
- Hal: is in each case bromine or in each case chlorine; and
- R¹⁴¹ and R¹⁴²: are as defined above;
with a 2,2'-biphenol compound of formula (XIVb) and, if appropriate, an 2,2'-biphenol compound of formula (XIVc) 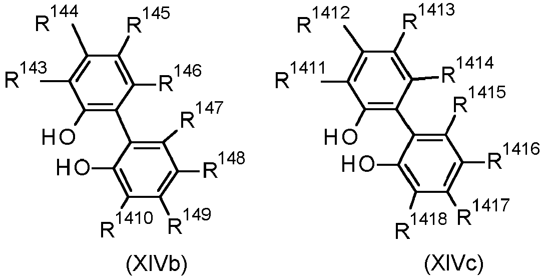 where
R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ and R¹⁴¹⁸ are as defined above.

The 2,2'-biphenol of formula (XIVc) may also be as defined for the 2,2'-biphenol of formul (XIVc) (if only one 2,2'-biphenol of formula (XIVb) is used for halogen replacement reaction).

### Organic fluorescent colorant (B15)

Suitable examples of compounds of formula (XV) are for example the compounds as specified in WO 2016/026863, especially at page 6, line 32 to page 18, line 26. Especially preferred are the compounds 2455, 2452, 2517 and 2440 of WO 2016/026863. Suitable examples of compounds of formula (XV) are also the compounds as specified in EP 3101087, especially those of paragraphs [0059] - [0078].

The color converter may comprise a plurality of organic fluorescent colorants (B) as defined above, for example from 1, 2, 3, 4, 5, 6, 7, 8, 9, 10 or more than 10. Preferably, the color converter comprises organic fluorescent colorants (B) selected from at least two, for example two, three or four, different groups of organic fluorescent colorants (B1), (B2), (B3), (B4), (B5), (B6), (B7), (B8), (B9), (B10), (B11), (B12), (B13), (B14) or (B15), each colorant generating a different color such that the mixed light, for example, generates white light having specific color temperature and/or color rendering index.

In a specific embodiment, the color converter may especially comprise at least one perylene bisimide compound of formula (XIII) as defined above, especially one mentioned as being preferred.

In a further specific embodiment, the color converter may especially comprise at least one compound comprising at least one structural unit of formula (VII) as defined above, especially one mentioned as being preferred.

In a further specific embodiment, the color converter may especially comprise at least one compound of formula (VIII). In a further specific embodiment, the color converter may especially comprise at least one compound of formula (IX). In a further specific embodiment, the color converter may especially comprise at least one compound of formula (XIA), especially one mentioned as being preferred. In a further specific embodiment, the color converter may especially comprise at least one compound of formula (XIB), especially one mentioned as being preferred. In a further specific embodiment, the color converter may especially comprise at least one compound of formula (XIIA), especially one mentioned as being preferred. In a further specific embodiment, the color converter may especially comprise at least one compound of formulae (XIIB),especially one mentioned as being preferred.

In a specific embodiment, the organic fluorescent colorants may be a combination of yellow and red emitting colorants, or a combination of yellow and orange emitting colorants, or a combination of yellow-green and red emitting colorants. It may be also beneficial to use more than two organic fluorescent colorants such as yellow, yellow-green and red emitting colorants or yellow, yellow-green and orange emitting colorants.

In a specific embodiment, the organic fluorescent colorant(s) (B) as defined above is (are) embedded in the polymeric matrix material.

The concentration of the organic fluorescent colorant(s) (B) as defined above in the polymer matrix is set as a function of the thickness of the color converter and the type of polymer. If a thin polymer layer is used, the concentration of the organic fluorescent colorant(s) is generally higher than in the case of a thick polymer layer. Typically, the amount of organic fluorescent colorant(s) (B) in the polymer also depends on the correlated color temperature CCT to be achieved. A skilled person will appreciate that by increasing the concentration of yellow fluorescent colorant(s) and red fluorescent colorant(s), the light emitted from the LED is tuned to longer wavelength to obtain white light with a required CCT.

Typically, the concentration of the red organic fluorescent colorant(s) according to the present invention is usually in the range from 0.0001 to 0.5% by weight, preferably 0.001 to 0.1 % by weight, based on the amount of polymer used. The concentration of (a) yellow or yellow-green organic fluorescent colorant(s) typically is 0.002 to 0.5% by weight, preferably 0.003 to 0.4% by weight, based on the amount of the polymer used.

It may be advantageous, for example in view of CCT or color rendering index (CRI), to use a mixture of yellow fluorescent colorant(s) and red fluorescent colorant(s).The ratio of yellow or yellow-green emitting organic fluorescent colorant(s) to red organic fluorescent colorant(s) is typically in the range from 1:1 to 25:1, preferably 2:1 to 20:1, more preferably 2:1 to 15:1, such as 10:1 or 3:1 or 4:1. A skilled person will readily appreciate that the ratio of the colorants depends on the chosen light source. For a desired CCT, the ratio of yellow dye/ red colorant is much greater, if the light is generated by a blue LED with a center wavelength of emission between 400 nm and 480 nm in comparison to the ratio of yellow colorant / red colorant if the light is generated by a white LED having a CCT between 3 000 to 20 000 K.

Optionally or alternatively, the color converter according to the invention comprises one or more inorganic luminescent materials. Preferably, the inorganic luminescent material(s) is (are) selected from garnets, silicates, sulfides, nitrides and oxynitrides and quantum dots. The inorganic luminescent material may especially configured to emit at least in the green, though other wavelengths are not excluded, like (also) in the red, yello, green, etc. Suitable examples of garnets, silicates, sulfides, nitrides and oxynitrides are compiled in table I below:

**Table I:**

| Class | Compounds | Excitation Peak nm | Emission Peak nm | Reference |
|---|---|---|---|---|
| Garnets | • YAG:Ce | 460-470 | 550 | US 5,998,925 |
| | • (Y₃Al₅O₁₂:Ce) | | | |
| | • (Y, Gd, Tb,Lu)₃Al₅O₁₂:Ce | | | |
| | • TAG:Ce (Tb₃Al₅O₁₂:Ce) | 460-470 | 575 | US 6,669,866, US 6,812,500, US 6,576,930, US6,0060,861, US 6,245,259, US 6,765,237 |
| Silicates | • Eu-doped Silicates | <460 | 510 to | US 7,311,858, |
| | - A₂Si(OD)₄:Eu with A = Sr, Ba, Ca, Mg, Zn and D = F, CI, S, N, Br | | 610 | US 7,267,787 |
| | - (SrBaCa)₂SiO₄:Eu | | | US 6,809,347, US 6,943,380 |
| | - Sr₃SiO₅ | | | |
| | - Ba₂MgSi₂O7:Eu²⁺; | | | US 6,429,583 |
| | - Ba₂SiO₄:Eu²⁺ | | | WO 02/11214 |
| | - (Ca,Ce)₃(Sc,Mg)₂Si₃O₁₂ | | | |
| Sulfides | • (Ca, Sr)S:Eu | <460 | 615-660 | |
| Nitrides | • (CaAlSiN₃:Eu²) | 455 | red | |
| | • (Sr,Ca)AlSiN₃:Eu²⁺ | | orange | WO 2005052087 |
| Oxynitrides | • SiAlON:Ce | 300-580 | 490 | |
| | • β-SiAlON:Eu | | 540 | |
| | • Ca-alpha-SiAlON:Eu (Ba₃Si₆O₁₂N₂:Eu) | | 585-595 | |
| | General formula CaₓEu_{y}(Si,Al)₁₂(O, N)₁₆ | | | |

Quantum dots (QDs) are nanocrystals of a semiconductor material having a diameter of about 20 nm or less. The quantum dot may include one of a Si-based nanocrystal, a group II-VI compound semiconductor nanocrystal, a group III-V compound semiconductor nanocrystal, a group IV-VI compound nanocrystal and a mixture thereof. The group II-VI compound semiconductor nanocrystal may include one selected from a group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, CdZnSeS, CdZnSeTe, CdZnSTe, CdHgSeS, CdHgSeTe, CdHgSTe, HgZnSeS, HgZnSeTe and HgZnSTe. The group III-V compound semiconductor nanocrystal may include one selected from a group consisting of GaN, GaP, GaAs, AlN, AlP, AlAs, InN, InP, InAs, GaNP, GaNAs, GaPAs, AlNP, AlNAs, AlPAS, InNP, InNAs, InPAs, GaAlNP, GaAlNAs, GaAlPAs, GalnNP, GalnNAs, GalnPAs, InAlNP, InAlNAs, and InAlPAs. The IV-VI compound semiconductor nano crystal may be SnTe.

To synthesize a nanocrystal in form of a QD, QDs may be prepared by vapor deposition such as metal organic chemical vapor deposition or molecular beam epitaxy, or by a wet chemical process in which a crystal is grown by adding one or more precursors into an organic solvent. In a specific embodiment, the at least one fluorescent colorant (B) is at least one quantum dot. In this case, the quantum dot is preferably embedded in the polymeric matrix mterial.

Hence, in a specific embodiment, the color converter comprises one or more inorganic luminescent materials as defined above and one or more organic fluorescent colorants (B) selected from the groups of colorants (B1), (B2), (B3), (B4), (B5), (B6), (B7), (B8), (B9), (B10), (B11), (B12), (B13), (B14) and (B15. In a further specific embodiment, the color converter does not comprise an inorganic luminescent material.

### Color converter

The color converter may comprise further constituents, additives such as flame retardants, antioxidants, light stabilizers, UV absorbers, free-radical scavengers, antistats. Stabilizers of this kind are known to those skilled in the art.

Suitable antioxidants or free-radical scavengers are, for example, phenols, especially sterically hindered phenols such as butylhydroxyanisole (BHA) or butylhydroxytoluene (BHT), or sterically hindered amines (HALS). Stabilizers of this kind are sold, for example, by BASF under the Irganox® trade name. In some cases, antioxidants and free-radical scavengers can be supplemented by secondary stabilizers such as phosphites or phosphonites, as sold, for example, by BASF under the Irgafos® trade name.

Suitable UV absorbers are, for example, benzotriazoles such as 2-(2-hydroxyphenyl)-2H-benzotriazole (BTZ), triazines such as (2-hydroxyphenyl)-s-triazine (HPT), hydroxybenzophenones (BP) or oxalanilides. UV absorbers of this kind are sold, for example, by BASF under the Uvinul® trade name.

In a preferred embodiment of the invention, the polymeric matrix material does not comprise any antioxidants or free-radical scavengers.

Preferably, the color converter additionally comprises at least one inorganic white pigment as a scattering body. In a preferred embodiment, at least one of the layers or matrices comprising an organic fluorescent colorant (B) as defined above comprises scattering bodies for light.

Suitable scattering bodies are inorganic white pigments, for example titanium dioxide, barium sulphate, lithopone, zinc oxide, zinc sulphide, calcium carbonate with a mean particle size to DIN 13320 of 0.01 to 10 µm, preferably 0.1 to 1 µm, more preferably 0.15 to 0.4 µm, especially scattering bodies based on TiO₂. Scattering bodies are included typically in an amount of 0.01 to 2.0% by weight, preferably 0.05 to 1% by weight, more preferably 0.1 to 0.5% by weight, based in each case on the polymer of the layer comprising scattering bodies.

In a preferred embodiment, the color converter has a two-layer structure with a red-fluorescing layer and a green-yellow-fluorescing layer, with the red layer facing the blue light source. In this embodiment, both layers comprise TiO₂ as a scattering body.

In a specific embodiment, the color converter consists of a plurality of polymer layers which have been laminated together to form a composite and wherein the various fluorescent colorants and/or scattering bodies may be present in different polymer layers.

If inventive color converters comprise more than one luminescent material, it is possible in one embodiment of the invention for a plurality of luminescent material to be present alongside one another in one layer.

In another embodiment, the various luminescent materials are present in various layers.

In a further embodiment, at least one polymer layer of the color converter has been mechanically reinforced with glass fibers.

Inventive color converters may be in any desired geometric arrangement. The color converters may, for example, be in the form of films, sheets or plaques. Equally, the matrix containing organic fluorescent dyes may be in droplet form or hemispherical form or in the form of lenses with convex and/or concave, flat or spherical surfaces.

"Casting" refers to the embodiment where LEDs or components comprising LEDs are cast or enveloped fully with a polymer comprising organic fluorescent colorant.

In one embodiment of the invention, the polymer layers (matrices) comprising organic fluorescent colorants are 25 to 400 micrometers (µm) thick, preferably 35 to 300 µm and particularly 50 to 200 µm. In another embodiment, the polymer layers comprising organic fluorescent colorants are 0.2 to 5 millimeters thick, preferably 0.3 to 3 mm and more preferably 0.4 to 1 mm. If the color converter consists of one layer or they have a laminate structure, the individual layers, in a preferred embodiment, are continuous and do not have any holes or interruptions.

Inventive color converters may optionally comprise further constituents such as a backing layer. Backing layers serve to impart mechanical stability to the color converter. The type of material for the backing layers is not crucial, provided that it is transparent and has the desired mechanical strength. Suitable materials for backing layers are, for example, glass or transparent rigid organic polymers such as polycarbonate, polystyrene or polymethacrylates or polymethyl methacrylates. Backing layers generally have a thickness of 0.1 mm to 10 mm, preferably 0.2 mm to 5 mm, more preferably 0.3 mm to 2 mm.

Optionally, the polymeric matrix material is coated or enclosed by a seal or coating. Suitable sealing and coating materials are known in the art and are for example described in WO 2012/152812, especially page 8, lines 6 to 34.

A further aspect of the invention relates to the use of color converters as defined above for the conversion of light generated by a LED. Especially, the invention relates to the use of color converters as defined above for the conversion of light generated by a blue LED with a center wavelength of emission between 400 to 480 nm, espcially between 420 nm and 480 nm to provide white light.

Likewise, the present invention relates to the use of a color converter as defined above for conversion of light generated by a cool white LED having a correlated color temperature between 3000 K and 20000K, especially 6000 K and 20000 K to provide white light having a lower correlated color temperature. More particularly, they are suitable for conversion of light generated by white LEDs with a CCT between 20 000 K to 6 000 K, such as 20 000 K to 8 000 K, 15 000 K to 8 100 K or 12 000 K to 8200 K to generate light having a lower CCT. In other words, the inventive color converters are capable to shift the wavelength of the white light source towards longer wavelength direction (i.e. redshift) to generate white light with a warm light tone.

Cool white LEDs with a CCT beween 3000 K and 20000K, especially 6000 K to 20000 K are commercially available. Blue LEDs with a center wavelength of emission between 400 to 480 nm or between 420 nm and 480 nm are also commercially available.

They are additionally suitable for applications as a light-collecting system (fluorescence collector) in photovoltaics and in fluorescence conversion solar cells.

The luminescent material(s) and optionally further constituents as described above may be incorporated in the polymeric matrix according to standard processes in the art, for example by mixing the at least luminecent material and, if present, further constituents to the polymer material by means of an extrusion process. The resulting molten polymer film may be passed through a minimum air space and may be cast upon a moving quenching member such as a cooled drum or roll or belt, etc., where the film is cooled sulficiently to solidify it. In an alternative method, the luminescent material(s) and further constituents are fed into a the melt of the polymer by using a side feeder and the resulting polymeric material is extruded in the form of a thin film. The color converter film may also be produced by combining the luminescent material(s) and optionally other ingredients and one or more precursors of the matrix, followed by the synthesis of the matrix. For instance, this may be done by using monomeric precursors of the polymer and polymerizing the monomeric precursors in the presence of the luminescent material(s) and optionally other ingredients, to provide the polymeric matrix.

Compared to color converters according to the prior art, inventive color converters exhibit a long lifetime and a high quantum yield, and emit pleasant light with good color reproduction.

In an embodiment, the light source is configured to provide blue light with a center wavelength of emission between 400 nm and 480 nm, especially between 420 nm and 480 nm, the lighting device further comprises a color converter as described above. In a further embodiment, the light source is configured to provide white light having a CCT between 3000 K and 20 000K, especially between 6000 K and 20000 K, the lighting device furthe comprises a color converter as described above. The color converter is configured to convert at least part of the light source light.

Thus, a further aspect of the invention relates to lighting devices comprising at least one white LED having a CCT between 3000 K and 20 000K, especially between 6000 K and 20000 K, and at least one color converter as defined above, wherein the color converter and the LED are in remote phosphor arrangement. Still a further aspect of the invention relates to lighting devices comprising at least one blue LED with a center wavelength of emission between 400 nm and 480 nm and at least one color converter as defined above, wherein the color converter and the LED are in remote phosphor arrangement. In one embodiment, inventive lighting devices comprise a plurality of LEDs selected from a blue LED with a center wavelength of emission between 400 nm and 480 nm and a white LED having a CCT between 3000 K and 20000 K. Inventive color converters can be used in combination with LEDs selected from blue LEDs with a center wavelength of emission between 400 nm and 480 nm and white LEDs having a CCT between 3000 K and 20000 K in virtually any geometric form and irrespective of the construction of the lighting device.

Inventive color converters comprising at least one organic fluorescent colorant (B) are usually used in a remote phosphor setup. In this case, the color converter is spatially separated from the LED. In general, the distance between LED and color converter is larger than 0.1 mm, such as 0.2 mm or more, and in some embodiments equal to or larger than 0.1 to 10 cm such as 0.3 to 5 cm or 0.5 to 3 cm. Between color converter and LED may be different media such as air, noble gases, nitrogen or other gases or mixtures thereof.

The color converter may, for example, be arranged concentrically around the LED or have a planar geometry. It may take the form, for example, of a plaque, sheet or film, be in droplet form or take the form of a casting. Inventive lighting devices are suitable for lighting in interiors, outdoors, of offices, of vehicles, in torches, games consoles, streetlights, traffic signs.

A further aspect of the present invention relates to a polymer mixture comprising at least one 2,5-furandicarboxylate polyester (A) obtainable by reacting (i) at least one diol selected from an aliphatic C₂-C₂₀-diol and a cycloaliphatic C₃-C₂₀-diol, with (ii) 2,5-furandicarboxylic acid and/or an ester forming derivative thereof and (iii) optionally at least one further dicarboxylic acid selected from 1,2-cyclohexanedicarboxylic acid, 1,4-cyclohexanedicarboxylic acid, 3,4-furandicarboxylic acid, terephthalic acid and 2,6-naphthalic acid and/or an ester forming derivative thereof and at least one luminescent material, preferably at least one organic fluorescent colorant (B) as defined above. With regard to suitable 2,5-furandicarboxylate polyester (A), the statements made above apply correspondingly. With regard to suitable fluorescent colorants (B), the statements made above apply correspondingly.

A further aspect relates to a device producing electric power upon illumination comprising a photovoltaic cell and the color converter as above, where at least a part of the light not absorbed by the photovoltaic cell is absorbed by the color converter.

## Claims

1. A color converter comprising
- a polymeric matrix material comprising at least one 2,5-furandicarboxylate polyester (A) obtainable by reacting (i) at least one diol selected from an aliphatic C₂-C₂₀-diol and a cycloaliphatic C₃-C₂₀-diol, with (ii) 2,5-furandicarboxylic acid and/or an ester forming derivative thereof and (iii) optionally at least one further dicarboxylic acid selected from 1,2-cyclohexanedicarboxylic acid, 1,4-cyclohexanedicarboxylic acid, 3,4-furandicarboxylic acid, terephthalic acid and 2,6-naphthalic acid and/or an ester forming derivative thereof; and
- at least one luminescent material.

2. The color converter according to claim 1, wherein the 2,5-furandicarboxylate polyester (A) is selected from poly(ethylene-2,5-furandicarboxylate), poly(propylene-2,5-furandicarboxylate), poly(ethylene-co-propylene-2,5-furandicarboxylate), poly(butylene-2,5-furandicarboxylate), poly(pentylene-2,5-furandicarboxylate), poly(neopentylene-2,5-furandicarboxylate) and mixtures thereof, preferably poly(ethylene-2,5-furandicarboxylate).

3. The color converter according to claim 1, wherein the 2,5-furandicarboxylate polyester (A) is poly(ethylene-2,5-furandicarboxylate-co-terephthalate), poly(ethylene-2,5-furandicarboxylate-co-2,6-naphthalate) or poly(ethylene-2,5-furandicarboxylate-co-3,4-furandicarboxylate).

4. The color converter according to any of the preceding claims, wherein the polymeric matrix material is a blend of at least two polyesters, a first polyester that is poly(ethylene-2,5-furandicarboxylate) and at least one second polyester which is selected from poly(ethylene terephthalate), poly(butylene terephthalate) poly(ethylene 2,6-naphthalate), poly(butylene 2,6-naphthalate) and poly(propylene-2,5-furandicarboxylate).

5. The color converter according to any of the preceding claims, wherein the at least one luminescent material is an organic fluorescent colorant selected from (B1), (B2), (B3), (B4), (B5), (B6), (B7), (B8), (B9), (B10), (B11), (B12), (B13), (B14), (B15) and mixtures thereof, wherein (B1), (B2), (B3), (B4), (B5), (B6), (B7), (B8), (B9), (B10), (B11), (B12), (B13), (B14) and (B15) are defined as follows:
(B1) a naphthoylbenzimidazole compound of formula (I) 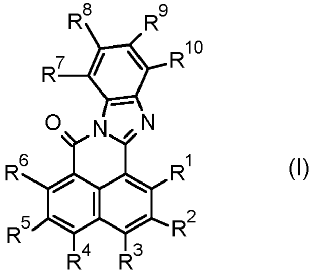 wherein
at least one of the radicals R¹, R², R³, R⁴, R⁵, R⁶, R⁷, R⁸, R⁹ and R¹⁰, independently of each other, is aryl which carries one, two or three cyano groups and 0, 1, 2, 3 or 4 substituents R^{Ar} and the remaining radicals R¹, R², R³, R⁴, R⁵, R⁶, R⁷, R⁸, R⁹ and R¹⁰, independently of each other, are selected from hydrogen and aryl which is unsubstituted or carries 1, 2, 3, 4 or 5 substituents R^{Ar},
where
R^{Ar} independently of each other and independently of each occurrence is selected from halogen, C₁-C₃₀-alkyl, C₂-C₃₀-alkenyl, C₂-C₃₀-alkynyl, where the three latter radicals are unsubstituted or carry one or more R^{a} groups, C₃-C₈-cycloalkyl, 3- to 8-membered heterocyclyl, where the two latter radicals are unsubstituted or carry one or more R^{b} groups, aryl and heteroaryl, where the two latter radicals are unsubstituted or carry one or more R^{c} groups,
where
R^{a} independently of each other and independently of each occurrence is selected from cyano, halogen, C₃-C₈-cycloalkyl, 3- to 8-membered heterocyclyl, aryl and heteroaryl, where C₃-C₈-cycloalkyl,3- to 8-membered heterocyclyl are unsubstituted or bear one or more R^{b1} groups, and where aryl and heteroaryl are unsubstituted or bear one or more R^{c1} groups;
R^{b} independently of each other and independently of each occurrence is selected from cyano, halogen, C₁-C₁₈-alkyl, C₃-C₈-cycloalkyl,3- to 8-membered heterocyclyl, aryl and heteroaryl, where C₃-C₈-cycloalkyl, 3- to 8-membered heterocyclyl are unsubstituted or bear one or more R^{b1} groups, and where aryl and heteroaryl are unsubstituted or bear one or more R^{c1} groups;
R^{c} independently of each other and independently of each occurrence is selected from cyano, halogen, C₁-C₁₈-alkyl, C₃-C₈-cycloalkyl,3- to 8-membered heterocyclyl, aryl and heteroaryl, where C₃-C₈-cycloalkyl,3- to 8-membered heterocyclyl are unsubstituted or bear one or more R^{b1} groups, and where aryl and heteroaryl are unsubstituted or bear one or more R^{c1} groups;
R^{b1} independently of each other and independently of each occurrence is selected from halogen, C₁-C₁₈-alkyl and C₁-C₁₈-haloalkyl;
R^{c1} independently of each other and independently of each occurrence is selected from halogen, C₁-C₁₈-alkyl and C₁-C₁₈-haloalkyl;
or mixtures thereof;
(B2) a cyanated naphthoylbenzimidazole compound of formula (II) 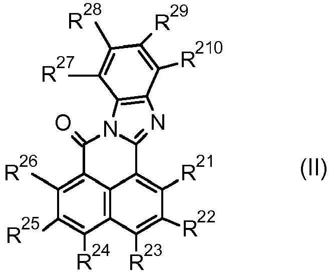 wherein
R²¹, R²², R²³, R²⁴, R²⁵, R²⁶, R²⁷, R²⁸, R²⁹ and R²¹⁰ are each independently hydrogen, cyano or aryl which is unsubstituted or has one or more identical or different substituents R^{2Ar},
where
each R^{2Ar} is independently selected from cyano, hydroxyl, mercapto, halogen, C₁-C₂₀-alkoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2},
C₁-C₃₀-alkyl, C₂-C₃₀-alkenyl, C₂-C₃₀-alkynyl, where the three latter radicals are unsubstituted or bear one or more R^{2a} groups, C₃-C₈-cycloalkyl, 3- to 8-membered heterocyclyl, where the two latter radicals are unsubstituted or bear one or more R^{2b} groups, aryl, U-aryl, heteroaryl and U-heteroaryl, where the four latter radicals are unsubstituted or bear one or more R^{2b} groups,
where
each R^{2a} is independently selected from cyano, hydroxyl, oxo, mercapto, halogen, C₁-C₂₀-alkoxy, C₁-C₂₀-alkylthio, nitro, -NR^{2Ar2}R^{Ar3}, -NR^{2Ar2}COR^{2Ar3}, -CONR^{2Ar2}R^{Ar3}, -SO₂NR^{2Ar2}R^{Ar3}, -COOR^{2Ar2}, -SO₃R^{2Ar2}, C₃-C₈-cycloalkyl, 3- to 8-membered heterocyclyl, aryl and heteroaryl, where the cycloalkyl, heterocyclyl, aryl and heteroaryl radicals are unsubstituted or bear one or more R^{2b} groups;
each R^{2b} is independently selected from cyano, hydroxyl, oxo, mercapto, halogen, C₁-C₂₀-alkoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₁₈-alkyl, C₂-C₁₈-alkenyl, C₂-C₁₈-alkynyl, C₃-C₈-cycloalkyl, 3- to 8-membered heterocyclyl, aryl and heteroaryl, where the four latter radicals are unsubstituted or bear one or more R^{2b1} groups;
each R^{2b1} is independently selected from cyano, hydroxyl, mercapto, oxo, nitro, halogen, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, -SO₃R^{2Ar2}, C₁-C₁₈-alkyl, C₂-C₁₈-alkenyl, C₂-C₁₈-alkynyl, C₁-C₁₂-alkoxy, and C₁-C₁₂-alkylthio;
U is an -O-, -S-, -NR^{2Ar1-}, -CO-, -SO- or -SO₂- moiety; R^{2Ar1}, R^{2Ar2}, R^{2Ar3} are each independently hydrogen, C₁-C₁₈-alkyl, 3- to 8-membered cycloalkyl, 3- to 8-membered heterocyclyl, aryl or heteroaryl, where alkyl is unsubstituted or bears one or more R^{2a} groups, where 3- to 8-membered cycloalkyl, 3- to 8-membered heterocyclyl, aryl and heteroaryl are unsubstituted or bear one or more R^{2b} groups;
with the proviso that the compound of formula II comprises at least one cyano group,
or mixtures thereof;
(B3) a cyanated perylene compound of formula (III) 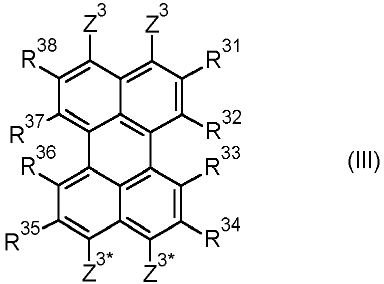 in which
one of the Z³ substituents is cyano and the other Z³ substituent is CO₂R³⁹, CONR³¹⁰R³¹¹, C₁-C₁₈-alkyl, C₂-C₁₈-alkenyl, C₂-C₁₈-alkynyl, C₃-C₁₂-cycloalkyl or C₆-C₁₄-aryl, where
C₁-C₁₈-alkyl, C₂-C₁₈-alkenyl, C₂-C₁₈-alkynyl are unsubstituted or bear one or more identical or different Z^{3a} substituents,
C₃-C₁₂-cycloalkyl is unsubstituted or bears one or more identical or different Z^{3b} substituents, and
C₆-C₁₄-aryl is unsubstituted or bears one or more identical or different Z^{3Ar} substituents;
one of the Z^{3*} substituents is cyano and the other Z^{3*} substituent is CO₂R³⁹, CONR³¹⁰R³¹¹, C₁-C₁₈-alkyl, C₂-C₁₈-alkenyl, C₂-C₁₈-alkynyl, C₃-C₁₂-cycloalkyl or C₆-C₁₄-aryl, where
C₁-C₁₈-alkyl, C₂-C₁₈-alkenyl, C₂-C₁₈-alkynyl are unsubstituted or bear one or more identical or different Z^{3a} substituents,
C₃-C₁₂-cycloalkyl is unsubstituted or bears one or more identical or different Z^{3b} substituents, and
C₆-C₁₄-aryl is unsubstituted or bears one or more identical or different Z^{3Ar} substituents;
R³¹, R³², R³³, R³⁴, R³⁵, R³⁶, R³⁷ and R³⁸ are each independently selected from hydrogen, cyano, bromine and chlorine,
with the proviso that 1, 2, 3, 4, 5, 6, 7 or 8 of the R³¹, R³², R³³, R³⁴, R³⁵, R³⁶, R³⁷ or R³⁸ substituents are cyano;
where
R³⁹ is hydrogen, C₁-C₁₀-alkyl, C₂-C₁₀-alkenyl, C₂-C₁₀-alkynyl, C₃-C₁₂-cycloalkyl or C₆-C₁₄-aryl, where
C₁-C₁₀-alkyl, C₂-C₁₀-alkenyl, C₂-C₁₀-alkynyl are unsubstituted or bear one or more identical or different R^{3a} substituents,
C₃-C₁₂-cycloalkyl is unsubstituted or bears one or more identical or different R^{3b} substituents and
C₆-C₁₄-aryl is unsubstituted or bears one or more identical or different R^{3Ar} substituents;
R³¹⁰ and R³¹¹ are each independently hydrogen, C₁-C₁₀-alkyl, C₂-C₁₀-alkenyl, C₂-C₁₀-alkynyl, C₃-C₁₂-cycloalkyl or C₆-C₁₄-aryl, where
C₁-C₁₀-alkyl, C₂-C₁₀-alkenyl, C₂-C₁₀-alkynyl are unsubstituted or bear one or more identical or different R^{3a} substituents,
C₃-C₁₂-cycloalkyl is unsubstituted or bears one or more identical or different R^{3b} substituents and
C₆-C₁₄-aryl is unsubstituted or bears one or more identical or different R^{3Ar} substituents;
each Z^{3a} is independently halogen, hydroxyl, NR^{310a}R^{311a}, C₁-C₁₀-alkoxy, C₁-C₁₀-haloalkoxy, C₁-C₁₀-alkylthio, C₃-C₁₂-cycloalkyl, C₆-C₁₄-aryl, C(=O)R^{39a}; C(=O)OR^{39a} or C(O)NR^{310a}R^{311a}, where
C₃-C₁₂-cycloalkyl is unsubstituted or bears one or more identical or different R^{3b} substituents and
C₆-C₁₄-aryl is unsubstituted or bears one or more identical or different R^{3Ar} substituents;
each Z^{3b} and each Z^{3Ar} is independently halogen, hydroxyl, NR^{310a}R^{311a}, C₁-C₁₀-alkyl, C₁-C₁₀-alkoxy, C₁-C₁₀-haloalkoxy, C₁-C₁₀-alkylthio, C(=O)R^{39a}; C(=O)OR^{39a} or C(O)NR^{310a}R^{311a};
each R^{3a} is independently halogen, hydroxyl, C₁-C₁₀-alkoxy, C₃-C₁₂-cycloalkyl or C₆-C₁₄-aryl;
each R^{3b} is independently halogen, hydroxyl, C₁-C₁₀-alkyl, C₁-C₁₀-alkoxy, C₁-C₁₀-haloalkoxy, C₁-C₁₀-alkylthio, C₂-C₁₀-alkenyl, C₂-C₁₀-alkynyl, C₃-C₁₂-cycloalkyl or C₆-C₁₄-aryl;
each R^{3Ar} is independently halogen, hydroxyl, C₁-C₁₀-alkyl, C₁-C₁₀-alkoxy, C₁-C₁₀-haloalkoxy, C₁-C₁₀-alkylthio, C₂-C₁₀-alkenyl, C₂-C₁₀-alkynyl, C₃-C₁₂-cycloalkyl or C₆-C₁₄-aryl;
R^{39a} is hydrogen, C₁-C₁₀-alkyl, C₂-C₁₀-alkenyl, C₂-C₁₀-alkynyl,C₃-C₁₂-cycloalkyl or C₆-C₁₄-aryl; and
R^{310a}, R^{311a} are each independently hydrogen, C₁-C₁₀-alkyl, C₂-C₁₀-alkenyl, C₂-C₁₀-alkynyl, C₃-C₁₂-cycloalkyl or C₆-C₁₄-aryl;
or mixtures thereof;
(B4) a cyanated compound of formula (IV) 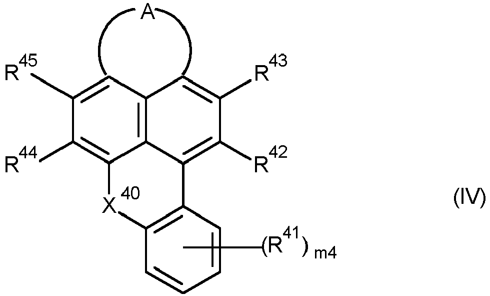 wherein
m4 is 0, 1, 2, 3 or 4;
each R⁴¹ independently from each other is selected from bromine, chlorine, cyano, -NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl, aryloxy in the six last-mentioned radicals are unsubstituted or substituted with 1, 2, 3, 4 or 5 identical or different radicals R^{41a} and where C₁-C₂₄-alkyl, C₁-C₂₄-haloalkyl, C₁-C₂₄-alkoxy, and the alkylene moiety of C₆-C₂₄-aryl-C₁-C₁₀-alkylene may be interrupted by one or more groups selected from O, S and NR^{4c};
at least one of the radicals R⁴², R⁴³, R⁴⁴ and R⁴⁵ is CN, and the remaining radicals, independently from each other, are selected from hydrogen, chlorine and bromine;
X⁴⁰ is O, S, SO or SO₂;
A is a diradical selected from diradicals of the general formulae (A.1), (A.2), (A.3), and (A.4) 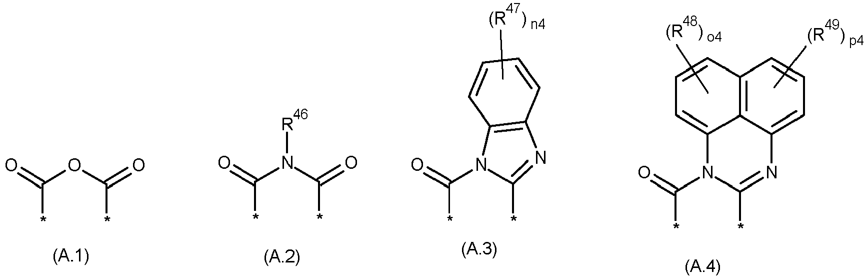 wherein
* in each case denotes the point of attachments to the remainder of the molecule;
n4 is 0, 1, 2, 3 or 4;
o4 is 0, 1, 2 or 3;
p4 is 0, 1, 2 or 3;
R⁴⁶ is hydrogen, C₁-C₂₄-alkyl, C₁-C₂₄-haloalkyl, C₃-C₂₄-cycloalkyl, C₆-C₂₄-aryl or C₆-C₂₄-aryl-C₁-C₁₀-alkylene, where the rings of cycloalkyl, aryl, and aryl-alkylene in the three last-mentioned radicals are unsubstituted or substituted with 1, 2, 3, 4 or 5 identical or different radicals R^{46a}, and where C₁-C₂₄-alkyl, C₁-C₂₄-haloalkyl and the alkylene moiety of C₆-C₂₄-aryl-C₁-C₁₀-alkylene may be interrupted by one or more heteroatoms or heteroatomic groups selected from O, S and NR^{4c};
each R⁴⁷ independently from each other is selected from bromine, chlorine, cyano, -NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl-alkylene in the six last-mentioned radicals are unsubstituted or substituted with 1, 2, 3, 4 or 5 identical or different radicals R^{47a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
each R⁴⁸ independently from each other is selected from bromine, chlorine, cyano, NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl-alkylene in the six last-mentioned radicals are unsubstituted or substituted with 1, 2, 3, 4 or 5 identical or different radicals R^{48a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
each R⁴⁹ independently from each other is selected from bromine, chlorine, cyano, NR^{4a}R^{4b}, C₁-C₂₄-alkyl, C₁-C₂₄-haloalkyl, C₁-C₂₄-alkoxy, C₁-C₂₄-haloalkoxy, C₃-C₂₄-cycloalkyl, heterocycloalkyl, heteroaryl, C₆-C₂₄-aryl, C₆-C₂₄-aryloxy, C₆-C₂₄-aryl-C₁-C₁₀-alkylene, where the rings of cycloalkyl, heterocycloalkyl, heteroaryl, aryl and aryl- alkylene in the six last-mentioned radicals are unsubstituted or substituted with 1, 2, 3, 4 or 5 identical or different radicals R^{49a} and where C₁-C₂₄-alkyl, C₁-C₂₄-haloalkyl, C₁-C₂₄-alkoxy, C₁-C₂₄-haloalkoxy, and the alkylene moiety of C₆-C₂₄-aryl-C₁-C₁₀-alkylene may be interrupted by one or more groups selected from O, S and NR^{4c};
R^{41a}, R^{46a}, R^{47a}, R^{48a}, R^{49a} are independently of one another selected from C₁-C₂₄-alkyl, C₁-C₂₄-fluoroalkyl, C₁-C₂₄-alkoxy, fluorine, chlorine and bromine;
R^{4a}, R^{4b}, R^{4c} are independently of one another are selected from hydrogen, C₁-C₂₀-alkyl, C₃-C₂₄-cycloalkyl, heterocycloalkyl, heteroaryl and C₆-C₂₄-aryl;
or mixtures thereof;
(B5) a benz(othi)oxanthene compound of formula (V) 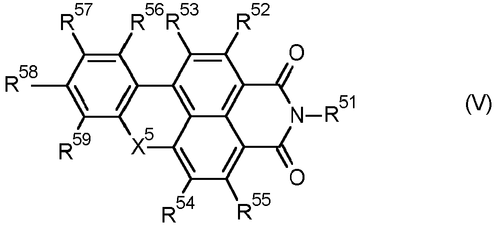 wherein
X⁵ is oxygen or sulfur;
R⁵¹ is phenyl which is unsubstituted or carries 1, 2, 3, 4, or 5 substituents selected from halogen, R⁵¹¹, OR⁵⁵², NHR⁵⁵² and NR⁵⁵²R⁵⁵⁷;
R⁵², R⁵³, R⁵⁴, R⁵⁵, R⁵⁶, R⁵⁷, R⁵⁸ and R⁵⁹ are independently of each other selected from hydrogen, halogen, R⁵⁵³, OR⁵⁵³, NHR⁵⁵³ and NR⁵⁵³R⁵⁵⁴, wherein
R⁵¹¹ is selected from C₁-C₂₀-alkyl, C₆-C₂₄-aryl and heteroaryl;
R⁵⁵² and R⁵⁵⁷ are independently of each other selected from C₁-C₁₈-alkyl, C₆-C₂₄-aryl and heteroaryl; and
R⁵⁵³ and R⁵⁵⁴ are independently of each other selected from C₁-C₁₈-alkyl, C₆-C₂₄-aryl and heteroaryl;
or mixtures thereof;
(B6) a benzimidazoxanthenisoquinoline compound of formulae (VIA) or (VIB) 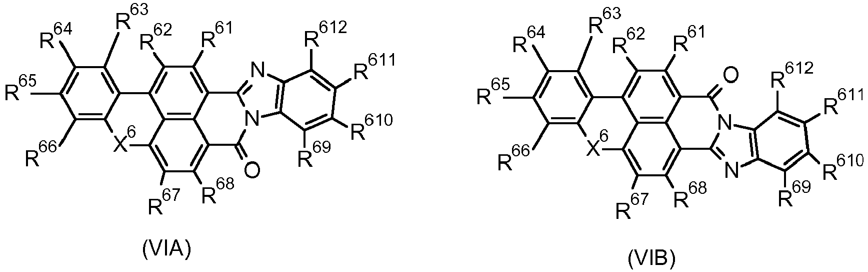 wherein
X⁶ is oxygen or sulfur;
R⁶¹, R⁶², R⁶³, R⁶⁴, R⁶⁵, R⁶⁶, R⁶⁷, R⁶⁸, R⁶⁹, R⁶¹⁰, R⁶¹¹ and R⁶¹² are independently of each other selected from hydrogen, halogen, R⁶⁶¹, OR⁶⁶¹, NHR⁶⁶¹ and NR⁶⁶¹R⁶⁶²;
wherein
each R⁶¹¹ is selected from C₁-C₁₈-alkyl, C₆-C₂₄-aryl and heteroaryl; and
each R⁶⁶² is selected from C₁-C₁₈-alkyl, C₆-C₂₄-aryl and heteroaryl;
or mixtures thereof;
(B7) fluorescent compound comprising at least one structural unit of formula (VII) 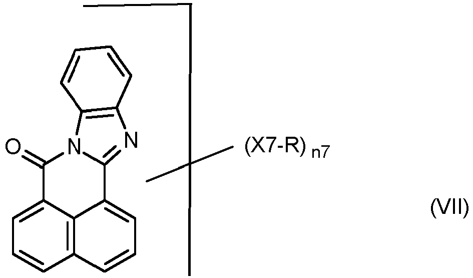 where one or more CH groups of the six-membered ring of the benzimidazole structure shown may be replaced by nitrogen and where the symbols are each defined as follows:
n7 is a number from 0 to (10-p7) for each structural unit of the formula (VII); where p7 is the number of CH units which have been replaced by nitrogen in the six-membered ring of the benzimidazole structure shown
X7 is a chemical bond, O, S, SO, SO₂, NR⁷¹; and
R is an aliphatic radical, cycloaliphatic radical, aryl, heteroaryl, each of which may bear substituents, an aromatic or heteroaromatic ring or ring system, each of which is fused to other aromatic rings of the structural unit of the formula (VII), is F, Cl, Br, CN, H when X7 is not a chemical bond;
where two R radicals may be joined to give one cyclic radical and where X7 and R, when n7 > one, may be the same or different;
R⁷¹ is each independently hydrogen, C₁-C₁₈-alkyl or cycloalkyl, the carbon chain of which may comprise one or more -O-, -S-, -CO-, -SO- and/or -SO₂- moieties and which may be mono- or polysubstituted; aryl or heteroaryl which may be mono- or polysubstituted;
or mixtures thereof;
(B8) a perylene compound of formulae (VIII) or (IX) 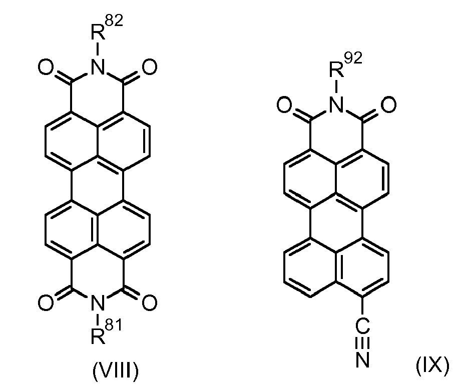 where
R⁸¹, R⁸² are each independently C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀-aryl-C₁-C₁₀-alkylene, where the aromatic ring in the three latter radicals is unsubstituted or mono- or polysubstituted by C₁-C₁₀-alkyl;
R⁹² is C₁-C₃₀-alkyl, C₃-C₈-cycloalkyl, aryl, heteroaryl, aryl-Ci-Cio-alkylene, where the aromatic ring in the three latter radicals is unsubstituted or mono- or polysubstituted by C₁-C₁₀-alkyl;
(B9) a naphthalene monoimide compound of formula (X) 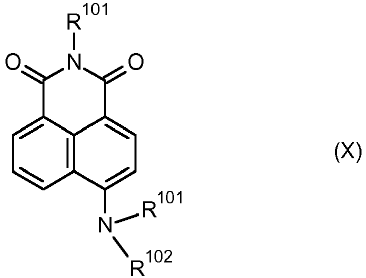 wherein
each R¹⁰¹ independently of each other is hydrogen, C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀-aryl-C₁-C₁₀-alkylene, where the aromatic ring in the three latter radicals is unsubstituted or mono- or polysubstituted by C₁-C₁₀-alkyl;
R¹⁰² is hydrogen, C₁-C₃₀-alkyl, C₂-C₃₀-alkyl which is interrupted by one or more oxygen, C₃-C₈-cycloalkyl, C₆-C₁₀-aryl, heteroaryl, C₆-C₁₀aryl-C₁-C₁₀ alkylene, where the aromatic ring in the three latter radicals is unsubstituted or mono- or polysubstituted by C₁-C₁₀-alkyl;
(B10)7-(diethylamino)-3-(5-methylbenzo[d]oxazol-2-yl)-2H-chromen-2-one;
(B11)a perylene compound of formulae (XIA) or (XIB) 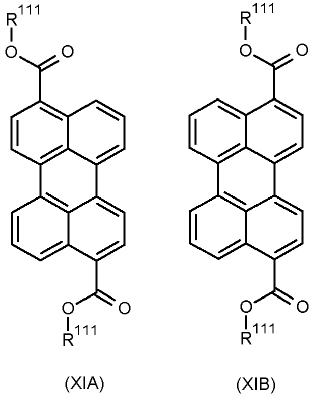
wherein
each R¹¹¹ independently of each other is C₁-C₁₈ alkyl, C₄-C₈ cycloalkyl, which may be mono- or polysubstituted by halogen or by linear or branched C₁-C₁₈ alkyl, or phenyl or naphthyl which may be mono- or polysubstituted by halogen or by linear or branched C₁-C₁₈ alkyl;
or mixtures thereof;
(B12)a cyanated perylene compound of formulae (XIIA) or (XIIB) 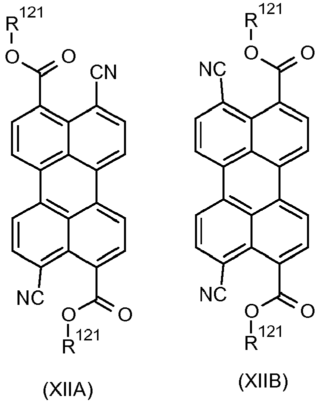 wherein
each R¹²¹ independently of each other is C₁-C₁₈ alkyl, C₄-C₈ cycloalkyl, which may be mono- or polysubstituted by halogen or by linear or branched C₁-C₁₈ alkyl, or phenyl or naphthyl which may be mono- or polysubstituted by halogen or by linear or branched C₁-C₁₈ alkyl;
or mixtures thereof;
(B13)a perylene bisimide compound of formula (XIII) 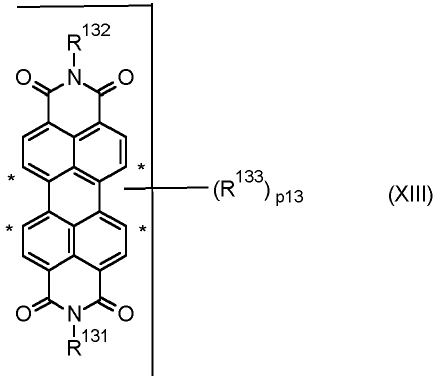 wherein
p13 is 1, 2, 3 or 4;
R¹³¹ and R¹³² independently of each other are C₁-C₁₀-alkyl, which is unsubstituted or substituted by C₆-C₁₀-aryl which in turn is unsubstituted or substituted by 1, 2 or 3 C₁-C₁₀-alkyl,
C₂-C₂₀-alkyl, which is interrupted by one or more oxygen, C₃-C₈-cycloalkyl, which is unsubstituted or substituted by 1, 2 or 3 C₁-C₁₀-alkyl, or
C₆-C₁₀-aryl which is unsubstituted or substituted by 1, 2 or 3 C₁-C₁₀-alkyl;
each R¹³³ independently of each other is fluorine, chlorine, C₁-C₁₆-alkyl, C₂-C₁₆-alkyl interrupted by one or more oxygen, C₁-C₁₆-alkoxy, C₆-C₁₀-aryloxy which is unsubstituted or mono- or polysubstituted by fluorine, chlorine, C₁-C₁₆-alkyl, C₂-C₁₆-alkyl interrupted by one or more oxygen, C₁-C₁₆-alkoxy or C₆-C₁₀-aryl, which is unsubstituted or substituted by 1, 2 or 3 radicals selected from C₁-C₆-alkyl, C₁-C₆-alkoxy-C₁-C₆-alkyl and C₁-C₆-alkoxy, where the R¹³³ radicals are at the positions indicated by *;
or mixtures thereof;
(B14)a perylene compound of formula (XIV) 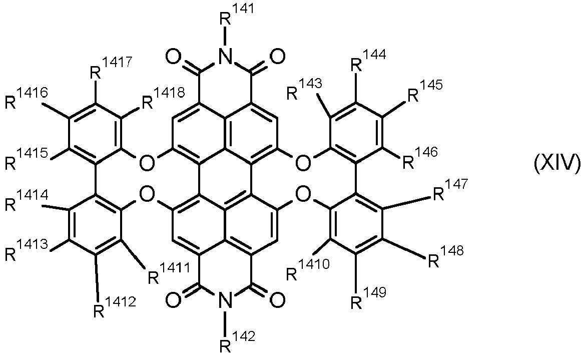 wherein
R¹⁴¹ and R¹⁴², independently of each other, are selected from hydrogen, in each case unsubstituted or substituted C₁-C₃₀-alkyl, polyalkyleneoxy, C₁-C₃₀-alkoxy, C₁-C₃₀-alkylthio, C₃-C₂₀-cycloalkyl, C₃-C₂₀-cycloalkyloxy, C₆-C₂₄-aryl and C₆-C₂₄-aryloxy;
R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ and R¹⁴¹⁸ independently of each other, are selected from hydrogen, halogen, cyano, hydroxyl, mercapto, nitro, -NE¹⁴¹E¹⁴², -NR^{Ar141}COR^{A142}, -_{C}ONR^{Ar141}R^{Ar142}, -SO₂NR^{A141}R^{A142}, -COOR^{Ar141}, -SO₃R^{Ar142},
in each case unsubstituted or substituted C₁-C₃₀-alkyl, polyalkyleneoxy, C₁-C₃₀-alkoxy, C₁-C₃₀-alkylthio, C₃-C₂₀-cycloalkyl, C₃-C₂₀-cycloalkoxy, C₆-C₂₄-aryl, C₆-C₂₄-aryloxy and C₆-C₂₄-arylthio,
where R¹⁴³ and R¹⁴⁴, R¹⁴⁴ and R¹⁴⁵, R¹⁴⁵ and R¹⁴⁶, R¹⁴⁶ and R¹⁴⁷, R¹⁴⁷ and R¹⁴⁸, R¹⁴⁸ and R¹⁴⁹, R¹⁴⁹ and R¹⁴¹⁰, R¹⁴¹¹ and R¹⁴¹², R¹⁴¹² and R¹⁴¹³, R¹⁴¹³ and R¹⁴¹⁴, R¹⁴¹⁴ and R¹⁴¹⁵, R¹⁴¹⁵ and R¹⁴¹⁶, R¹⁴¹⁶ and R¹⁴¹⁷ and/or R¹⁴¹⁷ and R¹⁴¹⁸ together with the carbon atoms of the biphenylyl moiety to which they are bonded, may also form a further fused aromatic or non-aromatic ring system wherein the fused ring system is unsubstituted or substituted;
where
E¹⁴¹ and E¹⁴², independently of each other, are hydrogen, unsubstituted or substituted C₁-C₁₈-alkyl, unsubstituted or substituted C₂-C₁₈-alkenyl, unsubstituted or substituted C₂-C₁₈-alkynyl, unsubstituted or substituted C₃-C₂₀-cycloalkyl or unsubstituted or substituted C₆-C₁₀-aryl;
R^{Ar141} and R^{Ar142}, each independently of each other, are hydrogen, unsubstituted or substituted C₁-C₁₈-alkyl, unsubstituted or substituted C₃-C₂₀-cycloalkyl, unsubstituted or substituted heterocyclyl, unsubstituted or substituted C₆-C₂₀-aryl or unsubstituted or substituted heteroaryl;
or mixtures thereof;
(B15)a 3,4;9,10-perylenetetracarboxylic diimide compound comprising a first group (XVa) and a second group (XVb),
wherein the first group (XVa) comprises one or more groups based on one or more of compound (V), compound (X), compound (XIA), compound (XIB), 7-(diethylamino)-3-(6-methylbenzo[d]oxazol-2-yl)-2H-chromen-2-one or compounds of formula (XVa1) 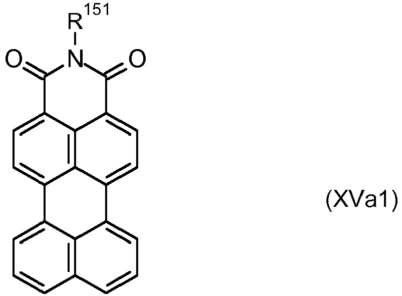 wherein
R¹⁵¹ is C₁-C₁₀-alkyl, which is unsubstituted or substituted by C₆-C₁₀-aryl which in turn is unsubstituted or substituted by 1, 2 or 3 C₁-C₁₀-alkyl, C₂-C₂₀-alkyl, which is interrupted by one or more oxygen, C₃-C₈-cycloalkyl, which is unsubstituted or substituted by 1, 2 or 3 C₁-C₁₀-alkyl, or
C₆-C₁₀-aryl which is unsubstituted or substituted by 1, 2 or 3 C₁-C₁₀-alkyl;
and wherein the second group (XVb) is 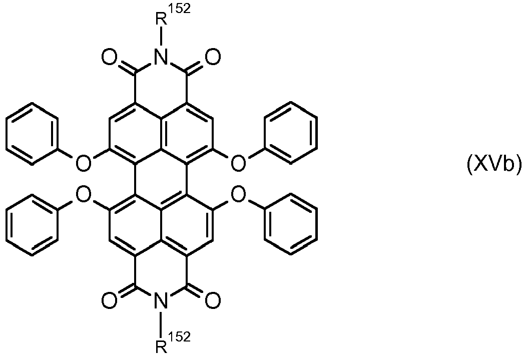 wherein
R¹⁵² independently of each other, are selected from hydrogen, C₁-C₁₀-alkyl, which is unsubstituted or substituted by C₆-C₁₀-aryl which in turn is unsubstituted or substituted by 1, 2 or 3 C₁-C₁₀-alkyl, C₂-C₂₀-alkyl, which is interrupted by one or more oxygen, C₃-C₈-cycloalkyl, which is unsubstituted or substituted by 1, 2 or 3 C₁-C₁₀-alkyl, or
C₆-C₁₀-aryl which is unsubstituted or substituted by 1, 2 or 3 C₁-C₁₀-alkyl or a group (XVb1) 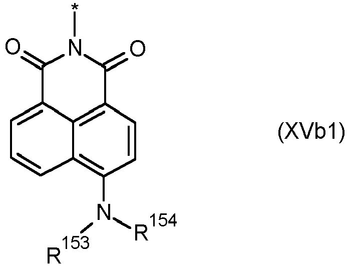 wherein
* denotes the bonding site to the remainder of the molecule;
R¹⁵³ and R¹⁵⁴, independently of each other, are selected from hydrogen, C₁-C₃₀-alkyl, C₂-C₃₀-alkenyl, C₂-C₃₀-alkynyl, C₃-C₁₂-cycloalkyl and C₆-C₂₄-aryl wherein the two last-mentioned radicals are unsubstituted or carry one, two or three radicals selected from C₁-C₁₀-alkyl.

6. The colour converter according to any of the preceding claims, comprising a mixture of at least two organic fluorescent colorants (B) as defined in claim 5, wherein the at least two organic fluorescent colorants (B) belong to at least two different classes of fluorescent organic colorants (B1), (B2), (B3), (B4), (B5), (B6), (B7), (B8), (B9), (B10), (B11), (B12), (B13), (B14) or (B15) .

7. The colour converter according to claim 5 or 6, comprising at least one perylene bisimide compound of formula (XIII) as organic fluorescent colorant.

8. The colour converter according to any of claims 5 to 7, comprising at least one compound comprising at least one structural unit of formula (VII) as organic fluorescent colorant.

9. The colour converter according to any of claims 5 to 8, comprising at least one compound selected from the compound of formula (VIII), the compound of formula (IX), the compounds of formulae (XIA) and (XIB), the compounds of formulae (XIIA) and (XIIB) and mixtures thereof as organic fluorescent colorant.

10. The colour converter according to any of the preceding claims, comprising at least one luminescent material selected from garnets, silicates, sulfides, nitrides and oxynitrides and quantum dots.

11. The colour converter according to any of the preceding claims, further comprising at least one inorganic white pigment as a scattering body, preferably titanium dioxide.

12. The use of a color converter according to any of the preceding claims for conversion of light generated by a blue LED with a center wavelength of emission between 400 nm and 480 nm to provide white light having a correlated color temperature between 2 000 K and 20 000 K or for conversion of light generated by a cool white LED having a correlated color temperature between 3 000 K and 20 000 K to provide white light having a lower correlated color temperature.

13. Polymer mixture comprising at least one 2,5-furandicarboxylate polyester (A) obtainable by reacting (i) at least one diol selected from an aliphatic C₂-C₂₀-diol and a cycloaliphatic C₃-C₂₀-diol, with (ii) 2,5-furandicarboxylic acid and/or an ester forming derivative thereof and (iii) optionally at least one further dicarboxylic acid selected from 1,2-cyclohexanedicarboxylic acid, 1,4-cyclohexanedicarboxylic acid, 3,4-furandicarboxylic acid, terephthalic acid and 2,6-naphthalic acid and/or an ester forming derivative thereof and at least one luminescent material, especially at least one organic fluorescent colorant (B) as defined in any of claims 5 to 9.

14. A lighting device comprising
(i) at least one LED selected from a blue LED with a center wavelength of emission from 400 nm to 480 nm and a cool white LED having a correlated color temperature between 3 000 K and 20 000 K; and
(ii) at least one color converter as defined in any of claims 1 to 11,
wherein the at least one color converter is in a remote arrangement from the at least one LED.

15. A device producing electric power upon illumination comprising a photovoltaic cell and the color converter as defined in any of claims 1 to 11, where at least a part of the light not absorbed by the photovoltaic cell is absorbed by the color converter.

## Patentansprüche

1. Farbkonverter, umfassend
- ein polymeres Matrixmaterial, das mindestens einen 2,5-Furandicarboxylat-Polyester (A) umfasst, der durch Umsetzen von (i) mindestens einem Diol, das aus einem aliphatischen C₂-C₂₀-Diol und einem cycloaliphatischen C₃-C₂₀-Diol ausgewählt ist, mit (ii) 2,5-Furandicarbonsäure und/oder einem esterbildenden Derivat davon und (iii) gegebenenfalls mindestens einer weiteren Dicarbonsäure, die aus 1,2-Cyclohexandicarbonsäure, 1,4-Cyclohexandicarbonsäure, 3,4-Furandicarbonsäure, Terephthalsäure und 2,6-Naphthalinsäure und/oder einem esterbildenden Derivat davon ausgewählt ist, erhältlich ist; und
- mindestens ein lumineszierendes Material.

2. Farbkonverter nach Anspruch 1, wobei der 2,5-Furandicarboxylat-Polyester (A) aus Poly(ethylen-2,5-furandicarboxylat), Poly(propylen-2,5-furandicarboxylat), Poly(ethylen-co-propylen-2,5-furandicarboxylat), Poly(butylen-2,5-furandicarboxylat), Poly(pentylen-2,5-furandicarboxylat), Poly-(neopentylen-2,5-furandicarboxylat) und Mischungen davon, vorzugsweise Poly(ethylen-2,5-furandicarboxylat), ausgewählt ist.

3. Farbkonverter nach Anspruch 1, wobei es sich bei dem 2,5-Furandicarboxylat-Polyester (A) um Poly-(ethylen-2,5-furandicarboxylat-co-terephthalat), Poly(ethylen-2,5-furandicarboxylat-co-2,6-naphtha-lat) oder Poly(ethylen-2,5-furandicarboxylat-co-3,4-furandicarboxylat) handelt.

4. Farbkonverter nach einem der vorhergehenden Ansprüche, wobei es sich bei dem polymeren Matrixmaterial um einen Blend von mindestens zwei Polyestern handelt, einem ersten Polyester, bei dem es sich um Poly(ethylen-2,5-furandicarboxylat) handelt, und mindestens einem zweiten Polyester, der aus Poly(ethylenterephthalat), Poly(butylen-terephthalat), Poly(ethylen-2,6-naphthalat), Poly(butylen-2,6-naphthalat) und Poly(propylen-2,5-furandicarboxylat) ausgewählt ist.

5. Farbkonverter nach einem der vorhergehenden Ansprüche, wobei es sich bei dem mindestens einen lumineszierenden Material um mindestens ein organisches Fluoreszenzfarbmittel handelt, das aus (B1), (B2), (B3), (B4), (B5), (B6), (B7), (B8), (B9), (B10), (B11), (B12), (B13), (B14), (B15) und Mischungen davon ausgewählt ist, wobei (B1), (B2), (B3), (B4), (B5), (B6), (B7), (B8), (B9), (B10), (B11), (B12), (B13), (B14) und (B15) wie folgt definiert sind:
(B1) eine Naphthoylbenzimidazol-Verbindung der Formel (I) 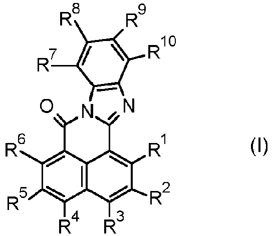 wobei
mindestens einer der Reste R¹, R², R³, R⁴, R⁵, R⁶, R⁷, R⁸, R⁹ und R¹⁰ unabhängig voneinander für Aryl, das eine, zwei oder drei Cyanogruppen und 0, 1, 2, 3 oder 4 Substituenten R^{Ar} trägt, steht und die übrigen Reste R¹, R², R³, R⁴, R⁵, R⁶, R⁷, R⁸, R⁹ und R¹⁰ unabhängig voneinander aus Wasserstoff und Aryl, das unsubstituiert ist oder 1, 2, 3, 4 oder 5 Substituenten R^{Ar} trägt, ausgewählt sind,
wobei
R^{Ar} unabhängig voneinander und unabhängig von jedem Vorkommen aus Halogen, C₁-C₃₀-Alkyl, C₂-C₃₀-Alkenyl, C₂-C₃₀-Alkinyl, wobei die drei letztgenannten Reste unsubstituiert oder eine oder mehrere Gruppen R^{a} tragen,
C₃-C₈-Cycloalkyl, 3- bis 8-gliedrigem Heterocyclyl, wobei die zwei letztgenann-ten Reste unsubstituiert oder eine oder mehrere Gruppen R^{b} tragen, Aryl und Heteroaryl, wobei die zwei letztgenannten Reste unsubstituiert oder eine oder mehrere Gruppen R^{c} tragen, ausgewählt ist,
wobei
R^{a} unabhängig voneinander und unabhängig von jedem Vorkommen aus Cyano, Halogen, C₃-C₈-Cycloalkyl, 3- bis 8-gliedrigem Heterocyclyl, Aryl und Heteroaryl ausgewählt ist, wobei C₃-C₈-Cycloalkyl und 3- bis 8-gliedriges Heterocyclyl unsubstituiert sind oder eine oder mehrere Gruppen R^{b1} tragen und wobei Aryl und Heteroaryl unsubstituiert sind oder eine oder mehrere Gruppen R^{c1} tragen;
R^{b} unabhängig voneinander und unabhängig von jedem Vorkommen aus Cyano, Halogen, C₁-C₁₈-Alkyl, C₃-C₈-Cycloalkyl, 3- bis 8-gliedrigem Heterocyclyl, Aryl und Heteroaryl ausgewählt ist, wobei C₃-C₈-Cycloalkyl und 3- bis 8-gliedriges Heterocyclyl unsubstituiert sind oder eine oder mehrere Gruppen R^{b1} tragen und wobei Aryl und Heteroaryl unsubstituiert sind oder eine oder mehrere Gruppen R^{c1} tragen;
R^{c} unabhängig voneinander und unabhängig von jedem Vorkommen aus Cyano, Halogen, C₁-C₁₈-Alkyl, C₃-C₈-Cycloalkyl, 3- bis 8-gliedrigem Heterocyclyl, Aryl und Heteroaryl ausgewählt ist, wobei C₃-C₈-Cycloalkyl und 3- bis 8-gliedriges Heterocyclyl unsubstituiert sind oder eine oder mehrere Gruppen R^{b1} tragen und wobei Aryl und Heteroaryl unsubstituiert sind oder eine oder mehrere Gruppen R^{c1} tragen;
R^{b1} unabhängig voneinander und unabhängig von jedem Vorkommen aus Halogen, C₁-C₁₈-Alkyl und C₁-C₁₈-Halogenalkyl aus-gewählt ist;
R^{c1} unabhängig voneinander und unabhängig von jedem Vorkommen aus Halogen, C₁-C₁₈-Alkyl und C₁-C₁₈-Halogenalkyl aus-gewählt ist;
oder Mischungen davon;
(B2) eine cyanierte Naphthoylbenzimidazol-Verbindung der Formel (II) 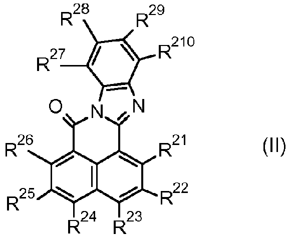 wobei
R²¹, R²², R²³, R²⁴, R²⁵, R²⁶, R²⁷, R²⁸, R²⁹ und R²¹⁰ jeweils unabhängig für Wasserstoff, Cyano oder Aryl, das unsubstituiert ist oder einen oder mehrere gleiche oder verschiedene Substituenten R^{2Ar} aufweist, stehen,
wobei
R^{2Ar} jeweils unabhängig aus Cyano, Hydroxyl, Mercapto, Halogen, C₁-C₂₀-Alkoxy, C₁-C₂₀-Alkyl-thio, Nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₃₀-Alkyl, C₂-C₃₀-Alkenyl, C₂-C₃₀-Alkinyl, wobei die drei letztgenannten Reste unsubstituiert sind oder eine oder mehrere R^{2a}-Gruppen tragen,
C₃-C₈-Cycloalkyl, 3- bis 8-gliedrigem Heterocyclyl, wobei die zwei letztgenannten Reste unsubstituiert sind oder eine oder mehrere R^{2b}-Gruppen tragen,
Aryl, U-Aryl, Heteroaryl und U-Heteroaryl, wobei die vier letztgenannten Reste unsubstituiert sind oder eine oder mehrere R^{2b}-Gruppen tragen,
ausgewählt ist,
wobei
R^{2a} jeweils unabhängig aus Cyano, Hydroxyl, Oxo, Mercapto, Halogen, C₁-C₂₀-Alkoxy, C₁-C₂₀-Alkylthio, Nitro, -NR^{2Ar2}R^{Ar3}, -NR^{2Ar2}COR^{2Ar3}, -CONR^{2Ar2}R^{Ar3}, -SO₂NR^{2Ar2}R^{Ar3}, -COOR^{2Ar2}, -SO₃R^{2Ar2}, C₃-C₈-Cycloalkyl, 3- bis 8-gliedrigem Heterocyclyl, Aryl und Heteroaryl ausgewählt ist, wobei die Cycloalkyl-, Heterocyclyl-, Aryl-und Heteroarylreste unsubstituiert sind oder eine oder mehrere R^{2b}-Gruppen tragen;
R^{2b} jeweils unabhängig aus Cyano, Hydroxyl, Oxo, Mercapto, Halogen, C₁-C₂₀-Alkoxy, C₁-C₂₀-Alkylthio, Nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₁₈-Alkyl, C₂-C₁₈-Alkenyl, C₂-C₁₈-Alkinyl, C₃-C₈-Cycloalkyl, 3- bis 8-gliedrigem Heterocyclyl, Aryl und Heteroaryl, wobei die vier letztgenannten Reste unsubstituiert sind oder eine oder mehrere R^{2b1}-Gruppen tragen, ausgewählt ist;
R^{2b1} jeweils unabhängig aus Cyano, Hydroxyl, Mercapto, Oxo, Nitro, Halogen, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, -SO₃R^{2Ar2}, C₁-C₁₈-Alkyl, C₂-C₁₈-Alkenyl, C₂-C₁₈-Alkinyl, C₁-C₁₂-Alkoxy und C₁-C₁₂-Alkylthio ausgewählt ist;
U für eine -O-, -S-, -NR^{2Ar1}-, -CO-, -SO- oder -SO₂-Gruppierung steht;
R^{2Ar1}, R^{2Ar2}, R^{2Ar3} jeweils unabhängig für Wasserstoff, C₁-C₁₈-Alkyl, 3- bis 8-gliedriges Cycloalkyl, 3- bis 8-gliedriges Heterocyclyl, Aryl oder Heteroaryl stehen, wobei Alkyl unsubstituiert ist oder eine oder mehrere R^{2a}-Gruppen trägt, wobei 3- bis 8-gliedriges Cycloalkyl, 3- bis 8-gliedriges Heterocyclyl, Aryl und Heteroaryl unsubstituiert sind oder eine oder mehrere R^{2b}-Gruppen tragen;
mit der Maßgabe, dass die Verbindung der Formel II mindestens eine Cyanogruppe umfasst,
oder Mischungen davon;
(B3) eine cyanierte Perylen-Verbindung der Formel (III) 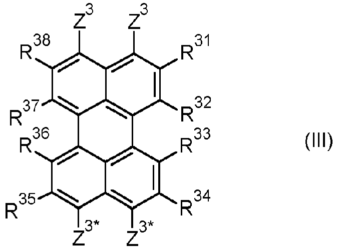 wobei
einer der Substituenten Z³ für Cyano steht und der andere Substituent Z³ für CO₂R³⁹, CONR³¹⁰R³¹¹, C₁-C₁₈-Alkyl, C₂-C₁₈-Alkenyl, C₂-C₁₈-Alkinyl, C₃-C₁₂-Cycloalkyl oder C₆-C₁₄-Aryl steht, wobei C₁-C₁₈-Alkyl, C₂-C₁₈-Alkenyl, C₂-C₁₈-Alkinyl unsubstituiert sind oder einen oder mehrere, gleiche oder verschiedene Substituenten Z^{3a} tragen, C₃-C₁₂-Cycloalkyl unsubstituiert ist oder einen oder mehrere gleiche oder verschiedene Substituenten Z^{3b} trägt und
C₆-C₁₄-Aryl unsubstituiert ist oder einen oder mehrere gleiche oder verschiedene Substituenten z^{3Ar} trägt;
einer der Substituenten Z^{3*} für Cyano steht und der andere Substituent Z^{3*} für CO₂R³⁹, CONR³¹⁰R³¹¹, C₁-C₁₈-Alkyl, C₂-C₁₈-Alkenyl, C₂-C₁₈-Alkinyl, C₃-C₁₂-Cycloalkyl oder C₆-C₁₄-Aryl steht, wobei C₁-C₁₈-Alkyl, C₂-C₁₈-Alkenyl, C₂-C₁₈-Alkinyl unsubstituiert sind oder einen oder mehrere gleiche oder verschiedene Substituenten Z^{3a} tragen, C₃-C₁₂-Cycloalkyl unsubstituiert ist oder einen oder mehrere gleiche oder verschiedene Substituenten Z^{3b} trägt und
C₆-C₁₄-Aryl unsubstituiert ist oder einen oder mehrere gleiche oder verschiedene Substituenten Z^{3Ar} trägt;
R³¹, R³², R³³, R³⁴, R³⁵, R³⁶, R³⁷ und R³⁸ jeweils unabhängig aus Wasserstoff, Cyano, Brom und Chlor ausgewählt sind,
mit der Maßgabe, dass 1, 2, 3, 4, 5, 6, 7 oder 8 der Substituenten R³¹, R³², R³³, R³⁴, R³⁵, R³⁶, R³⁷ oder R³⁸ für Cyano stehen;
wobei
R³⁹ für Wasserstoff, C₁-C₁₀-Alkyl, C₂-C₁₀-Alkenyl, C₂-C₁₀-Alkinyl, C₃-C₁₂-Cycloalkyl oder C₆-C₁₄-Aryl steht, wobei
C₁-C₁₀-Alkyl, C₂-C₁₀-Alkenyl, C₂-C₁₀-Alkinyl unsubstituiert sind oder einen oder mehrere gleiche oder verschiedene Substituenten R^{3a} tragen,
C₃-C₁₂-Cycloalkyl unsubstituiert ist oder einen oder mehrere gleiche oder verschiedene Substituenten R^{3b} trägt und
C₆-C₁₄-Aryl unsubstituiert ist oder einen oder mehrere gleiche oder verschiedene Substituenten R^{3Ar} trägt;
R³¹⁰ und R³¹¹ jeweils unabhängig für Wasserstoff, C₁-C₁₀-Alkyl, C₂-C₁₀-Alkenyl, C₂-C₁₀-Alkinyl, C₃-C₁₂-Cycloalkyl oder C₆-C₁₄-Aryl stehen, wobei
C₁-C₁₀-Alkyl, C₂-C₁₀-Alkenyl, C₂-C₁₀-Alkinyl unsubstituiert sind oder einen oder mehrere gleiche oder verschiedene Substituenten R^{3a} tragen,
C₃-C₁₂-Cycloalkyl unsubstituiert ist oder einen oder mehrere gleiche oder verschiedene Substituenten R^{3b} trägt und
C₆-C₁₄-Aryl unsubstituiert ist oder einen oder mehrere gleiche oder verschiedene Substituenten R^{3Ar} trägt;
jedes Z^{3a} unabhängig für Halogen, Hydroxy, NR^{310a}R^{311a}, C₁-C₁₀-Alkoxy, C₁-C₁₀-Halogenalkoxy, C₁-C₁₀-Alkylthio, C₃-C₁₂-Cycloalkyl, C₆-C₁₄-Aryl, C(=O)R^{39a}; C(=O)OR^{39a} oder C(O)NR^{310a}R^{311a} steht, wobei
C₃-C₁₂-Cycloalkyl unsubstituiert ist oder einen oder mehrere gleiche oder verschiedene Substituenten R^{3b} trägt und
C₆-C₁₄-Aryl unsubstituiert ist oder einen oder mehrere gleiche oder verschiedene Substituenten R^{3Ar} trägt;
jedes Z^{3b} und jedes Z^{3Ar} unabhängig für Halogen, Hydroxy, NR^{310a}R^{311a}, C₁-C₁₀-Alkyl, C₁-C₁₀-Alkoxy, C₁-C₁₀-Halogenalkoxy, C₁-C₁₀-Alkylthio, C(=O)R^{39a}; C(=O)OR^{39a} oder C(O)NR^{310a}R^{311a} steht;
jedes R^{3a} unabhängig für Halogen, Hydroxy, C₁-C₁₀-Alkoxy, C₃-C₁₂-Cycloalkyl oder C₆-C₁₄-Aryl steht;
jedes R^{3b} unabhängig für Halogen, Hydroxy, C₁-C₁₀-Alkyl, C₁-C₁₀-Alkoxy, C₁-C₁₀-Halogenalkoxy, C₁-C₁₀-Alkylthio, C₂-C₁₀-Alkenyl, C₂-C₁₀-Alkinyl, C₃-C₁₂-Cycloalkyl oder C₆-C₁₄-Aryl steht; jedes R^{3Ar} unabhängig für Halogen, Hydroxy, C₁-C₁₀-Alkyl, C₁-C₁₀-Alkoxy, C₁-C₁₀-Halogenalkoxy, C₁-C₁₀-Alkylthio, C₂-C₁₀-Alkenyl, C₂-C₁₀-Alkinyl, C₃-C₁₂-Cycloalkyl oder C₆-C₁₄-Aryl steht;
R^{39a} für Wasserstoff, C₁-C₁₀-Alkyl, C₂-C₁₀-Alkenyl, C₂-C₁₀-Alkinyl, C₃-C₁₂-Cycloalkyl oder C₆-C₁₄-Aryl steht; und
R^{310a}, R^{311a} jeweils unabhängig für Wasserstoff, C₁-C₁₀-Alkyl, C₂-C₁₀-Alkenyl, C₂-C₁₀-Alkinyl, C₃-C₁₂-Cycloalkyl oder C₆-C₁₄-Aryl stehen,
oder Mischungen davon;
(B4) eine cyanierte Verbindung der Formel (IV) 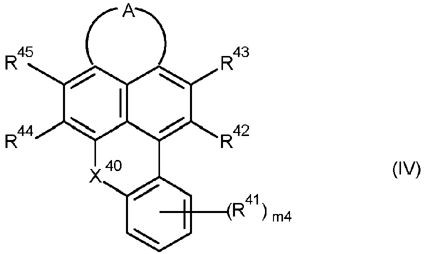 wobei
m4 für 0, 1, 2, 3 oder 4 steht;
R⁴¹ jeweils unabhängig voneinander aus Brom, Chlor, Cyano, -NR^{4a}R^{4b}, C₁-C₂₄-Alkyl, C₁-C₂₄-Halogenalkyl, C₁-C₂₄-Alkoxy, C₁-C₂₄-Halogenalkoxy, C₃-C₂₄-Cycloalkyl, Heterocycloalkyl, Heteroaryl, C₆-C₂₄-Aryl, C₆-C₂₄-Aryloxy und C₆-C₂₄-Aryl-C₁-C₁₀-alkylen ausgewählt ist, wobei die Ringe von Cycloalkyl, Heterocycloalkyl, Heteroaryl, Aryl und Aryloxy in den sechs letztgenannten Resten unsubstituiert oder durch 1, 2, 3, 4 oder 5 gleiche oder verschiedene Reste R^{41a} substituiert sind und wobei C₁-C₂₄-Alkyl, C₁-C₂₄-Halogenalkyl, C₁-C₂₄-Alkoxy und die Alkylengruppierung von C₆-C₂₄-Aryl-C₁-C₁₀-alkylen durch eine oder mehrere Gruppen, die aus O, S und NR^{4c} ausgewählt sind, unterbrochen sein können;
mindestens einer der Reste R⁴², R⁴³, R⁴⁴ und R⁴⁵ für CN steht und die übrigen Reste unabhängig voneinander aus Wasserstoff, Chlor und Brom ausgewählt sind;
X⁴⁰ für O, S, SO oder SO₂ steht;
A für einen zweiwertigen Rest steht, der aus zweiwertigen Resten der allgemeinen Formeln (A.1), (A.2), (A.3) und (A.4) ausgewählt ist 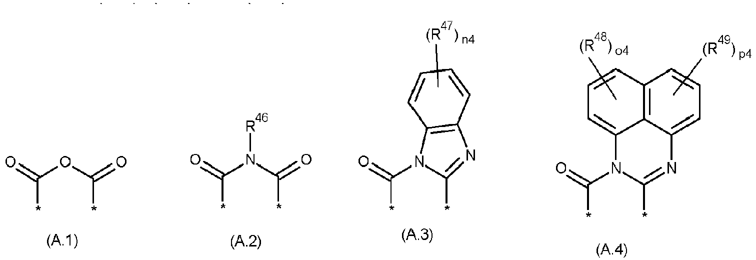 wobei
* in jedem Fall den Punkt von Verknüpfungen mit dem Rest des Moleküls anzeigt;
n4 für 0, 1, 2, 3 oder 4 steht;
o4 für 0, 1, 2 oder 3 steht;
p4 für 0, 1, 2 oder 3 steht;
R⁴⁶ für Wasserstoff, C₁-C₂₄-Alkyl, C₁-C₂₄-Halogenalkyl; C₃-C₂₄-Cycloalkyl, C₆-C₂₄-Aryl oder C₆-C₂₄-Aryl-C₁-C₁₀-alkylen steht, wobei die Ringe von Cycloalkyl, Aryl und Arylalkylen in den drei letztgenannten Resten unsubstituiert oder durch 1, 2, 3, 4 oder 5 gleiche oder verschiedene Reste R^{46a} substituiert sind und wobei C₁-C₂₄-Alkyl, C₁-C₂₄-Halogenalkyl und die Alkylengruppierung von C₆-C₂₄-Aryl-C₁-C₁₀-alkylen durch ein oder mehrere bzw. eine oder mehrere Heteroatome oder Heteroatomgruppen, die aus O, S und NR^{4c} ausgewählt sind, unterbrochen sein können;
R⁴⁷ jeweils unabhängig voneinander aus Brom, Chlor, Cyano, -NR^{4a}R^{4b}, C₁-C₂₄-Alkyl, C₁-C₂₄-Halogenalkyl, C₁-C₂₄-Alkoxy, C₁-C₂₄-Halogenalkoxy, C₃-C₂₄-Cycloalkyl, Heterocycloalkyl, Heteroaryl, C₆-C₂₄-Aryl, C₆-C₂₄-Aryloxy und C₆-C₂₄-Aryl-C₁-C₁₀-alkylen ausgewählt ist, wobei die Ringe von Cycloalkyl, Heterocycloalkyl, Heteroaryl, Aryl und Arylalkylen in den sechs letztgenannten Resten unsubstituiert oder durch 1, 2, 3, 4 oder 5 gleiche oder verschiedene Reste R^{47a} substituiert sind und wobei C₁-C₂₄-Alkyl, C₁-C₂₄-Halogenalkyl, C₁-C₂₄-Alkoxy, C₁-C₂₄-Halogenalkoxy und die Alkylengruppierung von C₆-C₂₄-Aryl-C₁-C₁₀-alkylen durch eine oder mehrere Gruppen, die aus O, S und NR^{4c} ausgewählt sind, unterbrochen sein können;
R⁴⁸ jeweils unabhängig voneinander aus Brom, Chlor, Cyano, NR^{4a}R^{4b}, C₁-C₂₄-Alkyl, C₁-C₂₄-Halogenalkyl, C₁-C₂₄-Alkoxy, C₁-C₂₄-Halogenalkoxy, C₃-C₂₄-Cycloalkyl, Heterocycloalkyl, Heteroaryl, C₆-C₂₄-Aryl, C₆-C₂₄-Aryloxy und C₆-C₂₄-Aryl-C₁-C₁₀-alkylen ausgewählt ist, wobei die Ringe von Cycloalkyl, Heterocycloalkyl, Heteroaryl, Aryl und Arylalkylen in den sechs letztgenannten Resten unsubstituiert oder
durch 1, 2, 3, 4 oder 5 gleiche oder verschiedene Reste R^{48a} substituiert sind und wobei C₁-C₂₄-Alkyl, C₁-C₂₄-Halogenalkyl, C₁-C₂₄-Alkoxy, C₁-C₂₄-Halogen-alkoxy und die Alkylengruppierung von C₆-C₂₄-Aryl-C₁-C₁₀-alkylen durch eine oder mehrere Gruppen, die aus O, S und NR^{4c} ausgewählt sind, unterbrochen sein können;
R⁴⁹ jeweils unabhängig voneinander aus Brom, Chlor, Cyano, NR^{4a}R^{4b}, C₁-C₂₄-Alkyl, C₁-C₂₄-Halogenalkyl, C₁-C₂₄-Alkoxy, C₁-C₂₄-Halogenalkoxy, C₃-C₂₄-Cycloalkyl, Heterocycloalkyl, Heteroaryl, C₆-C₂₄-Aryl, C₆-C₂₄-Aryloxy und C₆-C₂₄-Aryl-C₁-C₁₀-alkylen ausgewählt ist, wobei die Ringe von Cycloalkyl, Heterocycloalkyl, Heteroaryl, Aryl und Arylalkylen in den sechs letztgenannten Resten unsubstituiert oder durch 1, 2, 3, 4 oder 5 gleiche oder verschiedene Reste R^{49a} substituiert sind und wobei C₁-C₂₄-Alkyl, C₁-C₂₄-Halogenalkyl, C₁-C₂₄-Alkoxy, C₁-C₂₄-Halogen-alkoxy und die Alkylengruppierung von C₆-C₂₄-Aryl-C₁-C₁₀-alkylen durch eine oder mehrere Gruppen, die aus O, S und NR^{4c} ausgewählt sind, unterbrochen sein können;
R^{41a}, R^{46a}, R^{47a}, R^{48a} und R^{49a} unabhängig voneinander aus C₁-C₂₄-Alkyl, C₁-C₂₄-Fluoralkyl, C₁-C₂₄-Alkoxy, Fluor, Chlor und Brom ausgewählt sind;
R^{4a}, R^{4b} und R^{4c} unabhängig voneinander aus Wasserstoff, C₁-C₂₀-Alkyl, C₃-C₂₄-Cycloalkyl, Heterocycloalkyl, Heteroaryl und C₆-C₂₄-Aryl ausgewählt sind;
oder Mischungen davon;
(B5) eine Benz(othi)oxanthenverbindung der Formel (V) 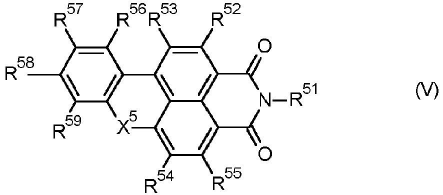 wobei
X⁵ für Sauerstoff oder Schwefel steht;
R⁵¹ für Phenyl, das unsubstituiert ist oder 1, 2, 3, 4 oder 5 Substituenten, die aus Halogen, R⁵¹¹, OR⁵⁵², NHR⁵⁵² und NR⁵⁵²R⁵⁵⁷ ausgewählt sind, trägt, steht;
R⁵², R⁵³, R⁵⁴, R⁵⁵, R⁵⁶, R⁵⁷, R⁵⁸ und R⁵⁹ unabhängig voneinander aus Wasserstoff, Halogen, R⁵⁵³, OR⁵⁵³, NHR⁵⁵³ und NR⁵⁵³R⁵⁵⁴ ausgewählt sind, wobei
R⁵¹¹ aus C₁-C₂₀-Alkyl, C₆-C₂₄-Aryl und Heteroaryl ausgewählt ist;
R⁵⁵² und R⁵⁵⁷ unabhängig voneinander aus C₁-C₁₈-Alkyl, C₆-C₂₄-Aryl und Heteroaryl ausgewählt sind; und
R⁵⁵³ und R⁵⁵⁴ unabhängig voneinander aus C₁-C₁₈-Alkyl, C₆-C₂₄-Aryl und Heteroaryl ausgewählt sind;
oder Mischungen davon;
(B6) eine Benzimidazoxanthenisochinolin-Verbindung der Formeln (VIA) oder (VIB) 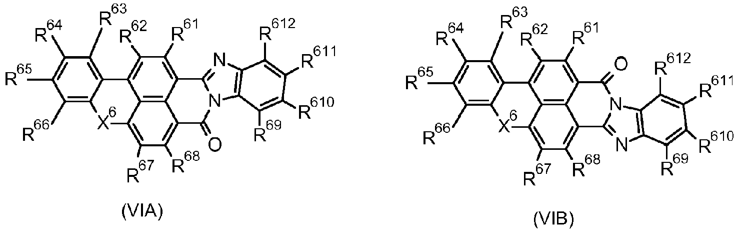 wobei
X⁶ für Sauerstoff oder Schwefel steht;
R⁶¹, R⁶², R⁶³, R⁶⁴, R⁶⁵, R⁶⁶, R⁶⁷, R⁶⁸, R⁶⁹, R⁶¹⁰, R⁶¹¹ und R⁶¹² unabhängig voneinander aus Wasserstoff, Halogen, R⁶⁶¹, OR⁶⁶¹, NHR⁶⁶¹ und NR⁶⁶¹R⁶⁶² ausgewählt sind;
wobei
R⁶⁶¹ jeweils aus C₁-C₁₈-Alkyl, C₆-C₂₄-Aryl und
Heteroaryl ausgewählt ist; und
R⁶⁶² jeweils aus C₁-C₁₈-Alkyl, C₆-C₂₄-Aryl und
Heteroaryl ausgewählt ist;
oder Mischungen davon;
(B7) eine fluoreszierende Verbindung mit mindestens einer Struktureinheit der Formel (VII) 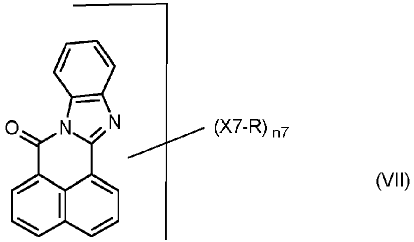 wobei
eine oder mehrere CH-Gruppen des sechsgliedrigen Rings der dargestellten Benzimidazolstruktur durch Stickstoff ersetzt sein können und wobei die Symbole jeweils folgende Bedeutung haben:
n7 für jede Struktureinheit der Formel (VII) eine Zahl von 0 bis (10-p7) ; wobei p7 die Zahl der CH-Einheiten ist, die in dem sechsgliedrigen Ring der dargestellten Benzimidazolstruktur durch Stickstoff ersetzt wurden;
X7 eine chemische Bindung, O, S, SO, SO₂, NR⁷¹; und R aliphatischer Rest, cycloaliphatischer Rest, Aryl, Heteroaryl, die jeweils Substituenten tragen können,
aromatischer oder heteroaromatischer Ring oder automatisches oder heteroaromatisches Ringsystem, der bzw. das jeweils an andere aromatische Ringe der Struktureinheit der Formel (VII) annelliert ist;
F, Cl, Br, CN, H, wenn X7 keine chemische Bindung ist;
wobei zwei Reste R zu einem cyclischen Rest verbunden sein können und
wobei X7 und R für n7 > eins gleich oder verschieden sein können;
R⁷¹ jeweils unabhängig Wasserstoff, C₁-C₁₈-Alkyl oder Cycloalkyl, dessen Kohlenstoffkette eine oder mehrere -O-, -S-, -CO-, -SO- und/oder -SO₂-Gruppierungen enthalten kann und das ein- oder mehrfach substituiert sein kann;
Aryl oder Heteroaryl, das ein- oder mehrfach substituiert sein kann;
oder Mischungen davon;
(B8) eine Perylen-Verbindung der Formeln (VIII) oder (IX) 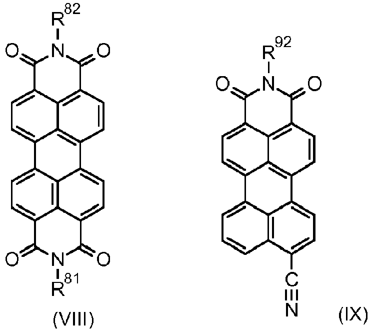 wobei
R⁸¹ und R⁸² jeweils unabhängig für C₁-C₃₀-Alkyl, C₂-C₃₀-Alkyl, das durch ein oder mehrere Sauerstoffatome unterbrochen ist, C₃-C₈-Cycloalkyl, C₆-C₁₀-Aryl, Heteroaryl oder C₆-C₁₀-Aryl-C₁-C₁₀-alkylen stehen, wobei der aromatische Ring in den drei letztgenannten Resten unsubstituiert oder ein-oder mehrfach durch C₁-C₁₀-Alkyl substituiert ist; R⁹² für C₁-C₃₀-Alkyl, C₃-C₈-Cycloalkyl, Aryl, Heteroaryl oder Aryl-C₁-C₁₀-alkylen steht, wobei der aromatische Ring in den drei letztgenannten Resten unsubstituiert oder ein- oder mehrfach durch C₁-C₁₀-Alkyl substituiert ist;
(B9) eine Naphthalinmonoimid-Verbindung der Formel (X) 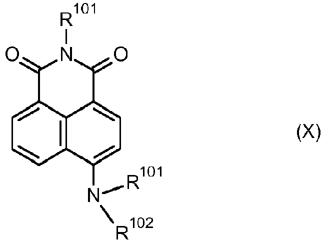 wobei
R¹⁰¹ jeweils unabhängig voneinander für Wasserstoff, C₁-C₃₀-Alkyl, C₂-C₃₀-Alkyl, das durch ein oder mehrere Sauerstoffatome unterbrochen ist, C₃-C₈-Cycloalkyl, C₆-C₁₀-Aryl, Heteroaryl oder C₆-C₁₀-Aryl-C₁-C₁₀-alkylen stehen, wobei der aromatische Ring in den drei letztgenannten Resten unsubstituiert oder ein- oder mehrfach durch C₁-C₁₀-Alkyl substituiert ist;
R¹⁰² für Wasserstoff, C₁-C₃₀-Alkyl, C₂-C₃₀-Alkyl, das durch ein oder mehrere Sauerstoffatome unterbrochen ist, C₃-C₈-Cycloalkyl, C₆-C₁₀-Aryl, Heteroaryl oder C₆-C₁₀-Aryl-C₁-C₁₀-alkylen steht, wobei der aromatische Ring in den drei letztgenannten Resten unsubstituiert oder ein-oder mehrfach durch C₁-C₁₀-Alkyl substituiert ist; (B10) 7-(Diethylamino)-3-(5-methylbenzo[d]xazol-2-yl)-2H-chromen-2-on;
(B11) eine Perylen-Verbindung der Formeln (XIA) oder (XIB) 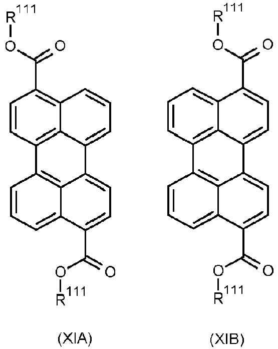 wobei
R¹¹¹ jeweils unabhängig voneinander für C₁-C₁₈-Alkyl, C₄-C₈-Cycloalkyl, das ein- oder mehrfach durch Halogen oder durch lineares oder verzweigtes C₁-C₁₈-Alkyl substituiert sein kann, oder Phenyl oder Naphthyl, das ein- oder mehrfach durch Halogen oder durch lineares oder verzweigtes C₁-C₁₈-Alkyl substituiert sein kann, steht;
oder Mischungen davon;
(B12) eine cyanierte Perylen-Verbindung der Formeln (XIIA) oder (XIIB) 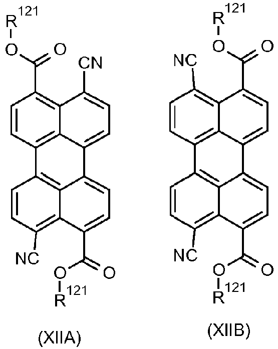 wobei
R¹²¹ jeweils unabhängig voneinander für C₁-C₁₈-Alkyl, C₄-C₈-Cycloalkyl, das ein- oder mehrfach durch Halogen oder durch lineares oder verzweigtes C₁-C₁₈-Alkyl substituiert sein kann, oder Phenyl oder Naphthyl, das ein- oder mehrfach durch Halogen oder durch lineares oder verzweigtes C₁-C₁₈-Alkyl substituiert sein kann, steht;
oder Mischungen davon;
(B13) eine Perylenbisimid-Verbindung der Formel (XIII) 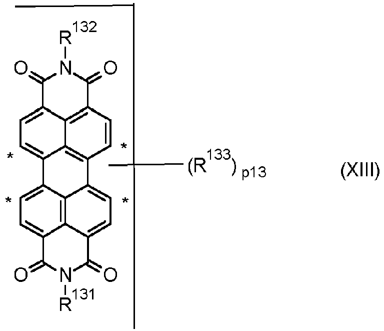 wobei
p13 für 1, 2, 3 oder 4 steht;
R¹³¹ und R¹³² unabhängig voneinander für C₁-C₁₀-Alkyl, das unsubstituiert oder durch C₆-C₁₀-Aryl, das wiederum unsubstituiert oder durch 1, 2 oder 3 C₁-C₁₀-Alkyl substituiert ist, substituiert ist, C₂-C₂₀-Alkyl, das durch ein oder mehrere Sauerstoffatome unterbrochen ist,
C₃-C₈-Cycloalkyl, das unsubstituiert oder durch 1, 2 oder 3 C₁-C₁₀-Alkyl substituiert ist, oder C₆-C₁₀-Aryl, das unsubstituiert oder durch 1, 2 oder 3 C₁-C₁₀-Alkyl substituiert ist,
stehen;
R¹³³ jeweils unabhängig voneinander für Fluor, Chlor, C₁-C₁₆-Alkyl, C₂-C₁₆-Alkyl, das durch ein oder mehrere Sauerstoffatome unterbrochen ist, C₁-C₁₆-Alkoxy, C₆-C₁₀-Aryloxy, das unsubstituiert oder ein- oder mehrfach durch Fluor, Chlor, C₁-C₁₆-Alkyl, C₂-C₁₆-Alkyl, das durch ein oder mehrere Sauerstoffatome unterbrochen ist, C₁-C₁₆-Alkoxy oder C₆-C₁₀-Aryl, das unsubstituiert oder durch 1, 2 oder 3 Reste, die aus C₁-C₆-Alkyl, C₁-C₆-Alkoxy-C₁-C₆-alkyl und C₁-C₆-Alkoxy ausgewählt sind, substituiert ist, steht, wobei sich die R¹³³-Reste an den mit * bezeichneten Positionen befinden;
oder Mischungen davon;
(B14) eine Perylen-Verbindung der Formel (XIV) 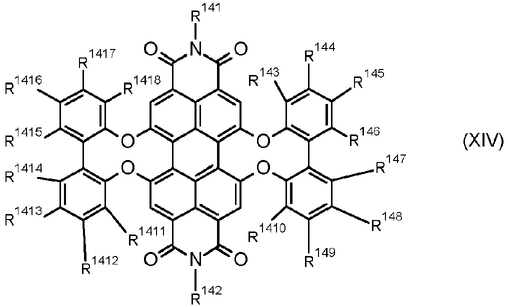 wobei
R¹⁴¹ und R¹⁴² unabhängig voneinander aus Wasserstoff,
jeweils unsubstituiertem oder substituiertem C₁-C₃₀-Alkyl, Polyalkylenoxy, C₁-C₃₀-Alkoxy, C₁-C₃₀-Alkylthio, C₃-C₂₀-Cycloalkyl, C₃-C₂₀-Cycloalkyloxy, C₆-C₂₄-Aryl und C₆-C₂₄-Aryloxy
ausgewählt sind;
R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ und R¹⁴¹⁸ unabhängig voneinander aus Wasserstoff, Halogen, Cyano, Hydroxy, Mercapto, Nitro, -NE¹⁴¹E¹⁴², -NR^{Ar141}COR^{Ar142}, -CONR^{Ar141}R^{Ar142}, -SO₂NR^{Ar141}R^{Ar142}, -COOR^{Ar141}, -SO₃R^{Ar142},
jeweils unsubstituiertem oder substituiertem C₁-C₃₀-Alkyl, Polyalkylenoxy, C₁-C₃₀-Alkoxy, C₁-C₃₀-Alkylthio, C₃-C₂₀-Cycloalkyl, C₃-C₂₀-Cycloalkoxy, C₆-C₂₄-Aryl, C₆-C₂₄-Aryloxy und C₆-C₂₄-Arylthio ausgewählt sind,
wobei R¹⁴³ und R¹⁴⁴, R¹⁴⁴ und R¹⁴⁵, R¹⁴⁵ und R¹⁴⁶, R¹⁴⁶ und R¹⁴⁷, R¹⁴⁷ und R¹⁴⁸, R¹⁴⁸ und R¹⁴⁹, R¹⁴⁹ und R¹⁴¹⁰, R¹⁴¹¹ und R¹⁴¹², R¹⁴¹² und R¹⁴¹³, R¹⁴¹³ und R¹⁴¹⁴, R¹⁴¹⁴ und R¹⁴¹⁵, R¹⁴¹⁵ und R¹⁴¹⁶, R¹⁴¹⁶ und R¹⁴¹⁷ und/oder R¹⁴¹⁷ und R¹⁴¹⁸ zusammen mit den Kohlenstoffatomen der Biphenylylgruppierung, an die sie gebunden sind, auch ein weiteres anelliertes aromatisches oder nichtaromatisches Ringsystem bilden können, wobei das anellierte Ringsystem unsubstituiert oder substituiert ist;
wobei
E¹⁴¹ und E¹⁴² unabhängig für Wasserstoff, unsubstituiertes oder substituiertes C₁-C₁₈-Alkyl, unsubstituiertes oder substituiertes C₂-C₁₈-Alkenyl, unsubstituiertes oder substituiertes C₂-C₁₈-Alkinyl, unsubstituiertes oder substituiertes C₃-C₂₀-Cycloalkyl oder unsubstituiertes oder substituiertes C₆-C₁₀-Aryl stehen;
R^{Ar141} und R^{Ar142} jeweils unabhängig für Wasserstoff, unsubstituiertes oder substituiertes C₁-C₁₈-Alkyl, unsubstituiertes oder substituiertes C₃-C₂₀-Cycloalkyl, unsubstituiertes oder substituiertes Heterocyclyl, unsubstituiertes oder substituiertes C₆-C₂₀-Aryl oder unsubstituiertes oder substituiertes Heteroaryl stehen;
oder Mischungen davon;
(B15) eine 3,4:9,10-Perylentetracarbonsäurediimid-Verbindung mit mindestens einer ersten Gruppe (XVa) und einer zweiten Gruppe (XVb),
wobei die erste Gruppe (XVa) eine oder mehrere Gruppen auf Basis von einer oder mehreren von Verbindung (V), Verbindung (X), Verbindung (XIA), Verbindung (XIB), 7-(Diethylamino)-3-(6-methyl-benzo[d]oxazol-2-yl)-2H-chromen-2-on oder Verbindungen der Formel (XVa1) 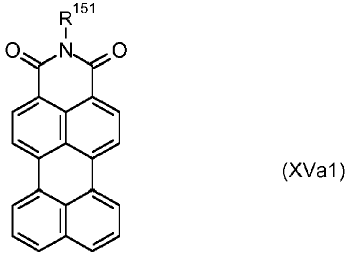 umfasst,
wobei
R¹⁵¹ für C₁-C₁₀-Alkyl, das unsubstituiert oder durch C₆-C₁₀-Aryl, das wiederum unsubstituiert oder durch 1, 2 oder 3 C₁-C₁₀-Alkyl substituiert ist, substituiert ist,
C₂-C₂₀-Alkyl, das durch ein oder mehrere Sauerstoffatome unterbrochen ist,
C₃-C₈-Cycloalkyl, das unsubstituiert oder durch 1, 2 oder 3 C₁-C₁₀-Alkyl substituiert ist, oder C₆-C₁₀-Aryl, das unsubstituiert oder durch 1, 2 oder 3 C₁-C₁₀-Alkyl substituiert ist,
steht;
und wobei es sich bei der zweiten Gruppe (XVb) um 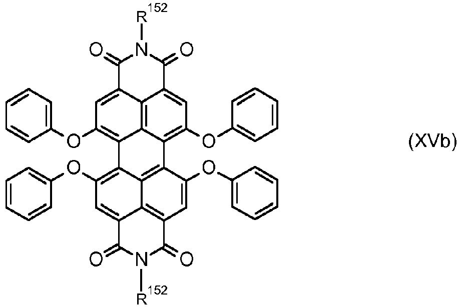 handelt,
wobei
R¹⁵² unabhängig voneinander aus Wasserstoff, C₁-C₁₀-Alkyl, das unsubstituiert oder durch C₆-C₁₀-Aryl, das wiederum unsubstituiert oder durch 1, 2 oder 3 C₁-C₁₀-Alkyl substituiert ist, substituiert ist,
C₂-C₂₀-Alkyl, das durch ein oder mehrere Sauerstoffatome unterbrochen ist,
C₃-C₈-Cycloalkyl, das unsubstituiert oder durch 1, 2 oder 3 C₁-C₁₀-Alkyl substituiert ist, oder C₆-C₁₀-Aryl, das unsubstituiert oder durch 1, 2 oder 3 C₁-C₁₀-Alkyl oder eine Gruppe (XVb1) 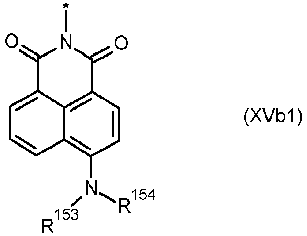 substituiert ist, wobei
* die Bindungsstelle an den Rest des Moleküls anzeigt;
steht;
R¹⁵³ und R¹⁵⁴ unabhängig voneinander aus Wasserstoff, C₁-C₃₀-Alkyl, C₂-C₃₀-Alkenyl, C₂-C₃₀-Alkinyl, C₃-C₁₂-Cycloalkyl und C₆-C₂₄-Aryl ausgewählt ist, wobei die beiden letztgenannten Reste unsubstituiert sind oder einen, zwei oder drei Reste, die aus C₁-C₁₀-Alkyl ausgewählt sind, tragen.

6. Farbkonverter nach einem der vorhergehenden Ansprüche, umfassend eine Mischung von mindestens zwei organischen Fluoreszenzfarbmitteln (B) gemäß Anspruch 5, wobei die mindestens zwei organischen Fluoreszenzfarbmittel (B) zu mindestens zwei verschiedenen Klassen von organischen Fluoreszenzfarbmitteln (B1), (B2), (B3), (B4), (B5), (B6), (B7), (B8), (B9), (B10), (B11), (B12), (B13), (B14) oder (B15) gehören.

7. Farbkonverter nach Anspruch 5 oder 6, umfassend mindestens eine Perylenbisimid-Verbindung der Formel (XIII) als organisches Fluoreszenzfarbmittel.

8. Farbkonverter nach einem der Ansprüche 5 bis 7, umfassend mindestens eine Verbindung mit mindestens einer Struktureinheit der Formel (VII) als organisches Fluoreszenzfarbmittel.

9. Farbkonverter nach einem der Ansprüche 5 bis 8, umfassend mindestens eine Verbindung, die aus den Verbindungen der Formel (VIII), der Verbindung der Formel (IX), den Verbindungen der Formeln (XIA) und (XIB), den Verbindungen der Formeln (XIIA) und (XIIB) und Mischungen davon ausgewählt ist, als organisches Fluoreszenzfarbmittel.

10. Farbkonverter nach einem der vorhergehenden Ansprüche, umfassend mindestens ein lumineszierendes Material, das aus Granaten, Silicaten, Sulfiden, Nitriden und Oxidnitriden und Quantenpunkten ausgewählt ist.

11. Farbkonverter nach einem der vorhergehenden Ansprüche, ferner umfassend mindestens ein anorganisches Weißpigment als Streukörper, vorzugsweise Titandioxid.

12. Verwendung eines Farbkonverters nach einem der vorhergehenden Ansprüche zur Konvertierung von von einer blauen LED mit einer Emissionsmittenwellenlänge zwischen 400 nm und 480 nm erzeugtem Licht zur Bereitstellung von weißem Licht mit einer korrigierten Farbtemperatur zwischen 2000 K und 20.000 K oder zur Konvertierung von durch eine kaltweiße LED mit einer korrelierten Farbtemperatur zwischen 3000 K und 20.000 K erzeugtem Licht zur Bereitstellung von weißem Licht mit einer niedrigeren korrelierten Farbtemperatur.

13. Polymermischung, umfassend mindestens einen 2,5-Furandicarboxylat-Polyester (A), der durch Umsetzen von (i) mindestens einem Diol, das aus einem aliphatischen C₂-C₂₀-Diol und einem cycloaliphatischen C₃-C₂₀-Diol ausgewählt ist, mit (ii) 2,5-Furandicarbonsäure und/oder einem esterbildenden Derivat davon und (iii) gegebenenfalls mindestens einer weiteren Dicarbonsäure, die aus 1,2-Cyclohexandicarbonsäure, 1,4-Cyclohexandicarbonsäure, 3,4-Furandicarbonsäure, Terephthalsäure und 2,6-Naphthalinsäure und/oder einem esterbildenden Derivat davon ausgewählt ist, erhältlich ist, und mindestens ein lumineszierendes Material, insbesondere mindestens ein organisches Fluoreszenzfarbmittel (B) gemäß einem der Ansprüche 5 bis 9.

14. Beleuchtungsvorrichtung, umfassend
(i) mindestens eine LED, die aus einer blauen LED mit einer Emissionsmittenwellenlänge zwischen 400 nm und 480 nm und einer kaltweißen LED mit einer korrelierten Farbtemperatur zwischen 3000 K und 20.000 K ausgewählt ist; und
(ii) mindestens einen Farbkonverter gemäß einem der Ansprüche 1 bis 11,
wobei sich der mindestens eine Farbkonverter in einer entfernten Anordnung von der mindestens einen LED befindet.

15. Vorrichtung, die bei Beleuchtung Strom erzeugt, mit einer Photovoltaikzelle und dem Farbkonverter gemäß einem der Ansprüche 1 bis 11, wobei mindestens ein Teil des nicht von der Photovoltaikzelle absorbierten Lichts von dem Farbkonverter absorbiert wird.

## Revendications

1. Convertisseur de couleur comprenant
- un matériau de matrice polymérique comprenant au moins un polyester de 2,5-furannedicarboxylate (A) qui peut être obtenu par la mise en réaction (i) d'au moins un diol choisi parmi un C₂-C₂₀-diol aliphatique et un C₃-C₂₀-diol cycloaliphatique, avec (ii) l'acide 2,5-furannedicarboxylique et/ou un dérivé de formation d'ester correspondant et (iii) éventuellement au moins un acide dicarboxylique supplémentaire choisi parmi l'acide 1,2-cyclohexanedicarboxylique, l'acide 1,4-cyclohexanedicarboxylique, l'acide 3,4-furannedicarboxylique, l'acide téréphtalique et l'acide 2,6-naphtalique et/ou un dérivé de formation d'ester correspondant ; et
- au moins un matériau luminescent.

2. Convertisseur de couleur selon la revendication 1, le polyester de 2,5-furannedicarboxylate (A) étant choisi parmi un poly(éthylène-2,5-furannedicarboxylate), un poly(propylène-2,5-furannedicarboxylate), un poly(éthylène-co-propylène-2,5-furannedicarboxylate), un poly(butylène-2,5-furannedicarboxylate), un poly(pentylène-2,5-furannedicarboxylate), un poly(néopentylène-2,5-furannedicarboxylate) et des mélanges correspondants, préférablement un poly(éthylène-2,5-furannedicarboxylate).

3. Convertisseur de couleur selon la revendication 1, le polyester de 2,5-furannedicarboxylate (A) étant un poly(éthylène-2,5-furannedicarboxylate-co-téréphtalate), un poly(éthylène-2,5-furannedicarboxylate-co-2,6-naphtalate) ou un poly(éthylène-2,5-furannedicarboxylate-co-3,4-furannedicarboxylate).

4. Convertisseur de couleur selon l'une quelconque des revendications précédentes, le matériau de matrice polymérique étant un mélange d'au moins deux polyesters, un premier polyester qui est un poly(éthylène-2,5-furannedicarboxylate) et au moins un deuxième polyester qui est choisi parmi un poly(téréphtalate d'éthylène), un poly(téréphtalate de butylène), un poly(2,6-naphtalate d'éthylène), un poly(2,6-naphtalate de butylène) et un poly(propylène-2,5-furannedicarboxylate).

5. Convertisseur de couleur selon l'une quelconque des revendications précédentes, l'au moins un matériau luminescent étant un colorant fluorescent organique choisi parmi (B1), (B2), (B3), (B4), (B5), (B6), (B7), (B8), (B9), (B10), (B11), (B12), (B13), (B14), (B15) et des mélanges correspondants, (B1), (B2), (B3), (B4), (B5), (B6), (B7), (B8), (B9), (B10), (B11), (B12), (B13), (B14) et (B15) étant définis comme suit :
(B1) un composé de type naphtoylbenzimidazole de formule (I) 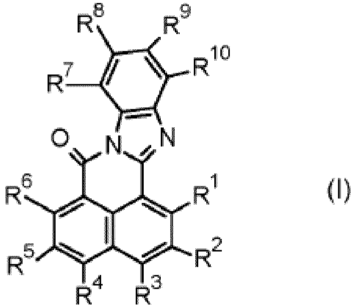
au moins l'un parmi les radicaux R¹, R², R³, R⁴, R⁵, R⁶, R⁷, R⁸, R⁹ et R¹⁰,
indépendamment les uns des autres, étant aryle qui porte un, deux ou trois groupes cyano et 0, 1, 2, 3 ou 4 substituants R^{Ar} et les radicaux restants R¹, R², R³, R⁴, R⁵, R⁶, R⁷, R⁸, R⁹ et R¹⁰, indépendamment les uns des autres, étant choisis parmi hydrogène et aryle qui est non substitué ou porte 1, 2, 3, 4 ou 5 substituants R^{Ar},
où
R^{Ar} indépendamment les uns des autres et indépendamment de chaque occurrence est choisi parmi halogène, C₁-C₃₀-alkyle, C₂-C₃₀-alcényle, C₂-C₃₀-alcynyle, où les trois derniers radicaux sont non substitués ou portent un ou plusieurs groupes R^{a}, C₃-C₈-cycloalkyle, hétérocyclyle à 3 à 8 chaînons, où les deux derniers radicaux sont non substitués ou portent un ou plusieurs groupes R^{b} ; aryle et hétéroaryle, où les deux derniers radicaux sont non substitués ou portent un ou plusieurs groupes R^{c}, où
R^{a} indépendamment les uns des autres et indépendamment de chaque occurrence est choisi parmi cyano, halogène, C₃-C₈-cycloalkyle, hétérocyclyle à 3 à 8 chaînons, aryle et hétéroaryle, où C₃-C₈-cycloalkyle, hétérocyclyle à 3 à 8 chaînons sont non substitués ou portent un ou plusieurs groupes R^{b1}, et où aryle et hétéroaryle sont non substitués ou portent un ou plusieurs groupes R^{c1} ;
R^{b} indépendamment les uns des autres et indépendamment de chaque occurrence est choisi parmi cyano, halogène, C₁-C₁₈-alkyle, C₃-C₈-cycloalkyle, hétérocyclyle à 3 à 8 chaînons, aryle et hétéroaryle, où C₃-C₈-cycloalkyle, hétérocyclyle à 3 à 8 chaînons sont non substitués ou portent un ou plusieurs groupes R^{b1}, et où aryle et hétéroaryle sont non substitués ou portent un ou plusieurs groupes R^{c1} ;
R^{c} indépendamment les uns des autres et indépendamment de chaque occurrence est choisi parmi cyano, halogène, C₁-C₁₈-alkyle, C₃-C₈-cycloalkyle, hétérocyclyle à 3 à 8 chaînons, aryle et hétéroaryle, où C₃-C₈-cycloalkyle, hétérocyclyle à 3 à 8 chaînons sont non substitués ou portent un ou plusieurs groupes R^{b1}, et où aryle et hétéroaryle sont non substitués ou portent un ou plusieurs groupes R^{c1} ;
R^{b1} indépendamment les uns des autres et indépendamment de chaque occurrence est choisi parmi halogène, C₁-C₁₈-alkyle et C₁-C₁₈-halogénoalkyle ;
R^{c1} indépendamment les uns des autres et indépendamment de chaque occurrence est choisi parmi halogène, C₁₋₁₈-alkyle et C₁₋₁₈-halogénoalkyle ;
ou des mélanges correspondants ;
(B2) un composé de type naphtoylbenzimidazole cyanaté de formule (II) 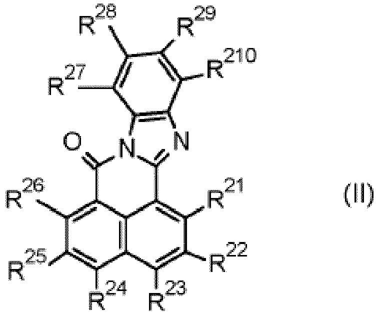
R²¹, R²², R²³, R²⁴, R²⁵, R²⁶, R²⁷, R²⁸, R²⁹ et R²¹⁰ étant chacun indépendamment hydrogène, cyano ou aryle qui est non substitué ou possède un ou plusieurs substituants identiques ou différents R^{2Ar},
où
chaque R^{2Ar} est indépendamment choisi parmi cyano, hydroxyle, mercapto, halogène, C₁-C₂₀-alcoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₃₀-alkyle, C₂-C₃₀-alcényle, C₂-C₃₀-alcynyle, où les trois derniers radicaux sont non substitués ou portent un ou plusieurs groupes R^{2a},
C₃-C₈-cycloalkyle, hétérocyclyle à 3 à 8 chaînons, où les deux derniers radicaux sont non substitués ou portent un ou plusieurs groupes R^{2b},
aryle, U-aryle, hétéroaryle et U-hétéroaryle, où les quatre derniers radicaux sont non substitués ou portent un ou plusieurs groupes R^{2b},
où
chaque R^{2a} est indépendamment choisi parmi cyano, hydroxyle, oxo, mercapto, halogène, C₁-C₂₀-alcoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₃-C₈-cycloalkyle, hétérocyclyle à 3 à 8 chaînons, aryle et hétéroaryle, où les radicaux cycloalkyle, hétérocyclyle, aryle et hétéroaryle sont non substitués ou portent un ou plusieurs groupes R^{2b} ;
chaque R^{2b} est indépendamment choisi parmi cyano, hydroxyle, oxo, mercapto, halogène, C₁-C₂₀-alcoxy, C₁-C₂₀-alkylthio, nitro, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, C₁-C₁₈-alkyle, C₂-C₁₈-alcényle, C₂-C₁₈-alcynyle, C₃-C₈-cycloalkyle, hétérocyclyle à 3 à 8 chaînons, aryle et hétéroaryle, où les quatre derniers radicaux sont non substitués ou portent un ou plusieurs groupes R^{2b1},
chaque R^{2b1} est indépendamment choisi parmi cyano, hydroxyle, mercapto, oxo, nitro, halogène, -NR^{2Ar2}R^{2Ar3}, -NR^{2Ar2}COR^{2Ar3}, -CONR^{2Ar2}R^{2Ar3}, -SO₂NR^{2Ar2}R^{2Ar3}, -COOR^{2Ar2}, -SO₃R^{2Ar2}, -SO₃R^{2Ar2}, C₁-C₁₈-alkyle, C₂-C₁₈-alcényle, C₂-C₁₈-alcynyle, C₁-C₁₂-alcoxy et C₁-C₁₂-alkyl thio
U est un fragment -O-, -S-, -NR^{2Ar1}-, -CO-, -SO- ou -SO₂- ;
R^{2Ar1}, R^{2Ar2}, R^{2Ar3} sont chacun indépendamment hydrogène, C₁-C₁₈-alkyle, cycloalkyle à 3 à 8 chaînons, hétérocyclyle à 3 à 8 chaînons, aryle ou hétéroaryle, où alkyle est non substitué ou porte un ou plusieurs groupes R^{2a}, où cycloalkyle à 3 à 8 chaînons, hétérocyclyle à 3 à 8 chaînons, aryle et hétéroaryle sont non substitués ou portent un ou plusieurs groupes R^{2b} ;
étant entendu que le composé de formule II comprend au moins un groupe cyano,
ou des mélanges correspondants ;
(B3) un composé de type pérylène cyanaté de formule (III) 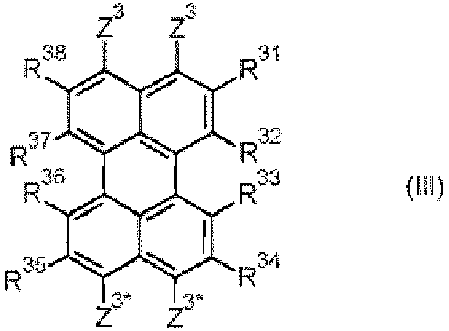 dans laquelle
un des substituants Z³ est cyano et l'autre substituant Z³ est CO₂R³⁹, CONR³¹⁰R³¹¹, C₁-C₁₈-alkyle, C₂-C₁₈-alcényle, C₂-C₁₈-alcynyle, C₃-C₁₂-cycloalkyle ou C₆-C₁₄-aryle, où C₁-C₁₈-alkyle, C₂-C₁₈-alcényle, C₂-C₁₈-alcynyle sont non substitués ou portent un ou plusieurs substituants identiques ou différents Z^{3a},
C₃-C₁₂-cycloalkyle est non substitué ou porte un ou plusieurs substituants identiques ou différents Z^{3b}, et C₆-C₁₄-aryle est non substitué ou porte un ou plusieurs substituants identiques ou différents Z^{3Ar} ;
un des substituants Z³* est cyano et l'autre substituant Z³* est CO₂R³⁹, CONR³¹⁰R³¹¹, C₁-C₁₈-alkyle, C₂-C₁₈-alcényle, C₂-C₁₈-alcynyle, C₃-C₁₂-cycloalkyle ou C₆-C₁₄-aryle, où
C₁-C₁₈-alkyle, C₂-C₁₈-alcényle, C₂-C₁₈-alcynyle sont non substitués ou portent un ou plusieurs substituants identiques ou différents Z^{3a},
C₃-C₁₂-cycloalkyle est non substitué ou porte un ou plusieurs substituants identiques ou différents Z^{3b}, et C₆-C₁₄-aryle est non substitué ou porte un ou plusieurs substituants identiques ou différents Z^{3Ar} ;
R³¹, R³², R³³, R³⁴, R³⁵, R³⁶, R³⁷ et R³⁸ sont chacun choisis indépendamment parmi hydrogène, cyano, brome et chlore,
étant entendu que 1, 2, 3, 4, 5, 6, 7 ou 8 des substituants R³¹, R³², R³³, R³⁴, R³⁵, R³⁶, R³⁷ et R³⁸ sont cyano ;
où
R³⁹ est hydrogène, C₁-C₁₀-alkyle, C₂-C₁₀-alcényle, C₂-C₁₀-alcynyle, C₃-C₁₂-cycloalkyle ou C₆-C₁₄-aryle, où
C₁-C₁₀-alkyle, C₂-C₁₀-alcényle, C₂-C₁₀-alcynyle sont non substitués ou portent un ou plusieurs substituants identiques ou différents R^{3a},
C₃-C₁₂-cycloalkyle est non substitué ou porte un ou plusieurs substituants identiques ou différents R^{3b}, et C₆-C₁₄-aryle est non substitué ou porte un ou plusieurs substituants identiques ou différents R^{3Ar} ;
R³¹⁰ et R³¹¹ sont chacun indépendamment hydrogène, C₁-C₁₀-alkyle, C₂-C₁₀-alcényle, C₂-C₁₀-alcynyle, C₃-C₁₂-cycloalkyle ou C₆-C₁₄-aryle, où
C₁-C₁₀-alkyle, C₂-C₁₀-alcényle, C₂-C₁₀-alcynyle sont non substitués ou portent un ou plusieurs substituants identiques ou différents R^{3a},
C₃-C₁₂-cycloalkyle est non substitué ou porte un ou plusieurs substituants identiques ou différents R^{3b}, et
C₆-C₁₄-aryle est non substitué ou porte un ou plusieurs substituants identiques ou différents R^{3Ar} ;
chaque Z^{3a} est indépendamment halogène, hydroxyle, NR^{310a}R^{311a}, C₁₋C₁₀-alcoxy, C₁-C₁₀-halogénoalcoxy, C₁-C₁₀-alkylthio, C₃-C₁₂-cycloalkyle, C₆-C₁₄-aryle, C(=O)R^{39a}; C(=O)OR^{39a} ou C(O)NR^{310a}R^{311a}, où
C₃-C₁₂-cycloalkyle est non substitué ou porte un ou plusieurs substituants identiques ou différents R^{3b}, et C₆-C₁₄-aryle est non substitué ou porte un ou plusieurs substituants identiques ou différents R^{3Ar} ;
chaque Z^{3b} et chaque Z^{3Ar} est indépendamment halogène, hydroxyle, NR^{310a}R^{311a}, C₁-C₁₀-alkyle, C₁₋C₁₀-alcoxy, C₁-C₁₀-halogénoalcoxy, C₁-C₁₀-alkylthio, C(=O)R^{39a}; C(=O)OR^{39a} ou C(O)NR³¹⁰aR^{311a} ;
chaque R^{3a} est indépendamment halogène, hydroxyle, C₁₋C₁₀-alcoxy, C₃-C₁₂-cycloalkyle ou C₆-C₁₄-aryle ;
chaque R^{3b} est indépendamment halogène, hydroxyle, C₁-C₁₀-alkyle, C₁₋C₁₀-alcoxy, C₁-C₁₀-halogénoalcoxy, C₁-C₁₀-alkylthio, C₂-C₁₀-alcényle, C₂-C₁₀-alcynyle, C₃-C₁₂-cycloalkyle ou C₆-C₁₄-aryle ;
chaque R^{3Ar} est indépendamment halogène, hydroxyle, C₁-C₁₀-alkyle, C₁₋C₁₀-alcoxy, C₁-C₁₀-halogénoalcoxy, C₁-C₁₀-alkylthio, C₂-C₁₀-alcényle, C₂-C₁₀-alcynyle, C₃-C₁₂-cycloalkyle ou C₆-C₁₄-aryle ;
R^{39a} est hydrogène, C₁-C₁₀-alkyle, C₂-C₁₀-alcényle, C₂-C₁₀-alcynyle, C₃-C₁₂-cycloalkyle ou C₆-C₁₄-aryle et
R^{310a}, R^{311a} sont chacun indépendamment hydrogène, C₁-C₁₀-alkyle, C₂-C₁₀-alcényle, C₂-C₁₀-alcynyle, C₃-C₁₂-cycloalkyle ou C₆-C₁₄-aryle ;
ou des mélanges correspondants ;
(B4) un composé cyanaté de formule (IV) 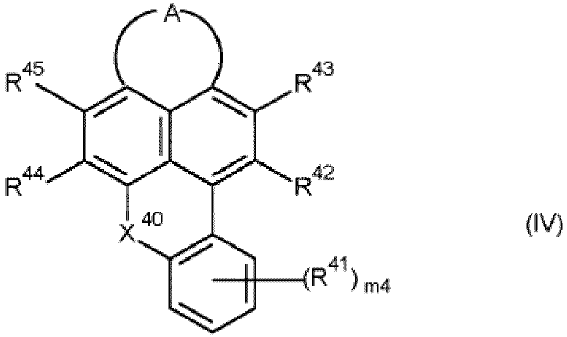
m4 étant 0, 1, 2, 3 ou 4 ;
chaque R⁴¹ étant indépendamment les uns des autres choisi parmi brome, chlore, cyano -NR^{4a}R^{4b}, C₁-C₂₄-alkyle, C₁-C₂₄-halogénoalkyle, C₁-C₂₄-alcoxy, C₁-C₂₄-halogénoalcoxy, C₃-C₂₄-cycloalkyle, hétérocycloalkyle, hétéroaryle, C₆-C₂₄-aryle, C₆-C₂₄-aryloxy, C₆-C₂₄-aryl-C₁-C₁₀-alkylène, les cycles du cycloalkyle, de l'hétérocycloalkyle, de l'hétéroaryle, de l'aryle, de l'aryloxy dans les six derniers radicaux mentionnés étant non substitués ou substitués par 1, 2, 3, 4 ou 5 radicaux R^{41a} identiques ou différents et où C₁-C₂₄-alkyle, C₁-C₂₄-halogénoalkyle, C₁-C₂₄-alcoxy, et le fragment alkylène du C₆-C₂₄-aryl-C₁-C₁₀-alkylène peuvent être interrompus par un ou plusieurs groupes choisis parmi O, S et NR^{4c} ;
au moins l'un parmi les radicaux R⁴², R⁴³, R⁴⁴ et R⁴⁵ étant CN, et les radicaux restants, indépendamment les uns des autres, étant choisis parmi hydrogène, chlore et brome ;
X⁴⁰ étant O, S, SO ou SO₂ ;
A étant un diradical choisi parmi les diradicaux des formules générales (A.1), (A.2), (A.3), et (A.4) 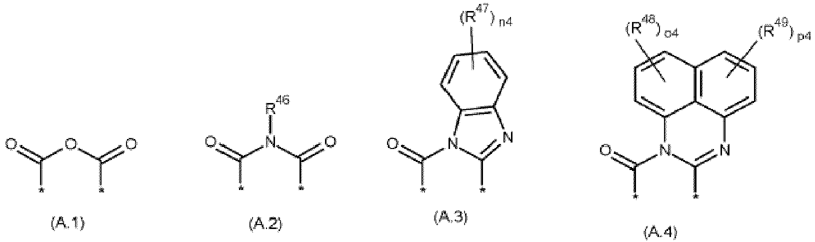
* désignant en chaque cas le point des fixations au reste de la molécule ;
n4 étant 0, 1, 2, 3 ou 4 ;
o4 étant 0, 1, 2 ou 3 ;
p4 étant 0, 1, 2 ou 3 ;
R⁴⁶ étant hydrogène, C₁-C₂₄-alkyle, C₁-C₂₄-halogénoalkyle, C₃-C₂₄-cycloalkyle, C₆-C₂₄-aryle ou C₆-C₂₄-aryl-C₁-C₁₀-alkylène, où les cycles du cycloalkyle, de l'aryle et de l'arylalkylène dans les trois derniers radicaux mentionnés sont non substitués ou substitués par 1, 2, 3, 4 ou 5 radicaux R^{46a} identiques ou différents, et où C₁-C₂₄-alkyle, C₁-C₂₄-halogénoalkyle et le fragment alkylène du C₆-C₂₄-aryl-C₁-C₁₀-alkylène peuvent être interrompus par un ou plusieurs hétéroatomes ou groupes hétéroatomiques choisis parmi O, S et NR^{4c} ;
chaque R⁴⁷ étant choisi indépendamment les uns des autres parmi brome, chlore, cyano, -NR^{4a}R^{4b}, C₁-C₂₄-alkyle, C₁-C₂₄-halogénoalkyle, C₁-C₂₄-alcoxy, C₁-C₂₄-halogénoalcoxy, C₃-C₂₄-cycloalkyle, hétérocycloalkyle, hétéroaryle, C₆-C₂₄-aryle, C₆-C₂₄-aryloxy, C₆-C₂₄-aryl-C₁-C₁₀-alkylène, où les cycles du cycloalkyle, de l'hétérocycloalkyle, de l'hétéroaryle, de l'aryle et de l'arylalkylène dans les six derniers radicaux mentionnés sont non substitués ou substitués par 1, 2, 3, 4 ou 5 radicaux R^{47a} identiques ou différents, et où C₁-C₂₄-alkyle, C₁-C₂₄-halogénoalkyle, C₁-C₂₄-alcoxy, C₁-C₂₄-halogénoalcoxy et le fragment alkylène du C₆-C₂₄-aryl-C₁-C₁₀-alkylène peuvent être interrompus par un ou plusieurs groupes choisis parmi O, S et NR^{4c} ;
chaque R⁴⁸ étant indépendamment les uns des autres choisi parmi brome, chlore, cyano, -NR^{4a}R^{4b}, C₁-C₂₄-alkyle, C₁-C₂₄-halogénoalkyle, C₁-C₂₄-alcoxy, C₁-C₂₄-halogénoalcoxy, C₃-C₂₄-cycloalkyle, hétérocycloalkyle, hétéroaryle, C₆-C₂₄-aryle, C₆-C₂₄-aryloxy, C₆-C₂₄-aryl-C₁-C₁₀-alkylène, où les cycles du cycloalkyle, de l'hétérocycloalkyle, de l'hétéroaryle, de l'aryle et de l'arylalkylène dans les six derniers radicaux mentionnés sont non substitués ou substitués par 1, 2, 3, 4 ou 5 radicaux R^{48a} identiques ou différents, et où C₁-C₂₄-alkyle, C₁-C₂₄-halogénoalkyle, C₁-C₂₄-alcoxy, C₁-C₂₄-halogénoalcoxy et le fragment alkylène du C₆-C₂₄-aryl-C₁-C₁₀-alkylène peuvent être interrompus par un ou plusieurs groupes choisis parmi O, S et NR^{4c} ;
chaque R⁴⁹ étant indépendamment les uns des autres choisi parmi brome, chlore, cyano, -NR^{4a}R^{4b}, C₁-C₂₄-alkyle, C₁-C₂₄-halogénoalkyle, C₁-C₂₄-alcoxy, C₁-C₂₄-halogénoalcoxy, C₃-C₂₄-cycloalkyle, hétérocycloalkyle, hétéroaryle, C₆-C₂₄-aryle, C₆-C₂₄-aryloxy, C₆-C₂₄-aryl-C₁-C₁₀-alkylène, où les cycles du cycloalkyle, de l'hétérocycloalkyle, de l'hétéroaryle, de l'aryle et de l'arylalkylène dans les six derniers radicaux mentionnés sont non substitués ou substitués par 1, 2, 3, 4 ou 5 radicaux R^{49a} identiques ou différents, et où C₁-C₂₄-alkyle, C₁-C₂₄-halogénoalkyle, C₁-C₂₄-alcoxy, C₁-C₂₄-halogénoalcoxy et le fragment alkylène du C₆-C₂₄-aryl-C₁-C₁₀-alkylène peuvent être interrompus par un ou plusieurs groupes choisis parmi O, S et NR^{4c} ;
R^{41a}, R^{46a}, R^{47a}, R^{48a}, R^{49a} étant indépendamment les uns des autres choisis parmi C₁-C₂₄-alkyle, C₁-C₂₄-fluoralkyle, C₁-C₂₄-alcoxy, fluor, chlore et brome ;
R^{4a}, R^{4b}, R^{4c} étant indépendamment les uns des autres choisis parmi hydrogène, C₁-C₂₀-alkyle, C₃-C₂₄-cycloalkyle, hétérocycloalkyle, hétéroaryle et C₆-C₂₄-aryle ;
ou des mélanges correspondants ;
(B5) un composé de type benz(othi)oxanthène de formule (V) 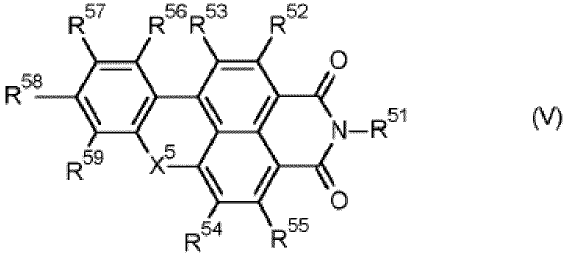
X⁵ étant oxygène ou soufre ;
R⁵¹ étant phényle qui est non substitué ou porte 1, 2, 3, 4, ou 5 substituants choisis parmi halogène, R⁵¹¹, OR⁵⁵², NHR⁵⁵² et NR⁵⁵²R⁵⁵⁷ ;
R⁵², R⁵³, R⁵⁴, R⁵⁵, R⁵⁶, R⁵⁷, R⁵⁸ et R⁵⁹ étant indépendamment les uns des autres choisis parmi hydrogène, halogène, R⁵⁵³, OR⁵⁵³, NHR⁵⁵³ et NR⁵⁵³R⁵⁵⁴,
R⁵¹¹ étant choisi parmi C₁-C₂₀-alkyle, C₆-C₂₄-aryle et hétéroaryle ;
R⁵⁵² et R⁵⁵⁷ étant indépendamment l'un de l'autre choisis parmi C₁-C₁₈-alkyle, C₆-C₂₄-aryle et hétéroaryle ; et
R⁵⁵³ et R⁵⁵⁴ étant indépendamment l'un de l'autre choisis parmi C₁-C₁₈-alkyle, C₆-C₂₄-aryle et hétéroaryle ;
ou des mélanges correspondants ;
(B6) un composé de type benzimidazoxanthèneisoquinoléine parmi les formules (VIA) et (VIB) 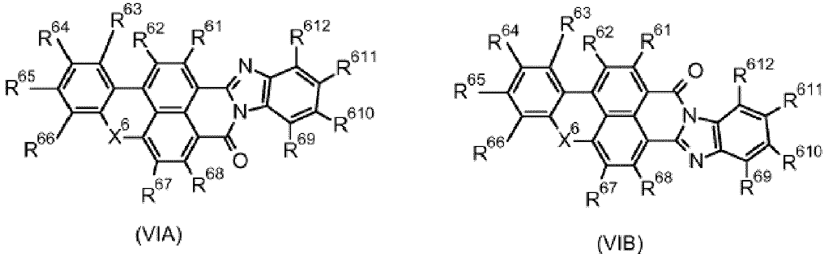
X⁶ étant oxygène ou soufre ;
R⁶¹, R⁶², R⁶³, R⁶⁴, R⁶⁵, R⁶⁶, R⁶⁷, R⁶⁸, R⁶⁹, R⁶¹⁰, R⁶¹¹ et R⁶¹² étant indépendamment les uns des autres choisis parmi hydrogène, halogène, R⁶⁶¹, OR⁶⁶¹, NHR⁶⁶¹ et NR⁶⁶¹R⁶⁶² ;
chaque R⁶¹¹ étant choisi parmi C₁-C₁₈-alkyle, C₆-C₂₄-aryle et hétéroaryle ; et
chaque R⁶⁶² étant choisi parmi C₁-C₁₈-alkyle, C₆-C₂₄-aryle et hétéroaryle ;
ou des mélanges correspondants ;
(B7) un composé fluorescent comprenant au moins un motif structural de formule (VII) 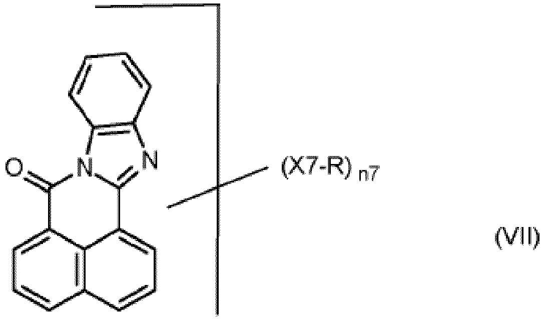 où un ou plusieurs groupes CH du cycle à six chaînons de la structure benzimidazole présentée peuvent être remplacés par azote et où les symboles sont chacun définis comme suit :
n7 est un nombre de 0 à (10 - p7) pour chaque motif structural de formule (VII) ; où p7 est le nombre de motifs CH qui ont été remplacés par azote dans le cycle à six chaînons de la structure benzimidazole présentée X7 est une liaison chimique, O, S, SO, SO₂, NR⁷¹ ; et
R est un radical aliphatique, un radical cycloaliphatique, aryle, hétéroaryle, chacun desquels pouvant porter des substituants, un cycle ou un système cyclique aromatique ou hétéroaromatique, chacun desquels étant condensé à d'autres cycles aromatiques du motif structural de formule (VII), est F, Cl, Br, CN, H lorsque X7 n'est pas une liaison chimique ; où deux radicaux R peuvent être joints pour donner un radical cyclique et où X7 et R, lorsque n7 > un, peuvent être identiques ou différents ;
R⁷¹ étant chacun indépendamment hydrogène, C₁-C₁₈-alkyle ou cycloalkyle, la chaîne carbonée desquels pouvant comprendre un ou plusieurs fragments -O-, -S-, -CO-,-SO- et/ou -SO₂- et pouvant être monosubstituée ou polysubstituée ; aryle ou hétéroaryle qui peut être monosubstitué ou polysubstitué ;
ou des mélanges correspondants ;
(B8) un composé de type pérylène parmi les formules (VIII) et (IX) 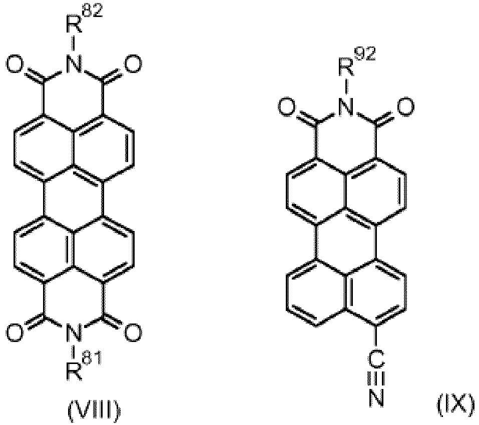 où
R⁸¹, R⁸² sont chacun indépendamment C₁-C₃₀-alkyle, C₂-C₃₀-alkyle qui est interrompu par un ou plusieurs oxygènes, C₃-C₈-cycloalkyle, C₆-C₁₀-aryle, hétéroaryle, C₆-C₁₀-aryl-C₁-C₁₀-alkylène, où le cycle aromatique dans les trois derniers radicaux est non substitué ou monosubstitué ou polysubstitué par C₁-C₁₀-alkyle ;
R⁹² est C₁-C₃₀-alkyle, C₃-C₈-cycloalkyle, aryle, hétéroaryle, aryl-C₁-C₁₀-alkylène, où le cycle aromatique dans les trois derniers radicaux est non substitué ou monosubstitué ou polysubstitué par C₁-C₁₀-alkyle ;
(B9) un composé de type monoimide de naphtalène de formule (X) 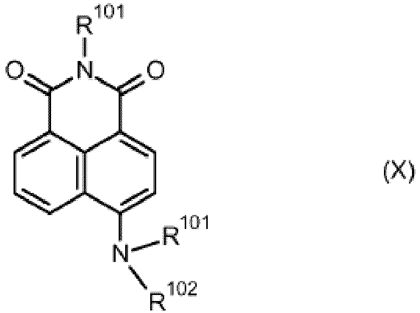
chaque R¹⁰¹ étant indépendamment l'un de l'autre hydrogène, C₁-C₃₀-alkyle, C₂-C₃₀-alkyle qui est interrompu par un ou plusieurs oxygènes, C₃-C₈-cycloalkyle, C₆-C₁₀-aryle, hétéroaryle, C₆-C₁₀-aryl-C₁-C₁₀-alkylène, où le cycle aromatique dans les trois derniers radicaux est non substitué ou monosubstitué ou polysubstitué par C₁-C₁₀-alkyle ;
R¹⁰² étant hydrogène, C₁-C₃₀-alkyle, C₂-C₃₀-alkyle qui est interrompu par un ou plusieurs oxygènes, C₃-C₈-cycloalkyle, C₆-C₁₀-aryle, hétéroaryle, C₆-C₁₀-aryl-C₁-C₁₀-alkylène, où le cycle aromatique dans les trois derniers radicaux est non substitué ou monosubstitué ou polysubstitué par C₁-C₁₀-alkyle ;
(B10) la 7-(diéthylamino)-3-(5-méthylbenzo[d]oxazol-2-yl)-2H-chromén-2-one ;
(B11) un composé de type pérylène parmi les formules (XIA) et (XIB) 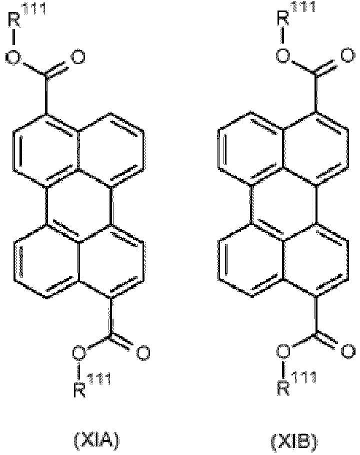
chaque R¹¹¹ étant indépendamment l'un de l'autre C₁-C₁₈-alkyle, C₄-C₈-cycloalkyle, qui peut être monosubstitué ou polysubstitué par halogène ou par C₁-C₁₈-alkyle linéaire ou ramifié, ou phényle ou naphtyle qui peuvent être monosubstitués ou polysubstitués par halogène ou par C₁-C₁₈-alkyle linéaire ou ramifié ;
ou des mélanges correspondants ;
(B12) un composé de type pérylène cyanaté parmi les formules (XIIA) et (XIIB) 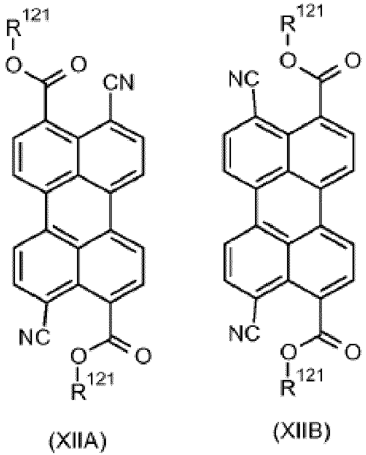 chaque R¹²¹ étant indépendamment l'un de l'autre C₁-C₁₈-alkyle, C₄-C₈-cycloalkyle, qui peut être monosubstitué ou polysubstitué par halogène ou par C₁-C₁₈-alkyle linéaire ou ramifié, ou phényle ou naphtyle qui peuvent être monosubstitués ou polysubstitués par halogène ou par C₁-C₁₈-alkyle linéaire ou ramifié ;
ou des mélanges correspondants ;
(B13) un composé de type bisimide de pérylène de formule (XIII) 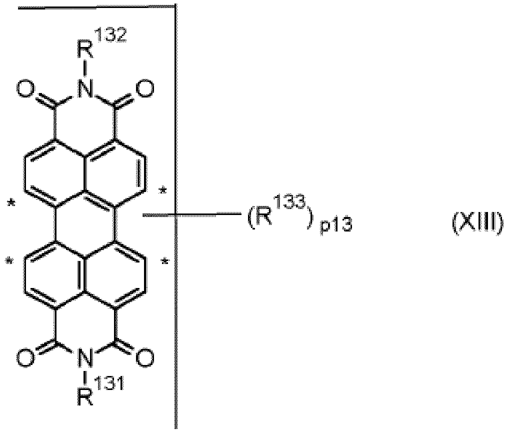
p13 étant 1, 2, 3 ou 4 ;
R¹³¹ et R¹³² étant indépendamment l'un de l'autre C₁-C₁₀-alkyle, qui est non substitué ou substitué par C₆-C₁₀-aryle qui à son tour est non substitué ou substitué par 1, 2 ou 3 C₁-C₁₀-alkyle ;
C₂-C₁₀-alkyle, qui est interrompu par un ou plusieurs oxygènes,
C₃-C₈-cycloalkyle, qui est non substitué ou substitué par 1, 2 ou 3 C₁-C₁₀-alkyle, ou
C₆-C₁₀-aryle qui est non substitué ou substitué par 1, 2 ou 3 C₁-C₁₀-alkyle ;
chaque R¹³³ indépendamment l'un de l'autre étant fluor, chlore, C₁-C₁₆-alkyle, C₂-C₁₆-alkyle interrompu par un ou plusieurs oxygènes, C₁-C₁₆-alcoxy, C₆-C₁₀-aryloxy qui est non substitué ou monosubstitué ou polysubstitué par fluor, chlore, C₁-C₁₆-alkyle, C₂-C₁₆-alkyle interrompu par un ou plusieurs oxygènes, C₁-C₁₆-alcoxy ou C₆-C₁₀-aryle, qui est non substitué ou substitué par 1, 2 ou 3 radicaux choisis parmi C₁-C₆-alkyle, C₁-C₆-alcoxy-C₁-C₆-alkyle et C₁-C₆-alcoxy, les radicaux R¹³³ se trouvant au niveau des positions indiquées par * ;
ou des mélanges correspondants ;
(B14) un composé de type pérylène de formule (XIV) 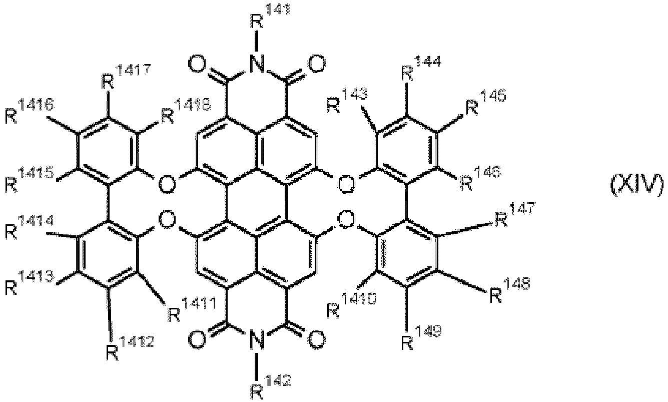
R¹⁴¹ et R¹⁴², indépendamment l'un de l'autre, étant choisis parmi hydrogène ; C₁-C₃₀-alkyle, polyalkylènoxy, C₁-C₃₀-alcoxy, C₁-C₃₀-alkylthio, C₃-C₂₀-cycloalkyle, C₃-C₂₀-cycloalkyloxy, C₆-C₂₄-aryle et C₆-C₂₄-aryloxy, en chaque cas non substitués ou substitués ;
R¹⁴³, R¹⁴⁴, R¹⁴⁵, R¹⁴⁶, R¹⁴⁷, R¹⁴⁸, R¹⁴⁹, R¹⁴¹⁰, R¹⁴¹¹, R¹⁴¹², R¹⁴¹³, R¹⁴¹⁴, R¹⁴¹⁵, R¹⁴¹⁶, R¹⁴¹⁷ et R¹⁴¹⁸ indépendamment les uns des autres, étant choisis parmi hydrogène, halogène, cyano, hydroxyle, mercapto, nitro, -NE¹⁴¹E¹⁴², - NR^{Ar141}COR^{A142}, -CONR^{Ar141}R^{Ar142}, -SO₂NR^{Ar141}R^{Ar142}, -COOR^{Ar141}, -SO₃R^{Ar142} ; C₁-C₃₀-alkyle, polyalkylènoxy, C₁-C₃₀-alcoxy, C₁-C₃₀-alkylthio, C₃-C₂₀-cycloalkyle, C₃-C₂₀-cycloalcoxy, C₆-C₂₄-aryle, C₆-C₂₄-aryloxy et C₆-C₂₄-arylthio, en chaque cas non substitués ou substitués,
où R¹⁴³ et R¹⁴⁴, R¹⁴⁴ et R¹⁴⁵, R¹⁴⁵ et R¹⁴⁶, R¹⁴⁶ et R¹⁴⁷, R¹⁴⁷ et R¹⁴⁸, R¹⁴⁸ et R¹⁴⁹, R¹⁴⁹ et R¹⁴¹⁰, R¹⁴¹¹ et R¹⁴¹², R¹⁴¹² et R¹⁴¹³, R¹⁴¹³ et R¹⁴¹⁴, R¹⁴¹⁴ et R¹⁴¹⁵, R¹⁴¹⁵ et R¹⁴¹⁶, R¹⁴¹⁶ et R¹⁴¹⁷ et/ou R¹⁴¹⁷ et R¹⁴¹⁸ conjointement avec les atomes de carbone du fragment biphénylyle auxquels ils sont liés, peuvent également former un système cyclique aromatique ou non aromatique condensé supplémentaire, le système cyclique condensé étant non substitué ou substitué ;
où
E¹⁴¹ et E¹⁴², indépendamment l'un de l'autre sont hydrogène, C₁-C₁₈-alkyle non substitué ou substitué, C₂-C₁₈-alcényle non substitué ou substitué, C₂-C₁₈-alcynyle non substitué ou substitué, C₃-C₂₀-cycloalkyle non substitué ou substitué ou C₆-C₁₀-aryle non substitué ou substitué ;
R^{Ar141} et R^{Ar142}, chacun indépendamment l'un de l'autre sont hydrogène, C₁-C₁₈-alkyle non substitué ou substitué, C₃-C₂₀-cycloalkyle non substitué ou substitué, hétérocyclyle non substitué ou substitué, C₆-C₂₀-aryle non substitué ou substitué ou hétéroaryle non substitué ou substitué ;
ou des mélanges correspondants ;
(B15) un composé de type diimide 3,4,9,10-pérylènetétracarboxylique comprenant un premier groupe (XVa) et un deuxième groupe (XVb),
le premier groupe (XVa) comprenant un ou plusieurs groupes basés sur l'un ou plusieurs parmi le composé (V), le composé (X), le composé (XIA), le composé (XIB), la 7-(diéthylamino)-3-(6-méthylbenzo[d]oxazol-2-yl)-2H-chromén-2-one et des composés de formule (XVa1) 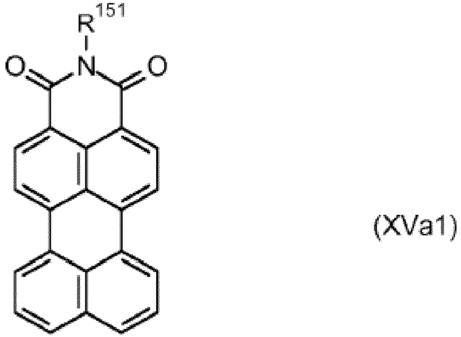
R¹⁵¹ étant C₁-C₁₀-alkyle, qui est non substitué ou substitué par C₆-C₁₀-aryle qui à son tour est non substitué ou substitué par 1, 2 ou 3 C₁-C₁₀-alkyle ; C₂-C₂₀-alkyle, qui est interrompu par un ou plusieurs oxygènes, C₃-C₈-cycloalkyle, qui est non substitué ou substitué par 1, 2 ou 3 C₁-C₁₀-alkyle, ou
C₆-C₁₀-aryle qui est non substitué ou substitué par 1, 2 ou 3 C₁-C₁₀-alkyle ;
et le deuxième groupe (XVb) étant 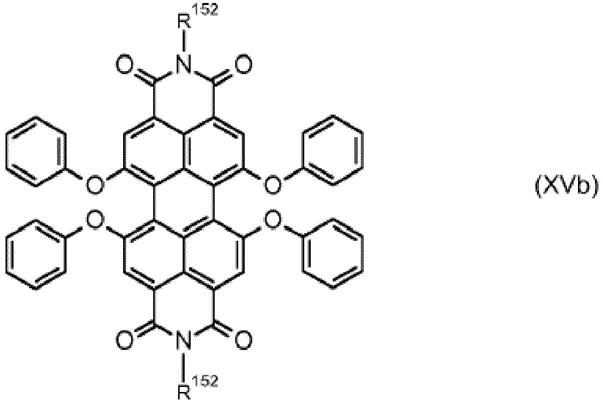 R¹⁵² indépendamment l'un de l'autre, étant choisis parmi hydrogène, C₁-C₁₀-alkyle, qui est non substitué ou substitué par C₆-C₁₀-aryle qui à son tour est non substitué ou substitué par 1, 2 ou 3 C₁-C₁₀-alkyle ; C₂-C₂₀-alkyle, qui est interrompu par un ou plusieurs oxygènes,
C₃-C₈-cycloalkyle, qui est non substitué ou substitué par 1, 2 ou 3 C₁-C₁₀-alkyle, ou C₆-C₁₀-aryle qui est non substitué ou substitué par 1, 2 ou 3 C₁-C₁₀-alkyle ou un groupe (XVb1) 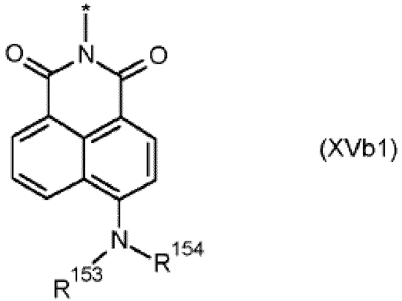
* désignant le site de liaison au reste de la molécule ;
R¹⁵³ et R¹⁵⁴, indépendamment l'un de l'autre, étant choisis parmi hydrogène, C₁-C₃₀-alkyle, C₂-C₃₀-alcényle, C₂-C₃₀-alcynyle, C₃-C₁₂-cycloalkyle et C₆-C₂₄-aryle, les deux radicaux mentionnés en dernier étant non substitués ou portant un, deux ou trois radicaux choisis parmi C₁-C₁₀-alkyle.

6. Convertisseur de couleur selon l'une quelconque des revendications précédentes, comprenant un mélange d'au moins deux colorants fluorescents organiques (B) tels que définis dans la revendication 5, les au moins deux colorants fluorescents organiques (B) appartenant à au moins deux classes différentes de colorants organiques fluorescents (B1), (B2), (B3), (B4), (B5), (B6), (B7), (B8), (B9), (B10), (B11), (B12), (B13), (B14) ou (B15).

7. Convertisseur de couleur selon la revendication 5 ou 6, comprenant au moins un composé de type bisimide de pérylène de formule (XIII) en tant que colorant fluorescent organique.

8. Convertisseur de couleur selon l'une quelconque des revendications 5 à 7, comprenant au moins un composé comprenant au moins un motif structural de formule (VII) en tant que colorant fluorescent organique.

9. Convertisseur de couleur selon l'une quelconque des revendications 5 à 8, comprenant au moins un composé choisi parmi le composé de formule (VIII), le composé de formule (IX), les composés de formules (XIA) et (XIB), les composés de formules (XIIA) et (XIIB) et des mélanges correspondants en tant que colorant fluorescent organique.

10. Convertisseur de couleur selon l'une quelconque des revendications précédentes, comprenant au moins un matériau luminescent choisi parmi des grenats, des silicates, des sulfures, des nitrures et des oxynitrures et des points quantiques.

11. Convertisseur de couleur selon l'une quelconque des revendications précédentes, comprenant en outre au moins un pigment blanc inorganique en tant que corps de diffusion, préférablement du dioxyde de titane.

12. Utilisation d'un convertisseur de couleur selon l'une quelconque des revendications précédentes pour la conversion de lumière générée par une LED bleue dotée d'une longueur d'onde centrale d'émission comprise entre 400 nm et 480 nm pour fournir une lumière blanche possédant une température de couleur corrélée comprise entre 2 000 K et 20 000 K ou pour la conversion de lumière générée par une LED blanche froide possédant une température de couleur corrélée comprise entre 3 000 K et 20 000 K pour fournir une lumière blanche possédant une température de couleur corrélée plus basse.

13. Mélange de polymères comprenant au moins un polyester de 2,5-furannedicarboxylate (A) qui peut être obtenu par la mise en réaction (i) d'au moins un diol choisi parmi un C₂-C₂₀-diol aliphatique et un C₃-C₂₀-diol cycloaliphatique, avec (ii) l'acide 2,5-furannedicarboxylique et/ou un dérivé de formation d'ester correspondant et (iii) éventuellement au moins un acide dicarboxylique supplémentaire choisi parmi l'acide 1,2-cyclohexanedicarboxylique, l'acide 1,4-cyclohexanedicarboxylique, l'acide 3,4-furannedicarboxylique, l'acide téréphtalique et l'acide 2,6-naphtalique et/ou un dérivé de formation d'ester correspondant et au moins un matériau luminescent, notamment au moins un colorant fluorescent organique (B) tel que défini dans l'une quelconque des revendications 5 à 9.

14. Dispositif d'éclairage comprenant
(i) au moins une LED choisie parmi une LED bleue dotée d'une longueur d'onde centrale d'émission de 400 nm à 480 nm et une LED blanche froide possédant une température de couleur corrélée comprise entre 3 000 K et 20 000 K ; et
(ii) au moins un convertisseur de couleur tel que défini dans l'une quelconque des revendications 1 à 11.
dans lequel l'au moins un convertisseur de couleur est dans un agencement à distance de l'au moins une LED.

15. Dispositif produisant de la puissance électrique lors d'une illumination comprenant une cellule photovoltaïque et le convertisseur de couleur tel que défini dans l'une quelconque des revendications 1 à 11, où au moins une partie de la lumière non absorbée par la cellule photovoltaïque est absorbée par le convertisseur de couleur.
